# EUROPEAN PATENT APPLICATION

(11) **EP 3 974 494 A1**
(43) Date of publication of application: **30.03.2022**
(21) Application number: 21198508.0
(22) Date of filing: 23.09.2021
(51) Int. Cl.: C09K 11/00, H01L 51/00, C07F 15/00

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 29.09.2020 KR 20200127522
(71) Applicant: Samsung Electronics Co., Ltd., Suwon-si, Gyeonggi-do 16677 (KR)
(72) Inventor: LEE, Yong Joo, 16678 Suwon-si (KR); KANG, Byungjoon, 16678 Suwon-si (KR); ISHIHARA, Shingo, 16678 Suwon-si (KR); YI, Jeoungin, 16678 Suwon-si (KR); CHOI, Byoungki, 16678 Suwon-si (KR); KOISHIKAWA, Yasushi, 16678 Suwon-si (KR); HWANG, Kyuyoung, 16678 Suwon-si (KR)
(74) Representative: Elkington and Fife LLP

(57) **Abstract**

An organometallic compound represented by Formula 1:

Formula 1 M(L₁)ₙ₁(L₂)ₙ₂

wherein, in Formula 1, M, L₁, L₂, n1 and n2 are the same as described in the specification.

## Description

### FIELD OF THE INVENTION

Aspects of the present disclosure relate to organometallic compounds, organic light-emitting devices including the same, and electronic apparatuses including the organic light-emitting devices.

### BACKGROUND OF THE INVENTION

Organic light-emitting devices (OLEDs) are self-emission devices, that have improved characteristics in terms of viewing angles, response time, brightness, driving voltage, and response speed, and produce full-color images.

In an example, an organic light-emitting device includes an anode, a cathode, and an organic layer arranged between the anode and the cathode and including an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

Various types of organic light emitting devices are known. However, there still remains a need in OLEDs having low driving voltage, high efficiency, high brightness, and long lifespan.

### SUMMARY OF THE INVENTION

Provided herein are novel organometallic compounds, organic light-emitting devices including the same, and electronic apparatuses including the organic light-emitting devices.

Additional aspects will be set forth in part in the description which follows and, in part, will be apparent from the description, or may be learned by practice of the presented embodiments of the disclosure.

According to an aspect of an embodiment, provided is an organometallic compound represented by Formula 1:

Formula 1 M(L₁)ₙ₁(L₂)ₙ₂

wherein, in Formula 1,
M is a transition metal,
L₁ is a ligand represented by Formula 2A,
L₂ is a ligand represented by Formula 2B,
n1 and n2 are each independently 1 or 2, wherein, when n1 is 2, two of L₁(s) are identical to or different from each other, and when n2 is 2, two of L₂(s) are identical to or different from each other,
the sum of n1 and n2 is 2 or 3, and
L₁ and L₂ are different from each other: 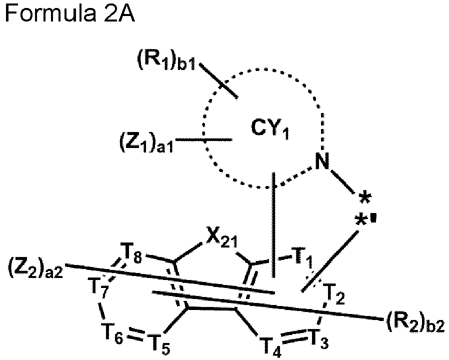 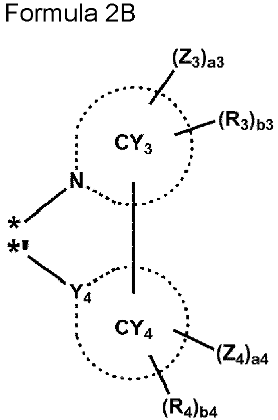 wherein, in Formulae 2A and 2B,
   Y₄ is C or N,
   X₂₁ is O, S, Se, S(=O), N(R₂₉), C(R₂₉)(R₃₀), or Si(R₂₉)(R₃₀),
   T₁ to T₄ are each independently C, N, carbon bonded to ring CY₁, or carbon bonded to M in Formula 1, wherein one of T₁ to T₄ is the carbon bonded to M in Formula 1, and one of the remaining groups T₁ to T₄ that is not bonded to M in Formula 1 is the carbon bonded to ring CY₁,
   T₅ to T₈ are each independently C or N,
   ring CY₁ and ring CY₃ are each independently a C₁-C₃₀ heterocyclic group,
   ring CY₄ is a C₅-C₃₀ carbocyclic group or a C₁-C₃₀ heterocyclic group,
   Z₁, Z₃, and Z₄ are each independently a fluoro group (-F) or a fluorinated group,
   Z₂ is a fluoro group, a fluorinated non-cyclic group, or a fluorinated saturated cyclic group,
   a1, a3, and a4 are each independently an integer from 0 to 20, wherein a2 is an integer from 0 to 6, and the sum of a1, a2, a3, and a4 is 1 or more,
   R₁ to R₄, R₂₉, and R₃₀ are each independently hydrogen, deuterium, - F, -CI, -Br, -I, SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
   b1, b3, and b4 are each independently an integer from 0 to 20, and b2 is an integer from 0 to 6,
   when i) none of T₁ to T₈ in Formula 2A is N, ii) a2 in Formula 2A is not 0, and iii) Z₂ in Formula 2A is a fluoro group, then a) b3 in Formula 2B is not 0, and b) at least one of R₃(s) in the number of b3 in Formula 2B is -Si(Q₃)(Q₄)(Q₅) or -Ge(Q₃)(Q₄)(Q₅),
   two or more of a plurality of R₁(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
   two or more of a plurality of R₂(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
   two or more of a plurality of R₃(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
   two or more of a plurality of R₄(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
   R₁₀ₐ i is the same as described in connection with R₁,
   * and *' in Formulae 2A and 2B each indicate a binding site to M in Formula 1, and
   a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₇-C₆₀ arylalkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroarylalkyl group, the substituted monovalent non-aromatic condensed polycyclic group, and the substituted monovalent non-aromatic condensed heteropolycyclic group is:
   deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each independently substituted with deuterium, -F, -CI, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or a combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ aryl alkyl group, a C1-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, or a monovalent non-aromatic condensed heteropolycyclic group, each independently unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C1-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q26)(Q27), -P(=O)(Q₂₈)(Q₂₉), -P(Q28)(Q29), or a combination thereof;
   -N(Q31)(Q32), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉) or -P(Q38)(Q39); or a combination thereof,
   wherein Q₁ to Q₉, Q₁₁ to Q₁₉, Q₂₁ to Q₂₉, and Q₃₁ to Q₃₉ are each independently: hydrogen; deuterium; -F; -CI; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₇-C₆₀ arylalkyl group; a C₁-C₆₀ heteroaryl group; a C₁-C₆₀ heteroaryloxy group; a C1-C₆₀ heteroarylthio group; a C₂-C₆₀ heteroarylalkyl group; a monovalent non-aromatic condensed polycyclic group; or a monovalent non-aromatic
   condensed heteropolycyclic group.

According to an aspect of an embodiment, provided is an organic light-emitting device including: a first electrode; a second electrode; and an organic layer arranged between the first electrode and the second electrode and wherein the organic layer includes an emission layer, wherein the organic layer includes at least one organometallic compound represented by Formula 1.

The organometallic compound may be included in the emission layer of the organic layer, and the organometallic compound included in the emission layer may act as a dopant.

According to an aspect of another embodiment, provided is an electronic apparatus including the organic light-emitting device.

### BRIEF DESCRIPTION OF THE DRAWINGS

The above and other aspects, features, and advantages of certain embodiments of the disclosure will be more apparent from the following description taken in conjunction with FIGURE which shows a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In any formula, * and *' each indicate a binding site to a neighboring atom or a neighboring functional group.

An aspect of the present disclosure provides an organometallic compound represented by Formula 1:

Formula 1 M(L₁)ₙ₁(L₂)ₙ₂

wherein M in Formula 1 is a transition metal.

In an embodiment, M may be a Period 1 transition metal, a Period 2 transition metal, or a Period 3 transition metal.

In an embodiment, M may be iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, M may be Ir, Pt, Os, or Rh.

In Formula 1, L₁ may be a ligand represented by Formula 2A, and L₂ may be a ligand represented by Formula 2B: 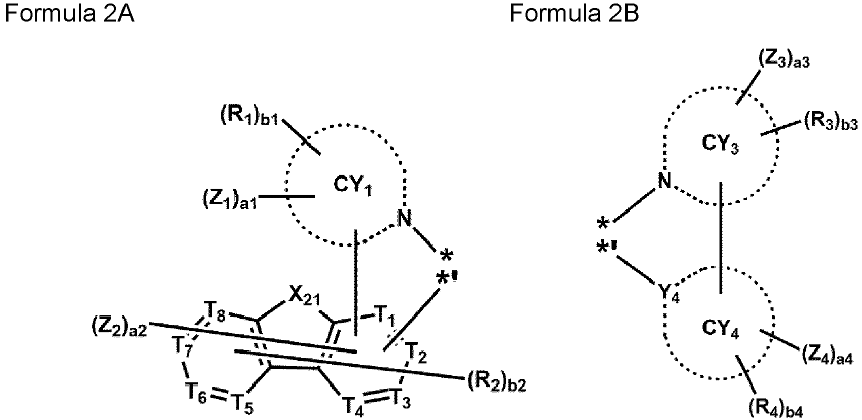 wherein Formulae 2A and 2B are the same as described in the present specification.

In Formula 1, n1 and n2 may each independently be 1 or 2, wherein, when n1 is 2, two L₁(s) may be identical to or different from each other, and when n2 is 2, two L₂(s) may be identical to or different from each other.

In Formula 1, the sum of n1 and n2 may be 2 or 3. For example, the sum of n1 and n2 may be 3.

In an embodiment, in Formula 1, i) M may be Ir, and the sum of n1 and n2 may be 3; or ii) M may be Pt, and the sum of n1 and n2 may be 2.

In an embodiment, in Formula 1, M may be Ir, and i) n1 may be 1, and n2 may be 2, or ii) n1 may be 2, and n2 may be 1.

In Formula 1, L₁ and L₂ may be different from each other. That is, the organometallic compound represented by Formula 1 may be a heteroleptic complex.

In Formula 2B, Y₄ may be C or N. For example, Y₄ may be C.

In Formula 2A, X₂₁ may be O, S, Se, S(=O), N(R₂₉), C(R₂₉)(R₃₀), or Si(R₂₉)(R₃₀), wherein R₂₉ and R₃₀ may each be the same as described herein. For example, X₂₁ may be O or S.

In Formula 2A, T₁ to T₄ may each independently be C, N, carbon bonded to ring CY₁, or carbon bonded to M in Formula 1, wherein one of T₁ to T₄ is the carbon bonded to M in Formula 1, and one of the remaining groups T₁ to T₄ that is not bonded to M in Formula 1 is the carbon bonded to ring CY₁, and T₅ to T₈ may each independently be C or N.

In an embodiment, none of T₁ to T₈ may be N.

In an embodiment, one or two of T₁ to T₈ may be N.

In an embodiment, one or two of T₅ to T₈ may be N.

In Formulae 2A and 2B, ring CY₁ and ring CY₃ may each independently be a C₁-C₃₀ heterocyclic group, and ring CY₄ may be a C₃-C₃₀ carbocyclic group or a C1-C₃₀ heterocyclic group.

For example, ring CY₁, and ring CY₃ may each independently be a pyrrole group, an indole group, a carbazole group, a benzocarbazole group, a dibenzocarbazole group, an indolophenanthrene group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzisoxadiazole group, a benzothiadiazole group, a 5,6,7,8-tetrahydroisoquinoline group, a 5,6,7,8-tetrahydroquinoline group, a pyridine group condensed with a cyclohexane group, or a pyridine group condensed with a norbornane group.

For example, ring CY₄ may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzisoxadiazole group, a benzothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In an embodiment, ring CY₁ and ring CY₃ may each independently be a pyridine group, a pyrimidine group, a pyrazine group, a pyridazine group, a triazine group, a quinoline group, an isoquinoline group, a benzoquinoline group, a benzoisoquinoline group, a 5,6,7,8-tetrahydroisoquinoline group, a 5,6,7,8-tetrahydroquinoline group, or a pyridine group condensed with a norbornane group.

In an embodiment, in Formula 2B, Y₄ may be C, and ring CY₄ may be a benzene group, a naphthalene group, a 1,2,3,4-tetrahydronaphthalene group, a fluorene group, a carbazole group, a dibenzofuran group, a dibenzothiophene group, a dibenzosilole group, an azafluorene group, an azacarbazole group, an azadibenzofuran group, an azadibenzothiophene group, an azadibenzosilole group, or a benzene group condensed with a norbornane group.

In Formulae 2A and 2B, Z₁, Z₃, and Z₄ may each independently be a fluoro group (-F) or a fluorinated group, and Z₂ may be a fluoro group, a fluorinated non-cyclic group, or a fluorinated saturated cyclic group.

The term "fluorinated group" as used herein refers to any group including at least one fluoro group. For example, a fluorinated non-cyclic group refers to a non-cyclic group including at least one fluoro group. For example, a fluorinated cyclic group refers to a cyclic group (for example, an unsaturated cyclic group or a saturated cyclic group) including at least one fluoro group.

The term "fluorinated non-cyclic group" as used herein refers to a non-cyclic group including at least one fluoro group. The non-cyclic group may be a non-cyclic group including at least one carbon, and examples thereof are a C₁-C₆₀ alkyl group, a C₂-C₆₀ alkenyl group, a C₂-C₆₀ alkynyl group, a C₁-C₆₀ alkoxy group, a C₁-C₆₀ alkylthio group, and the like. The "fluorinated non-cyclic group" may optionally be further substituted with another group (except a cyclic group) other than a fluoro group or fluorinated group. Examples of the "fluorinated non-cyclic group" are -CFH₂, -CF₂H, - CF₃, and the like.

The term "fluorinated saturated cyclic group" as used herein refers to a saturated cyclic group including at least one fluoro group. The saturated cyclic group may be a saturated cyclic group including at least one carbon, and examples thereof are a C₃-C₁₀ cycloalkyl group, a C₁-C₁₀ heterocycloalkyl group, and the like. The "fluorinated saturated cyclic group" may optionally be further substituted with another group (except an unsaturated cyclic group) other than a fluoro group or a fluorinated group. An example of the "fluorinated saturated cyclic group" is a cyclohexyl group substituted with at least one fluoro group.

In an embodiment, Z₁, Z₃, and Z₄ may each independently be:
a fluoro group; or
a fluorinated C₁-C₂₀ alkyl group, a fluorinated C₃-C₁₀ cycloalkyl group, a fluorinated C₁-C₁₀ heterocycloalkyl group, a fluorinated phenyl group, or a fluorinated biphenyl group, each unsubstituted or substituted with deuterium, a cyano group, a C₁-C₂₀ alkyl group, a deuterated C₁-C₂₀ alkyl group, a C₃-C₁₀ cycloalkyl group, a deuterated C₃-C₁₀ cycloalkyl group, a C₁-C₁₀ heterocycloalkyl group, a deuterated C₁-C₁₀ heterocycloalkyl group, a phenyl group, a deuterated phenyl group, a biphenyl group, a deuterated biphenyl group, or a combination thereof.

In one or more embodiments, Z₂ may be:
a fluoro group; or
a fluorinated C₁-C₂₀ alkyl group, a fluorinated C₃-C₁₀ cycloalkyl group, or a fluorinated C₁-C₁₀ heterocycloalkyl group, each independently unsubstituted or substituted with deuterium, a cyano group, a C₁-C₂₀ alkyl group, a deuterated C₁-C₂₀ alkyl group, a C₃-C₁₀ cycloalkyl group, a deuterated C₃-C₁₀ cycloalkyl group, a C₁-C₁₀ heterocycloalkyl group, a deuterated C₁-C₁₀ heterocycloalkyl group, or a combination thereof.

In Formulae 2A and 2B, a1, a3, and a4 indicate the number of Z₁, the number of Z₃, and the number of Z₄, respectively, and may each independently be an integer from 0 to 20. When a1 is 2 or more, two or more of Z₁(s) may be identical to or different from each other, when a3 is 2 or more, two or more of Z₃(s) may be identical to or different from each other, and when a4 is 2 or more, two or more of Z₄(s) may be identical to or different from each other. For example, a1, a3, and a4 may each independently be 0, 1, 2, or 3.

In Formula 2A, a2 indicates the number of Z₂, and may be an integer from 0 to 6. When a2 is 2 or more, two or more of Z₂(s) may be identical to or different from each other. For example, a2 may be 0, 1, 2, or 3.

In Formulae 2A and 2B, the sum of a1, a2, a3, and a4 may be 1 or more (for example, 1, 2, or 3). That is, the organometallic compound represented by Formula 1 may include at least one of Z₁ to Z₄.

In an embodiment, in Formula 1, the sum of a1, a2, a3, and a4 may be 1 or 2. In an embodiment, in Formula 1,
i) a1 may be 1, and a2, a3, and a4 may each independently be 0,
ii) a2 may be 1 or 2, and a1, a3, and a4 may each independently be 0,
iii) a3 may be 1, and a1, a2, and a4 may each independently be 0,
iv) a4 may be 1, and a1, a2, and a3 may each independently be 0,
v) a2 and a4 may each independently be 1, and a1 and a3 may each independently be 0, or
vi) a1 and a2 may each independently be 1, and a3 and a4 may each independently be 0.

In Formulae 2A and 2B, R₁ to R₄, R₂₉, and R₃₀ may each independently be hydrogen, deuterium, -F, -CI, -Br, -I, SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉), wherein Q₁ to Q₉ may each be the same as described herein.

In an embodiment, each of R₁ to R₄, R₂₉, and R₃₀ may not include a fluoro group.

In an embodiment, a substituent of the "substituted C₁-C₆₀ alkyl group", which can be one of R₁ to R₄, R₂₉, and R₃₀, may each independently be:
deuterium, -CD₃, -CD₂H, -CDH₂, a cyano group, a C₂-C₆₀ alkenyl group, a C₂-C₆₀ alkynyl group, a C₁-C₆₀ alkoxy group, or a C₁-C₆₀ alkylthio group;
a C₂-C₆₀ alkenyl group, a C₂-C₆₀ alkynyl group, a C₁-C₆₀ alkoxy group, or a C₁-C₆₀ alkylthio group, each substituted with deuterium, -CD₃, -CD₂H, - CDH₂, a cyano group, a C₃-C₁₀ cycloalkyl group, a C₁-C₁₀ heterocycloalkyl group, a C₃-C₁₀ cycloalkenyl group, a C₁-C₁₀ heterocycloalkenyl group, - N(Q₁₁)(Q₁₂), -Si(Q₁₃)(Q₁₄)(Q₁₅), -Ge(Q₁₃)(Q₁₄)(Q₁₈), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, or a C₁-C₁₀ heterocycloalkenyl group, each unsubstituted or substituted with deuterium, -CD₃, -CD₂H, -CDH₂, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, -N(Q₂₁)(Q₂₂), - Si(Q23)(Q24)(Q25), -Ge(Q₂₃)(Q₂₄)(Q₂₅), -B(Q₂₆)(Q₂₇), -P(=O)(Q₂₈)(Q₂₉), - P(Q28)(Q29), or a combination thereof; or
-N(Q31)(Q32), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q38)(Q39).

In an embodiment, R₁ to R₄, R₂₉, and R₃₀ may each independently be:
hydrogen, deuterium, or a cyano group;
a C₁-C₂₀ alkyl group unsubstituted or substituted with deuterium, a cyano group, a C₃-C₁₀ cycloalkyl group, a deuterated C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, a phenyl group, a deuterated phenyl group, a (C₁-C₂₀ alkyl)phenyl group, a deuterated (C₁-C₂₀ alkyl)phenyl group, a biphenyl group, a deuterated biphenyl group, a (C₁-C₂₀ alkyl)biphenyl group, a deuterated (C₁-C₂₀ alkyl)biphenyl group, or a combination thereof;
a C₃-C₁₀ cycloalkyl group, a C₁-C₁₀ heterocycloalkyl group, a phenyl group, or a biphenyl group, each independently unsubstituted or substituted with deuterium, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated a C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C1-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, a phenyl group, a deuterated phenyl group, a (C₁-C₂₀ alkyl)phenyl group, a deuterated (C₁-C₂₀ alkyl)phenyl group, a biphenyl group, a deuterated biphenyl group, a (C₁-C₂₀ alkyl)biphenyl group, a deuterated (C₁-C₂₀ alkyl)biphenyl group, or a combination thereof; or
-Si(Q₃)(Q₄)(Q₅) or -Ge(Q₃)(Q₄)(Q₅).

In an embodiment, R₁ to R₄, R₂₉, and R₃₀ may each independently be:
hydrogen, deuterium, or a cyano group;
a C₁-C₂₀ alkyl group unsubstituted or substituted with deuterium, a cyano group, a C₃-C₁₀ cycloalkyl group, a deuterated C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, or a combination thereof;
a C₃-C₁₀ cycloalkyl group, a C₁-C₁₀ heterocycloalkyl group, a phenyl group, or a biphenyl group, each independently unsubstituted or substituted with deuterium, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated a C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, a phenyl group, a deuterated phenyl group, a (C₁-C₂₀ alkyl)phenyl group, a deuterated (C₁-C₂₀ alkyl)phenyl group, a biphenyl group, a deuterated biphenyl group, a (C₁-C₂₀ alkyl)biphenyl group, a deuterated (C₁-C₂₀ alkyl)biphenyl group, or a combination thereof; or
-Si(Q₃)(Q₄)(Q₅) or -Ge(Q₃)(Q₄)(Q₅).

In an embodiment, in Formulae 2A and 2B, R₁ to R₄, R₂₉, and R₃₀ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C1-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each independently substituted with deuterium, -F, -CI, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each independently unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a (phenyl)C₁-C₁₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Ge(Q₃)(Q₄)(Q₅), -B(Q₆)(Q₇), -P(=O)(Q₈)(Q₉), or-P(Q₈)(Q₉), wherein Q₁ to Q₉ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each independently unsubstituted or substituted with deuterium, a C₁-C₁₀ alkyl group, a phenyl group, or a combination thereof.

In Formulae 2A and 2B, b1, b3, and b4 indicate the number of R₁, the number of R₃, and the number of R₄, respectively, and may each independently be an integer from 0 to 20. When b1 is two or more, two or more of R₁(s) may be identical to or different from each other, and when b3 is two or more, two or more of R₃(s) may be identical to or different from each other, and when b4 is two or more, two or more of R₄(s) may be identical to or different from each other. For example, b1, b3, and b4 may each independently be an integer from 0 to 8.

In Formula 2A, b2 indicates the number of R₂, and may be an integer from 0 to 6. When b2 is 2 or more, two or more of R₂(s) may be identical to or different from each other. For example, b2 may be 0, 1, 2, or 3.

When i) none of T₁ to T₈ in Formula 2A is N, ii) a2 in Formula 2A is not 0, and iii) Z₂ in Formula 2A is a fluoro group, then a) b3 in Formula 2B may not be 0, and b) at least one of R₃(s) in the number of b3 in Formula 2B may be -Si(Q₃)(Q₄)(Q₅) or - Ge(Q₃)(Q₄)(Q₅), wherein Q₃ to Q₅ may each independently be the same as described herein.

For example, Q₃ to Q₅ may each independently be:
a C₁-C₆₀ alkyl group unsubstituted or substituted with deuterium, a C1-C₆₀ alkyl group, a C₆-C₆₀ aryl group, or a combination thereof; or
a C₆-C₆₀ alkyl group unsubstituted or substituted with deuterium, a C1-C₆₀ alkyl group, or a C₆-C₆₀ aryl group, or a combination thereof.

In an embodiment, Q₃ to Q₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each independently unsubstituted or substituted with deuterium, a C1-C₁₀ alkyl group, a phenyl group, or a combination thereof.

In an embodiment, Q₃ to Q₅ may be identical to each other.

In an embodiment, two or more of Q₃ to Q₅ may be identical to each other.

In an embodiment, in Formula 2B, b3 may not 0, and at least one of R₃(s) in the number of b3 may be -Si(Q₃)(Q₄)(Q₅) or -Ge(Q₃)(Q₄)(Q₅).

In an embodiment, the organometallic compound represented by Formula 1 may include at least one deuterium.

For example, the organometallic compound represented by Formula 1 may satisfy at least one of Condition (1) to Condition (4):

### Condition (1)

b1 in Formula 2A is not 0, and at least one of R₁(s) in the number of b1 includes deuterium

### Condition (2)

b2 in Formula 2A is not 0, and at least one of R₂(s) in the number of b2 includes deuterium

### Condition (3)

b3 in Formula 2B is not 0, and at least one of R₃(s) in the number of b3 includes deuterium

### Condition (4)

b4 in Formula 2B is not 0, and at least one of R₄(s) in the number of b4 includes deuterium.

In an embodiment, in Formulae 2A and 2B, R₁ to R₄, R₂₉, and R₃₀ may each independently be hydrogen, deuterium, -F, a cyano group, a nitro group, -SF₅, -CH₃, - CD₃, -CD₂H, -CDH₂, -CF₃, -CF₂H, -CFH₂, -OCH₃, -OCDH₂, -OCD₂H, -OCD₃, -SCH₃, - SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with a fluoro group, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with a fluoro group, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with a fluoro group, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with a fluoro group, -Si(Q₃)(Q₄)(Q₅), or -Ge(Q₃)(Q₄)(Q₅) (wherein Q₃ to Q₅ may each independently be the same as described herein).

In an embodiment, in Formulae 2A and 2B, R₁ to R₄, R₂₉, and R₃₀ may each independently be hydrogen, deuterium, a cyano group, a nitro group, -CH₃, -CD₃, - CD₂H, -CDH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-201 to 9-230, a group represented by one of Formulae 9-201 to 9-230 in which at least one hydrogen is substituted with deuterium, a group represented by one of Formulae 10-1 to 10-145, a group represented by one of Formulae 10-1 to 10-145 in which at least one hydrogen is substituted with deuterium, a group represented by one of Formulae 10-201 to 10-354, group represented by one of Formulae 10-201 to 10-354 in which at least one hydrogen is substituted with deuterium, -Si(Q₃)(Q₄)(Q₅), or -Ge(Q₃)(Q₄)(Q₅) (wherein Q₃ to Q₅ may each independently be the same as described herein).

In an embodiment, in Formulae 2A and 2B, Z₁, Z₃, and Z₄ may each independently be -F, -CF₃, -CF₂H, -CFH₂, a group represented by of one of Formulae 9-1 to 9-39 in which at least one hydrogen is substituted with a fluoro group, a group represented by of one of Formulae 9-201 to 9-230 in which at least one hydrogen is substituted with a fluoro group, a group represented by one of Formulae 10-1 to 10-145 in which at least one hydrogen is substituted with a fluoro group, or a group represented by one of Formulae 10-201 to 10-354 in which at least one hydrogen is substituted with a fluoro group.

In an embodiment, in Formula 2A, Z₂ may be -F, -CF₃, -CF₂H, -CFH₂, a group represented by one of Formulae 9-1 to 9-39 in which at least one hydrogen is substituted with a fluoro group, a group represented by one of Formulae 9-201 to 9-227 in which at least one hydrogen is substituted with a fluoro group, or a group represented by one of Formulae 10-1 to 10-11 in which at least one hydrogen is substituted with a fluoro group: 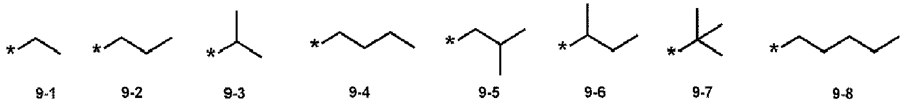 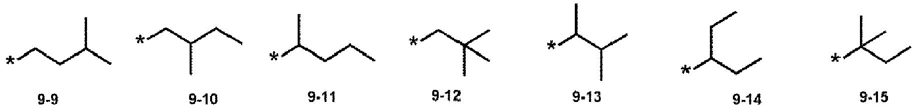 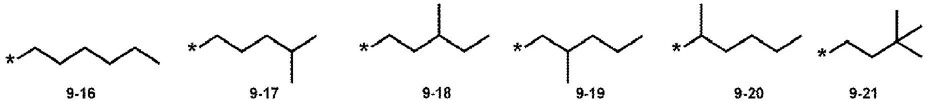 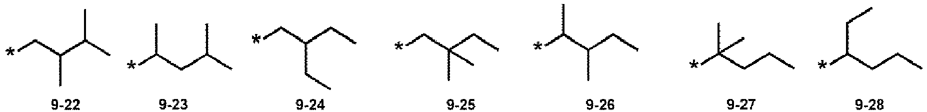 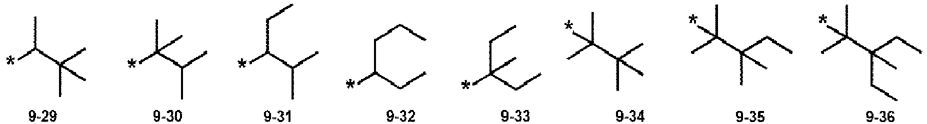 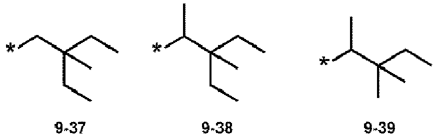 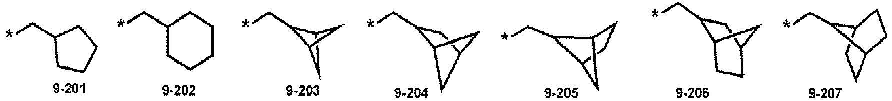 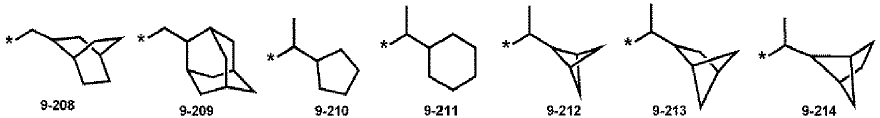 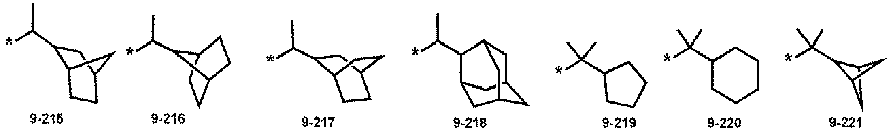 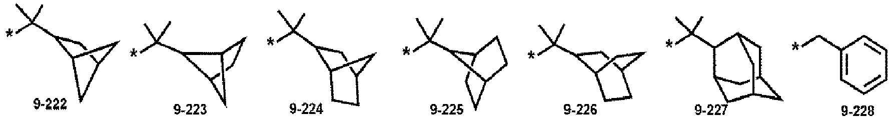 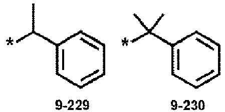 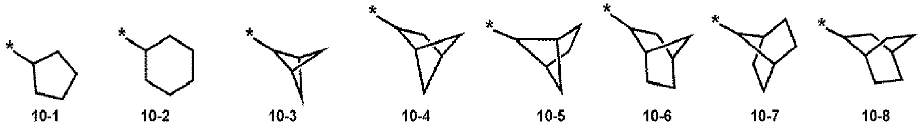 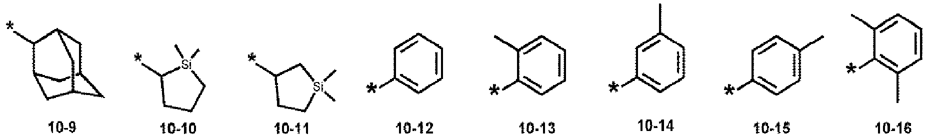 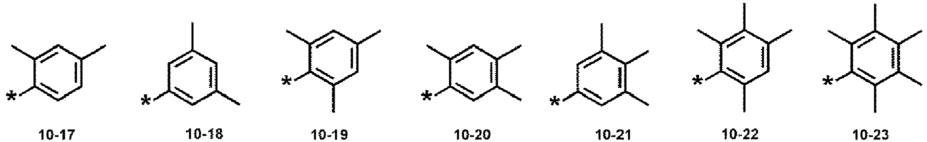 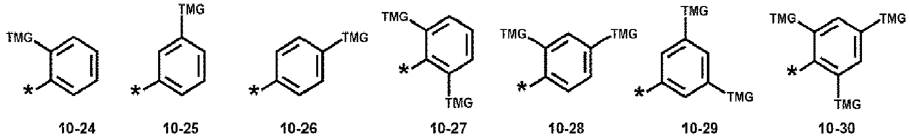 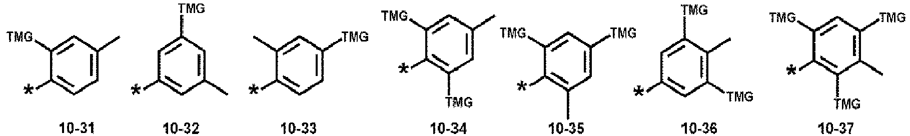 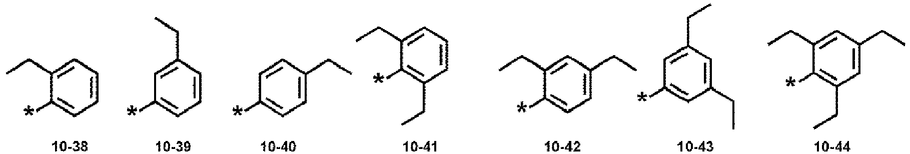 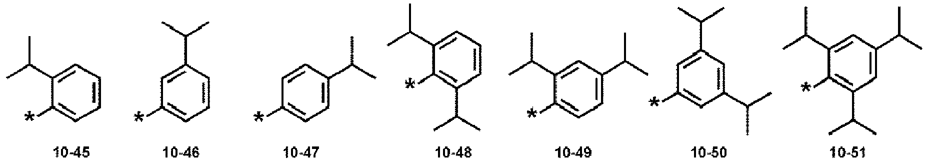 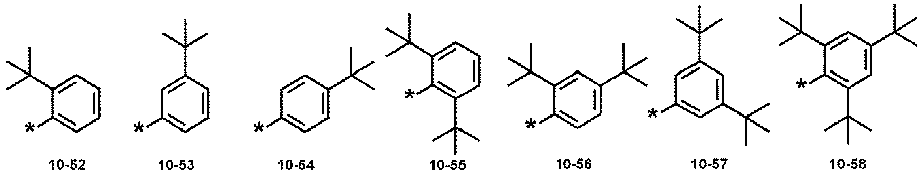 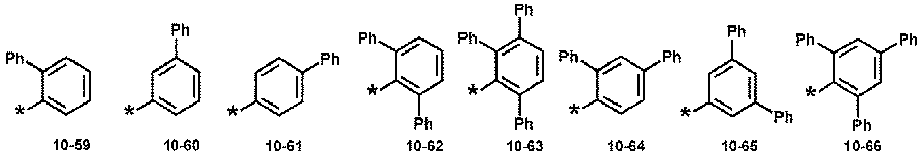 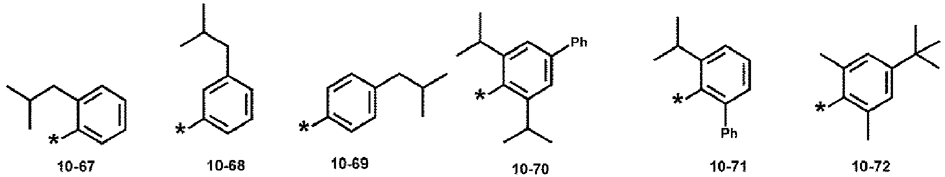 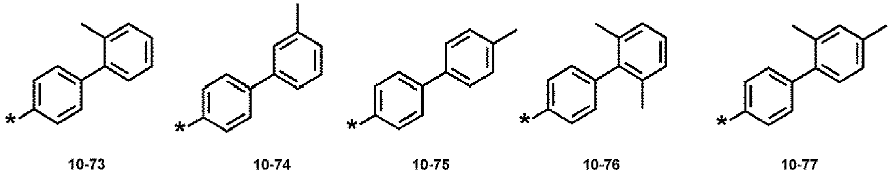 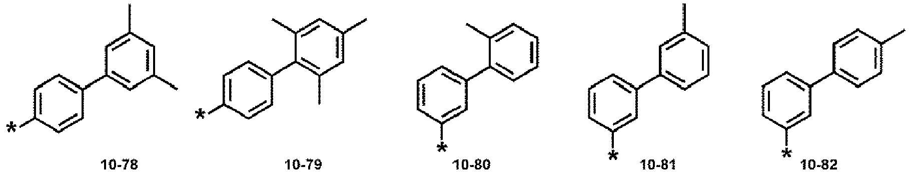 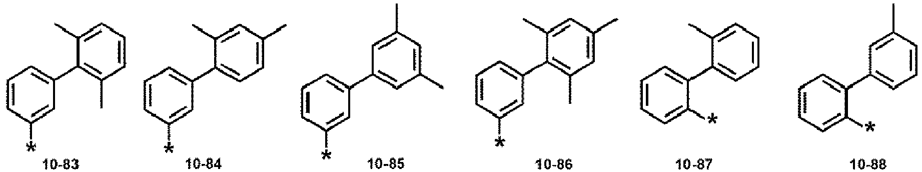 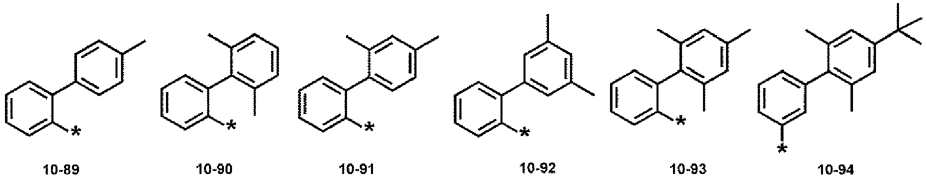 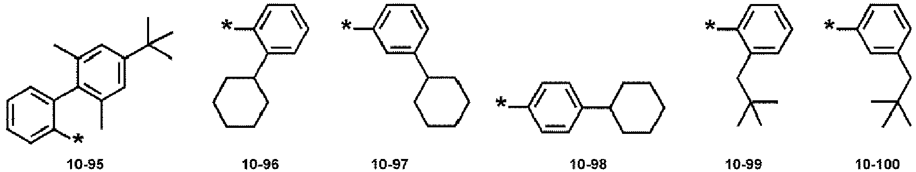 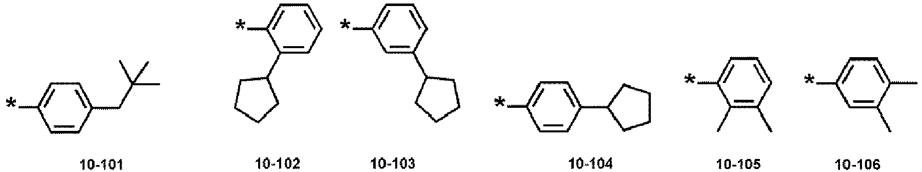 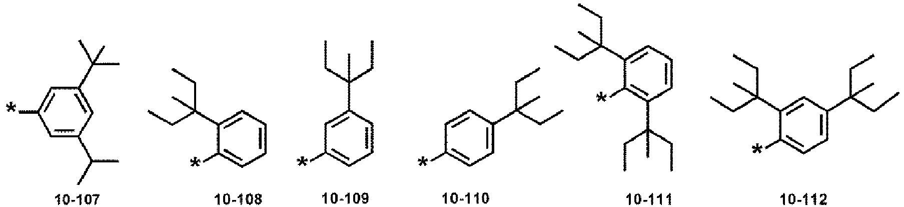 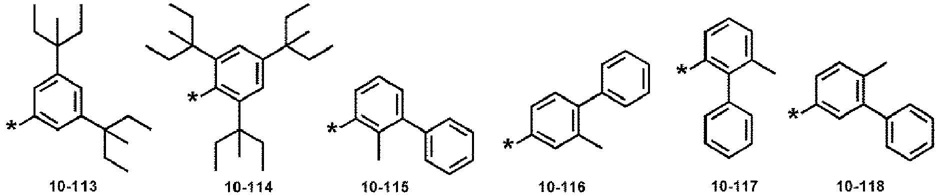 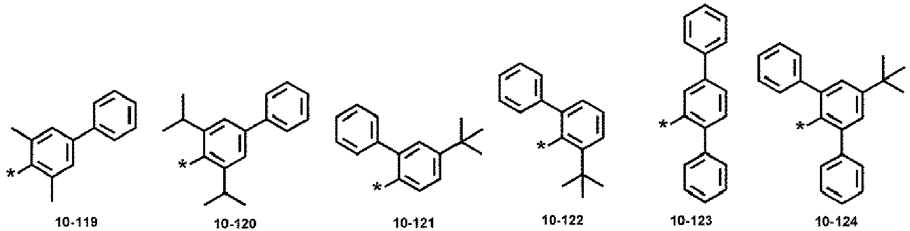 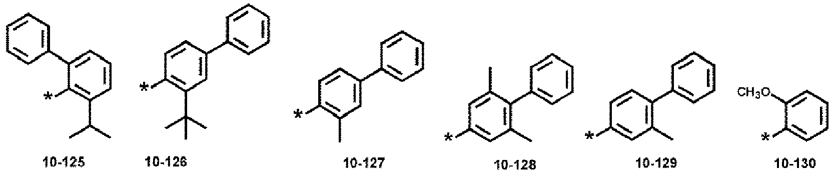 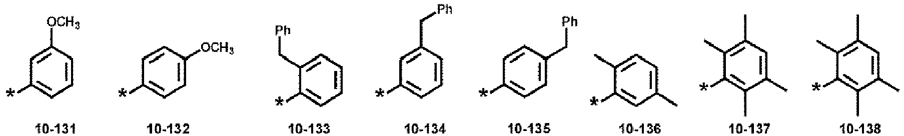 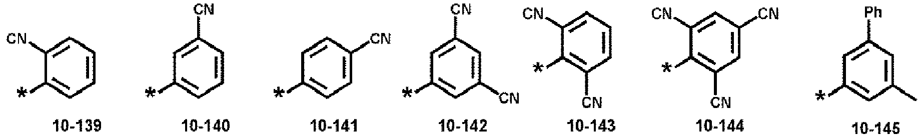 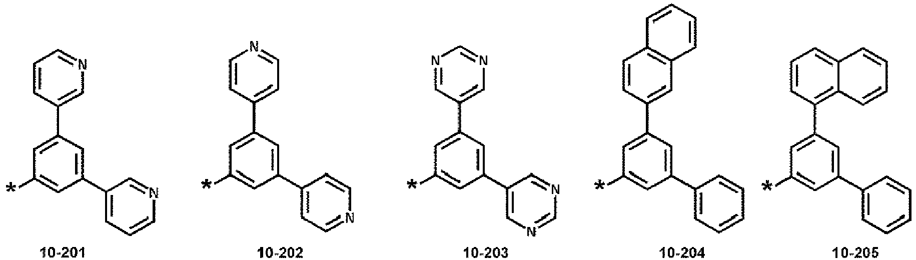 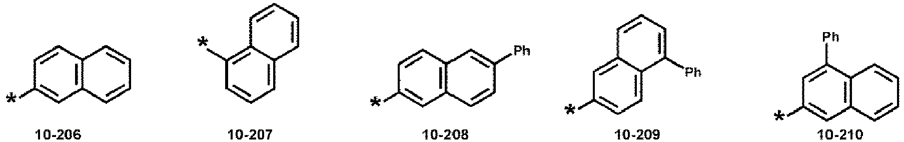 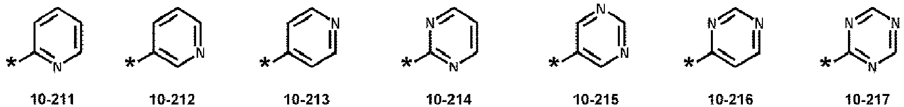 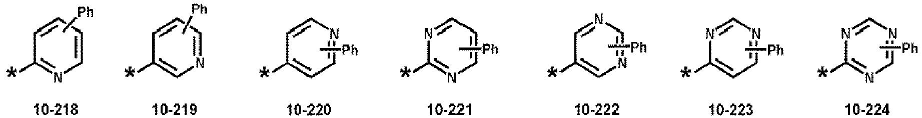 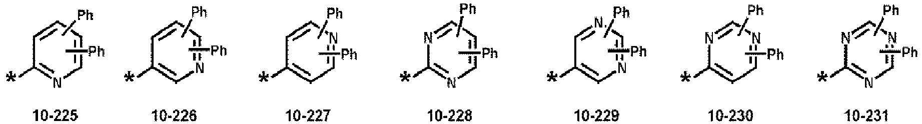 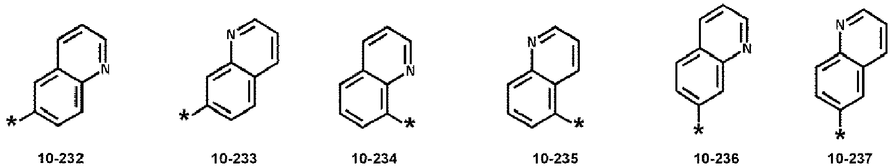 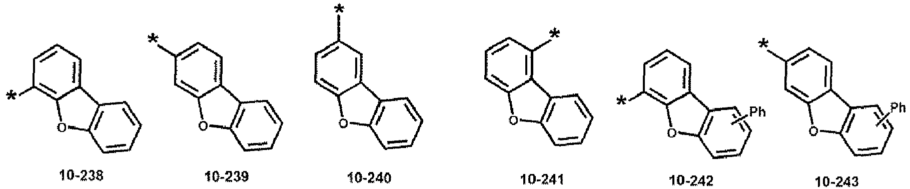 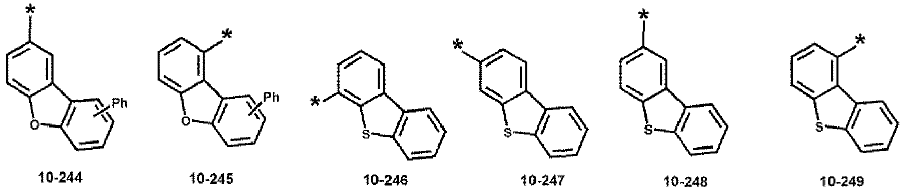 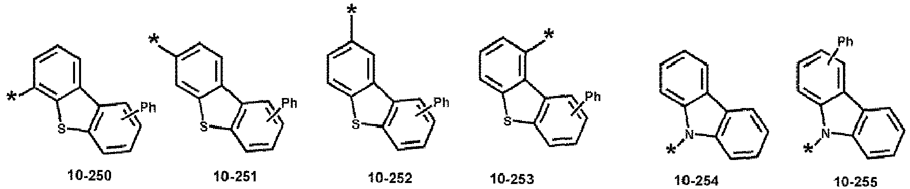 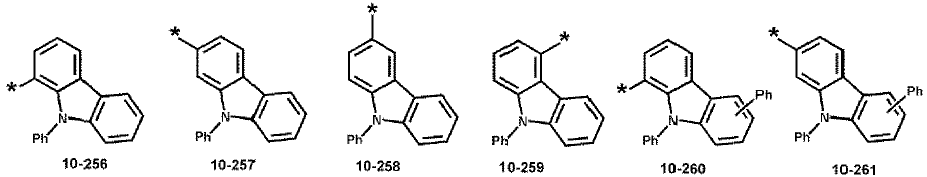 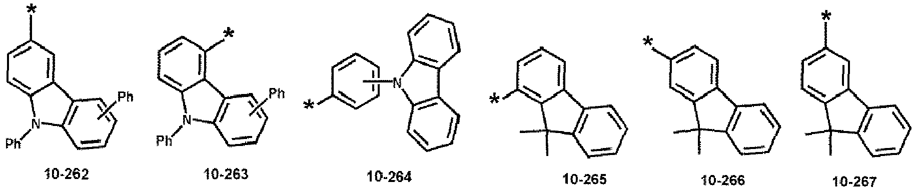 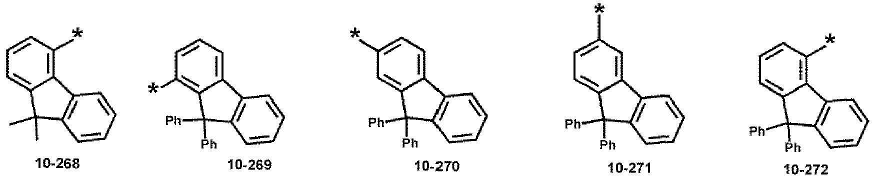 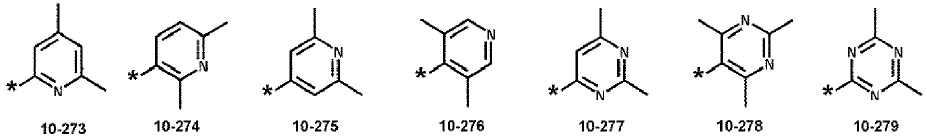 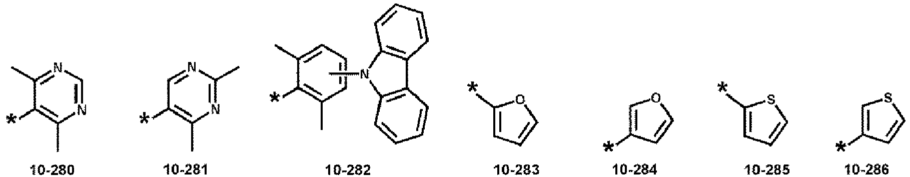 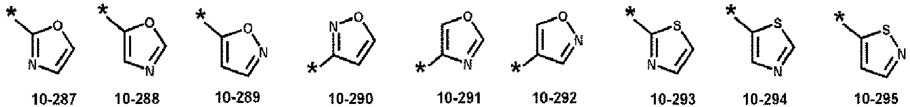 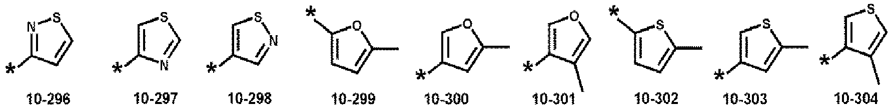 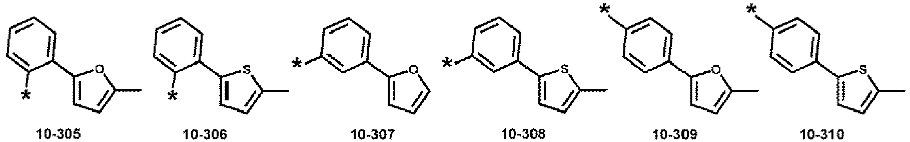 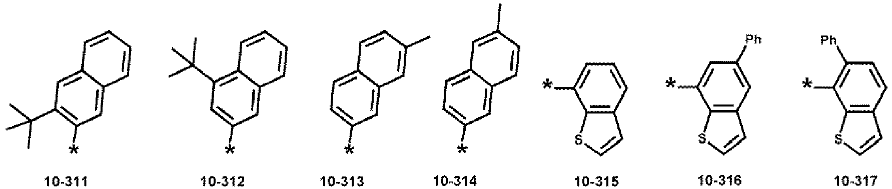 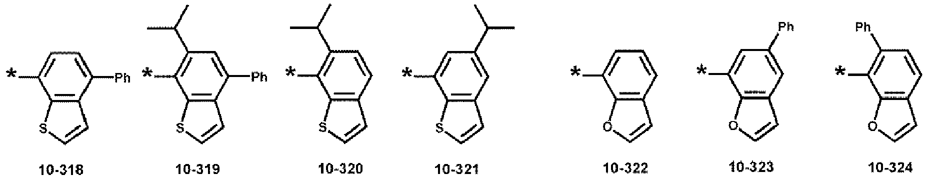 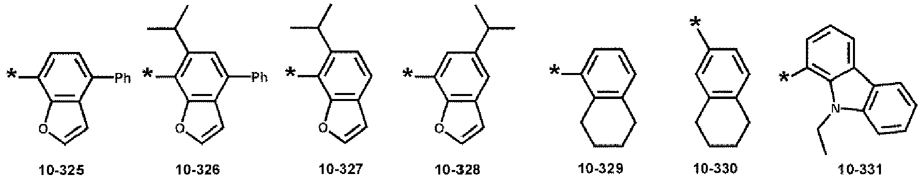 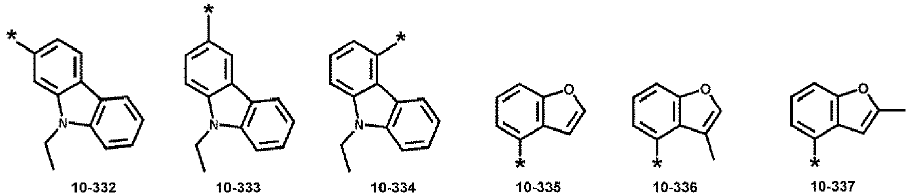 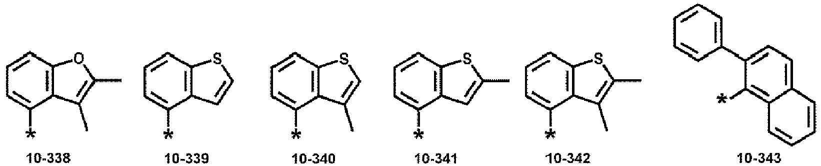 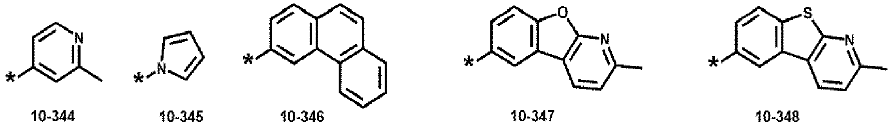 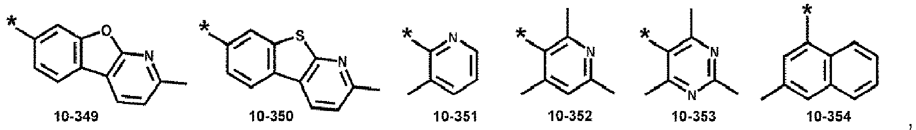 wherein, in Formulae 9-1 to 9-39, 9-201 to 9-230, 10-1 to 10-145, and 10-201 to 10-354, * indicates a binding site to a neighboring atom, Ph indicates a phenyl group, TMS indicates a trimethylsilyl group, TMG indicates a trimethylgermyl group, and OMe indicates a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may be, for example, a group represented by one of Formulae 9-501 to 9-514 and 9-601 to 9-637: 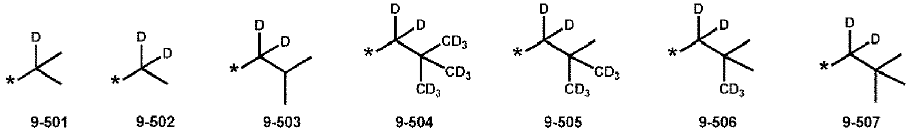 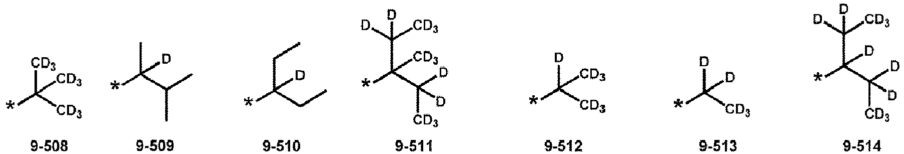 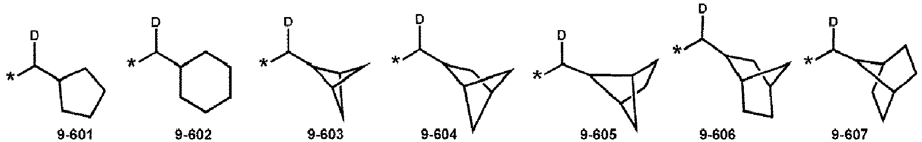 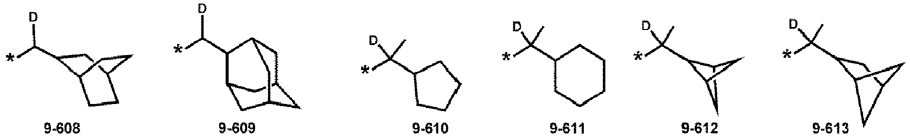 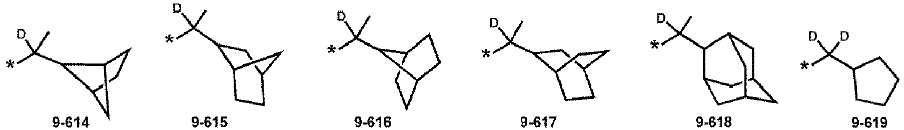 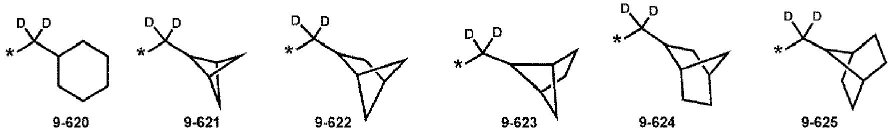 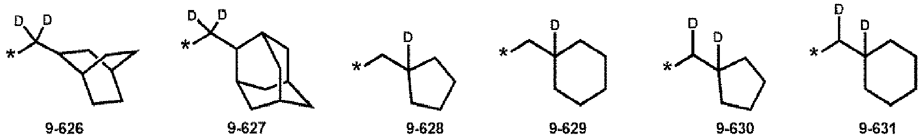 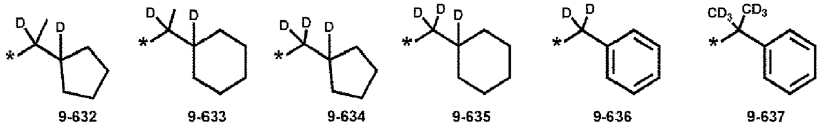 wherein * indicates a binding site to a neighboring atom.

The "group represented by one of Formulae 9-1 to 9-39 in which at least one hydrogen is substituted with a fluoro group" and the "group represented by one of Formulae 9-201 to 9-230 in which at least one hydrogen is substituted with a fluoro group" may be, for example, a group represented by one of Formulae 9-701 to 9-710: 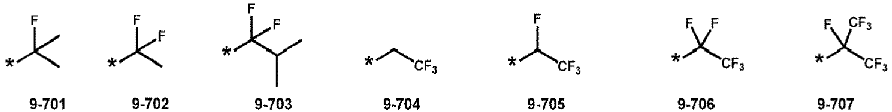 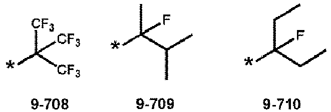 wherein * indicates a binding site to a neighboring atom.

The "group represented by one of Formulae 10-1 to 10-145 in which at least one hydrogen is substituted with deuterium" and the "group represented by one of Formulae 10-201 to 10-354 in which at least one hydrogen is substituted with deuterium" may be, for example, a group represented by one of Formulae 10-501 to 10-553: 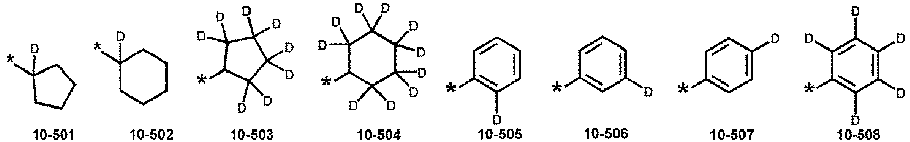 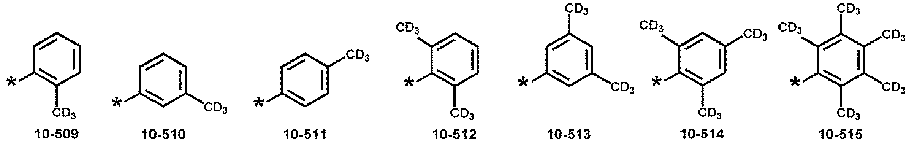 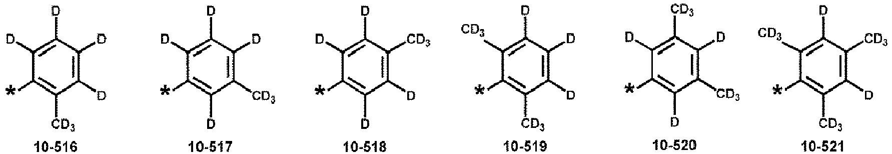 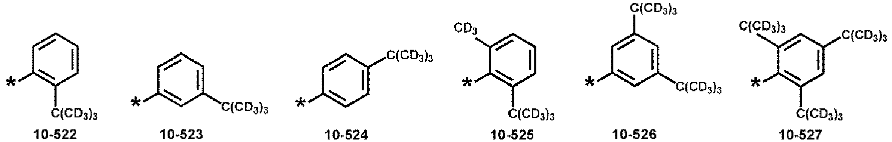 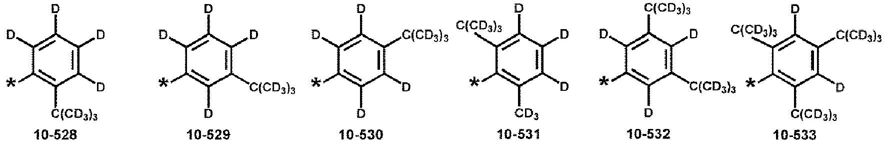 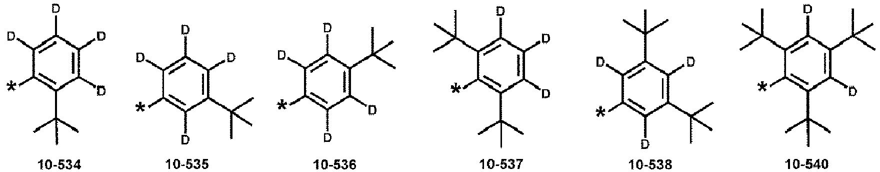 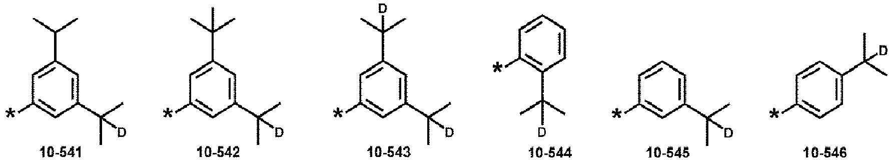 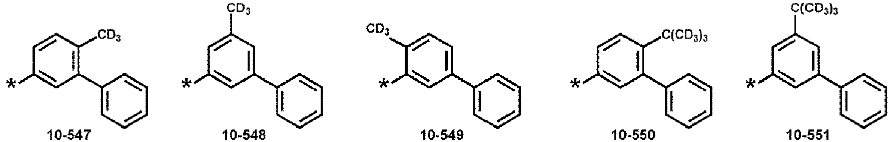 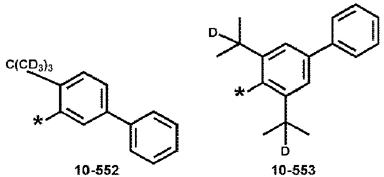 wherein * indicates a binding site to a neighboring atom.

The "group represented by one of Formulae 10-1 to 10-145 in which at least one hydrogen is substituted with a fluoro group" and the "group represented by Formulae 10-201 to 10-354 in which at least one hydrogen is substituted with a fluoro group" may be, for example, a group represented by one of Formulae 10-601 to 10-636: 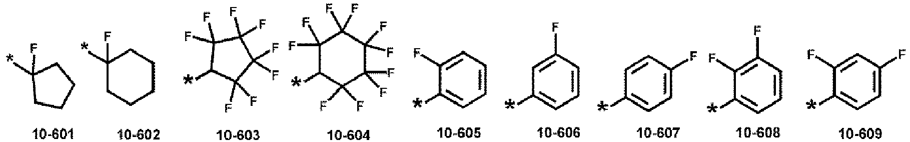 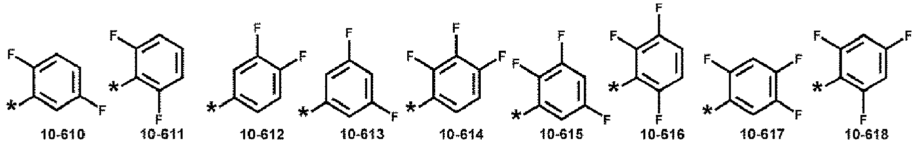 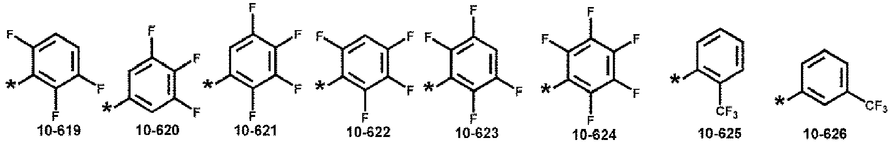 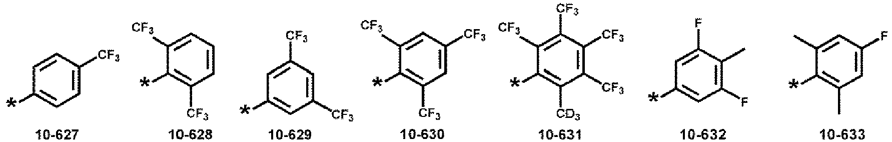 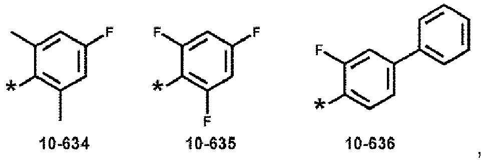 wherein * indicates a binding site to a neighboring atom.

In Formulae 2A and 2B, i) two or more of a plurality of R₁(s) may optionally be linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ, ii) two or more of a plurality of R₂(s) may optionally be linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ, iii) two or more of a plurality of R₃ (s) may optionally be linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ, and iv) two or more of a plurality of R₄(s) may optionally be linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ, wherein R₁₀ₐ may be the same as described in connection with R₁.

In Formulae 2A and 2B, * and *' each indicate a binding site to M in Formula 1. In an embodiment, a group represented by 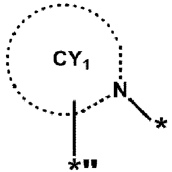 in Formula 2A may be a group represented by one of Formulae CY1(1) to CY1(22): 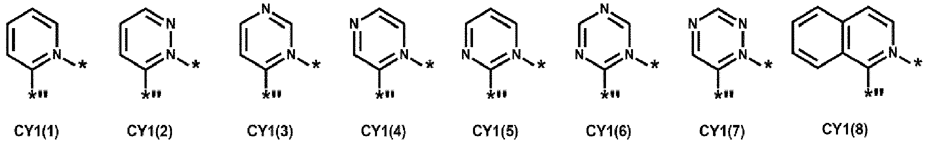 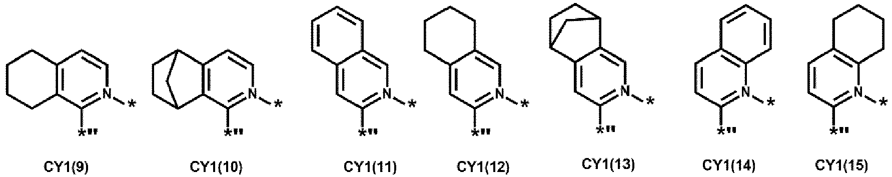 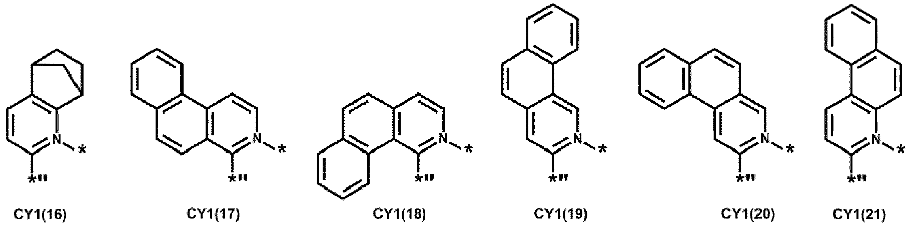 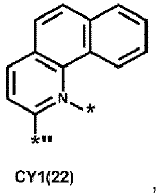 wherein, in Formulae CY1(1) to CY1(22), * indicates a binding site to M in Formula 1, and *" indicates a binding site to a neighboring carbon atom in Formula 2A.

In an embodiment, a group represented by 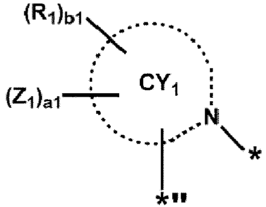 in Formula 2A may be a group represented by one of Formulae CY1-1 to CY1-16 and CY1-1F to CY1-32F: 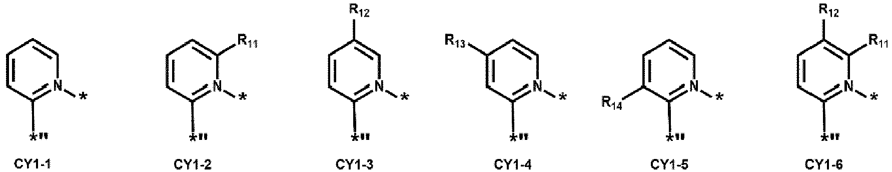 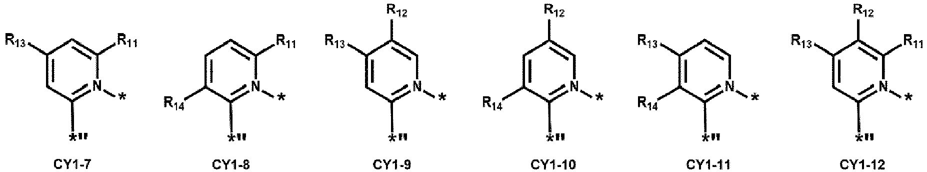 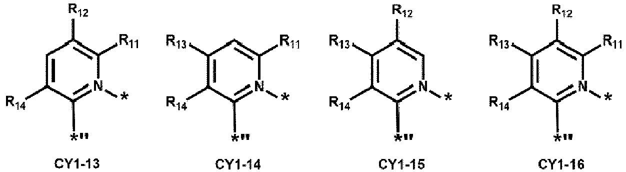 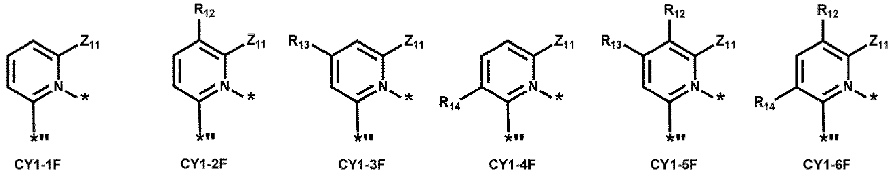 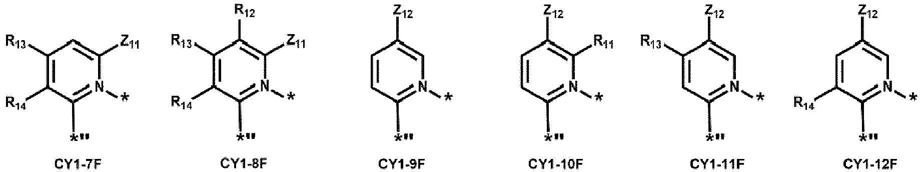 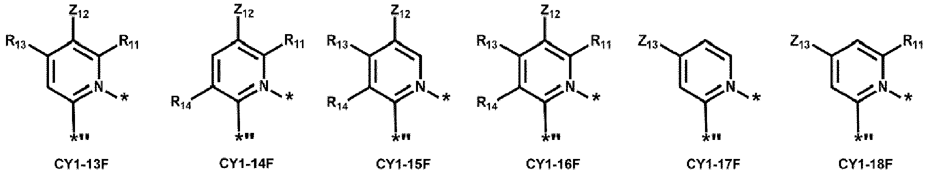 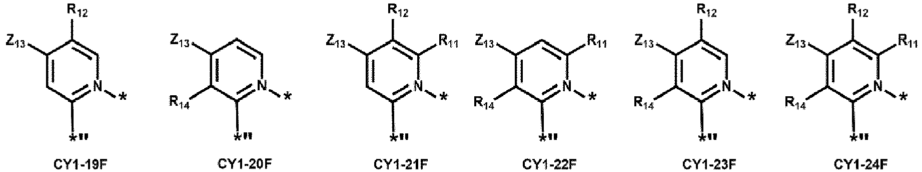 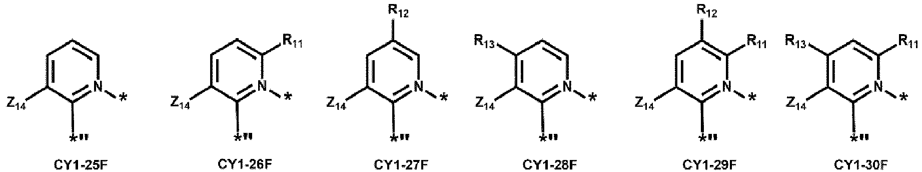 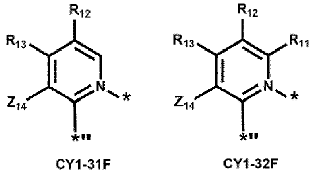
wherein, in Formulae CY1-1 to CY1-16 and CY1-1F to CY1-32F,
Z₁₁ to Z₁₄ may each be the same as described in connection with Z₁,
R₁₁ to R₁₄ may each be the same as described in connection with R₁, wherein each of R₁₁ to R₁₄ may not be hydrogen,
* indicates a binding site to M in Formula 1, and
*" indicates a binding site to a neighboring carbon atom in Formula 2A. In an embodiment, a group represented by 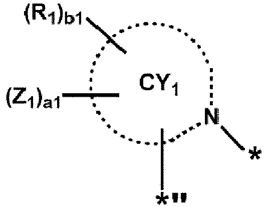 in Formula 2A may be a group represented by one of Formulae CY1(8) to CY1(22).

In an embodiment, a group represented by 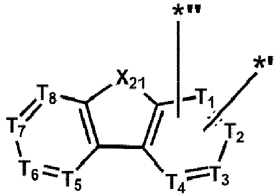 in Formula 2A may be a group represented by one of Formulae CY2-1 to CY2-6: 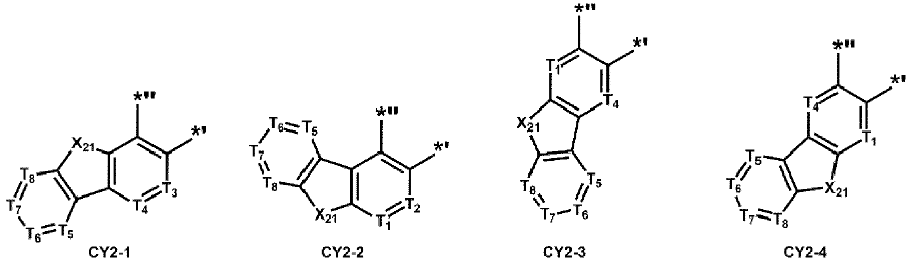 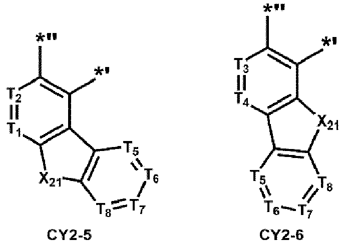 wherein, in Formulae CY2-1 to CY2-6, *' indicates a binding site to M in Formula 1, and *" indicates a binding site to ring CY₁ in Formula 2A. In an embodiment, in Formulae CY2-1 to CY2-6, each of T₁ to T₈ may be C.

In an embodiment, in Formulae CY2-1 to CY2-6, T₈ may be N, and each of T₁ to T₇ may be C.

In an embodiment, a group represented by 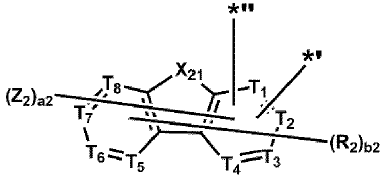 in Formula 2A may be a group represented by one of Formulae CY2-1-1 to CY2-1-22, CY2-1-1N to CY2-1-16N, CY2-4-1 to CY2-4-22, CY2-4-1N to CY2-4-16N, CY2-1-1F to CY2-1-21F, CY2-1-1NF to CY2-1-15NF, CY2-4-1F to CY2-4-21F, and CY2-4-1NF to CY2-4-15NF: 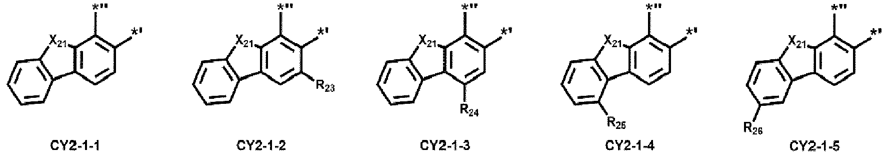 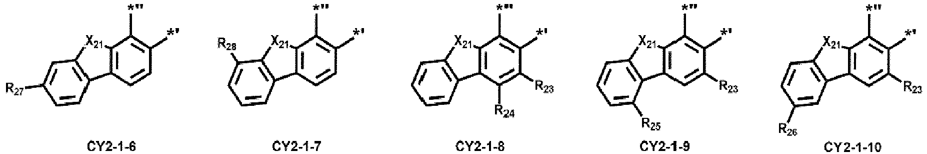 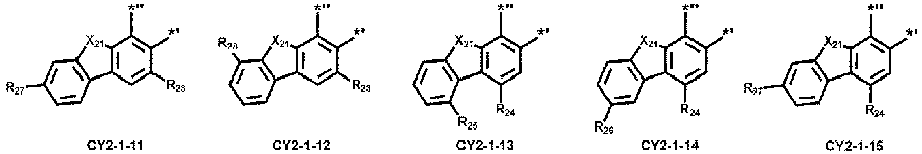 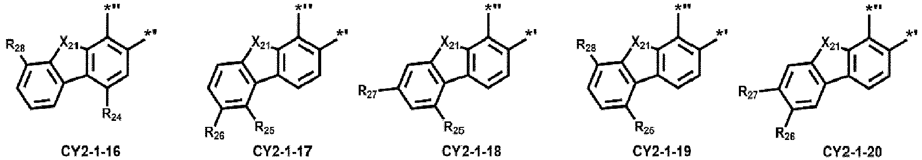 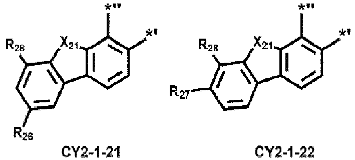 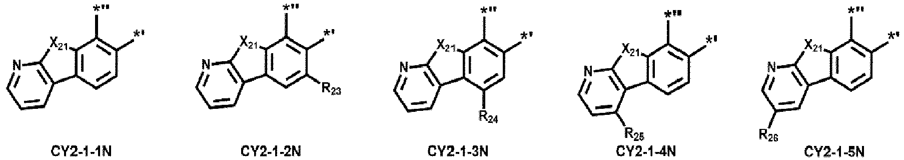 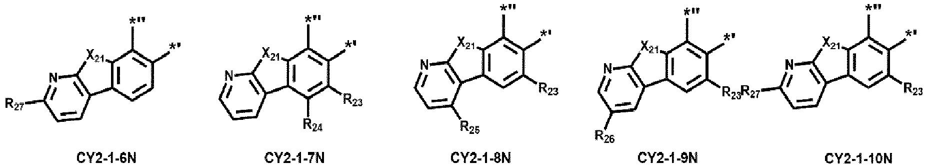 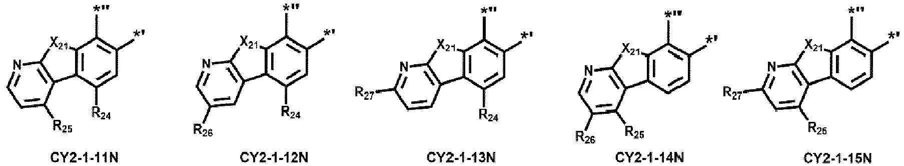 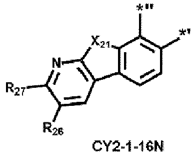 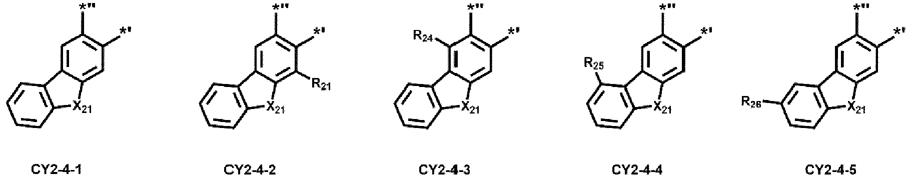 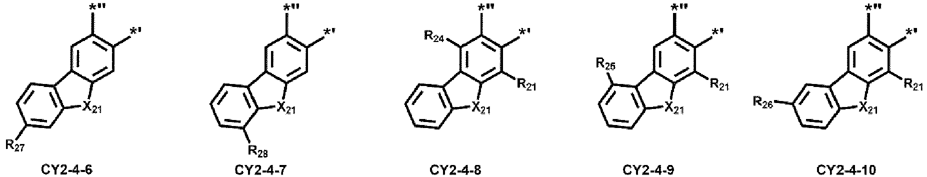 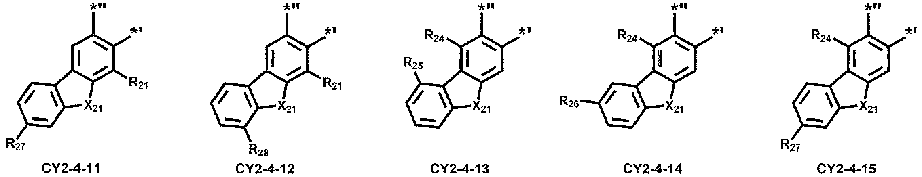 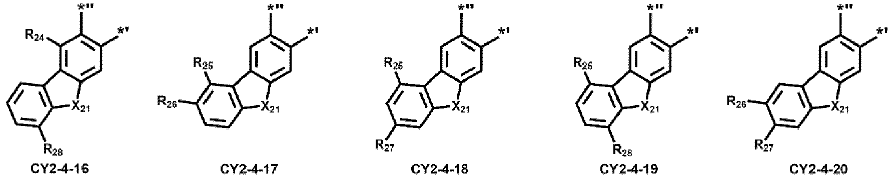 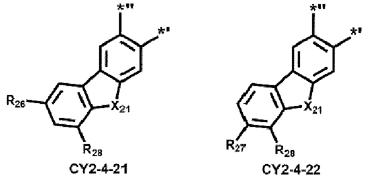 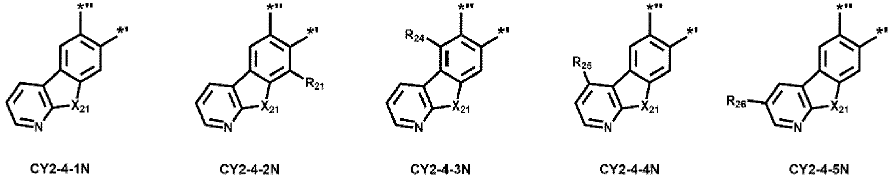 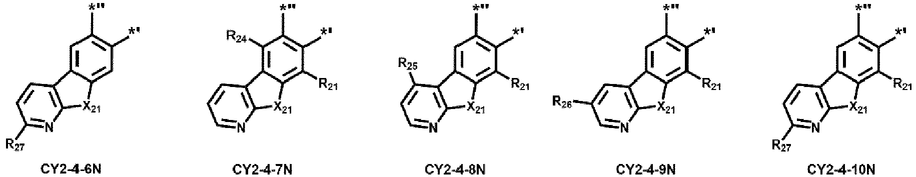 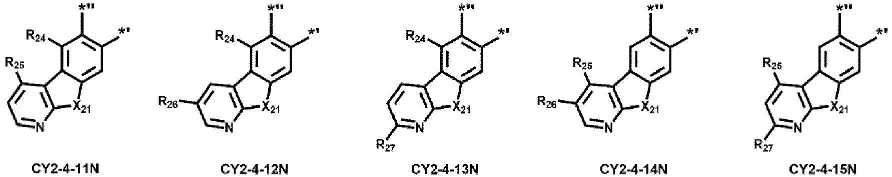 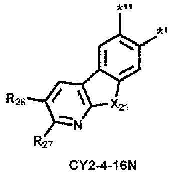 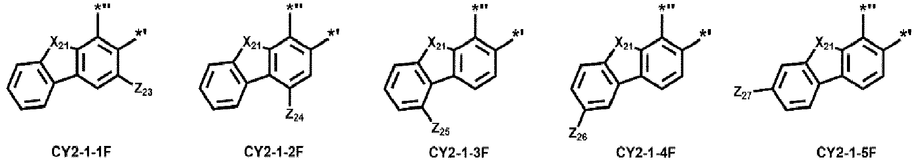 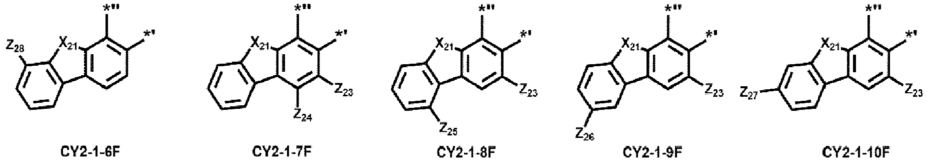 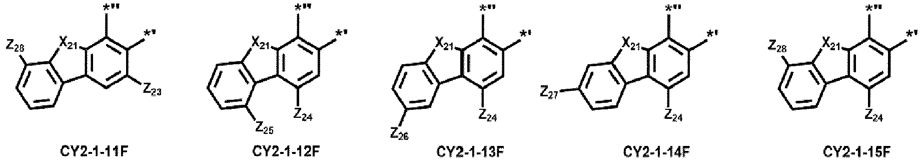 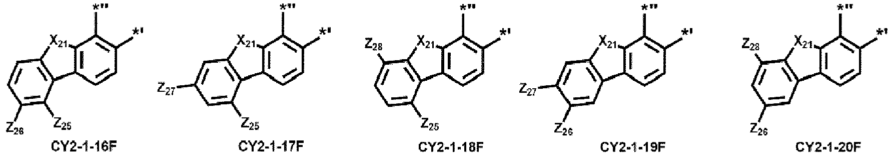 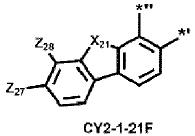 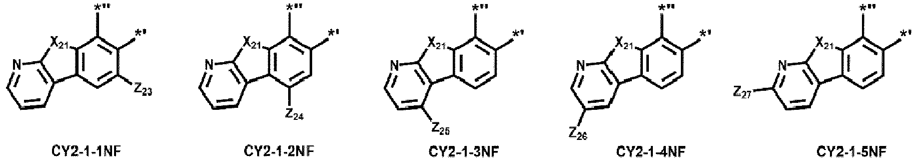 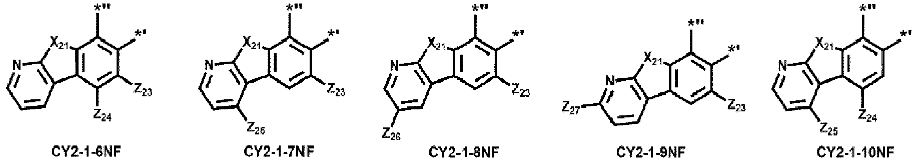 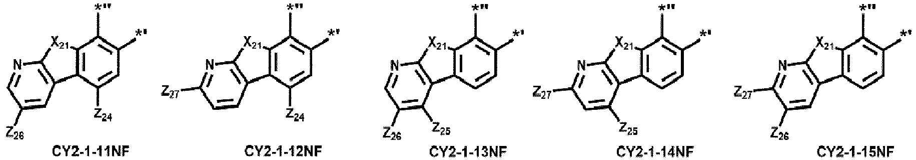 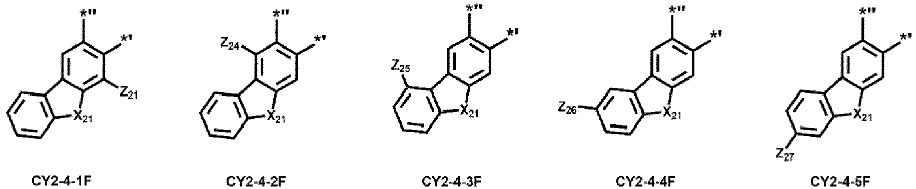 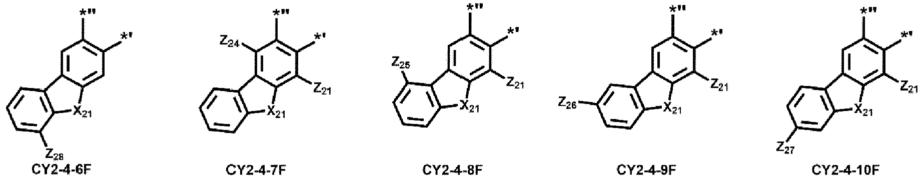 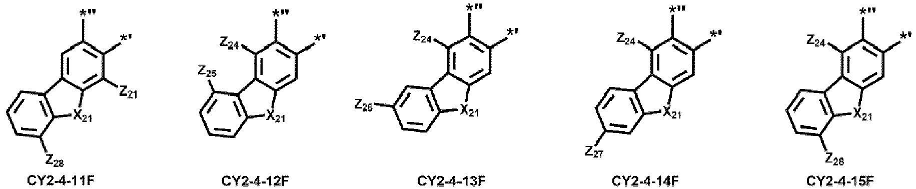 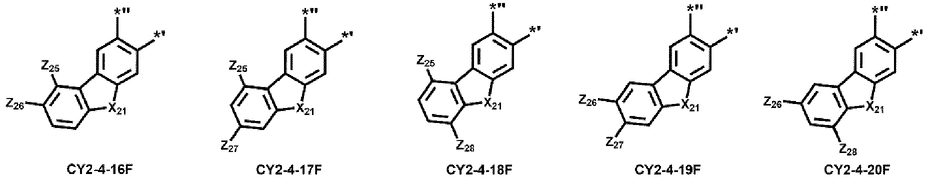 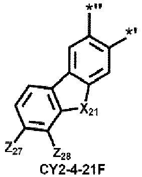 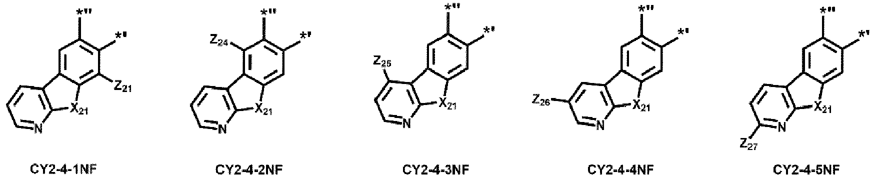 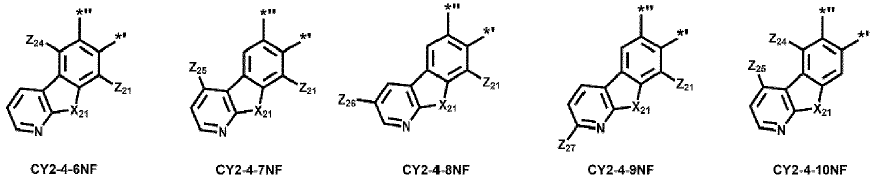 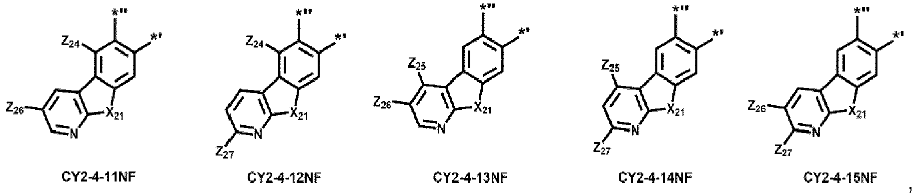
wherein, in Formulae CY2-1-1 to CY2-1-22, CY2-1-1N to CY2-1-16N, CY2-4-1 to CY2-4-22, CY2-4-1N to CY2-4-16N, CY2-1-1F to CY2-1-21F, CY2-1-1 NF to CY2-1-15NF, CY2-4-1F to CY2-4-21F, and CY2-4-1NF to CY2-4-15NF,
Z₂₁ to Z₂₈ may each be the same as described in connection with Z₂,
R₂₁ to R₂₈ may each be the same as described in connection with R₂, wherein each of R₂₁ to R₂₈ may not be hydrogen,
*' indicates a binding site to M in Formula 1, and
*" indicates a binding site to ring CY₁ in Formula 2A.

In an embodiment, a group represented by 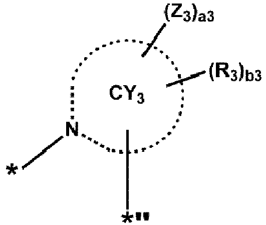 in Formula 2B may be a group represented by Formula CY3(1): 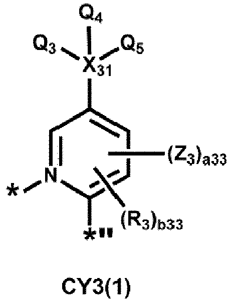 wherein, in Formula CY3(1),
X₃₁ may be Si or Ge,
Z₃, R₃, and Q₃ to Q₅ may each be the same as described herein,
a33 and b33 may each independently be an integer from 0 to 3,
two or more of R₃(s) in the number of a33 may optionally be linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ (for example, a cyclohexane group, a norbornane group, a benzene group, a pyridine group, a naphthalene group, a quinoline group, or an isoquinoline group, each independently unsubstituted or substituted with at least one R₁₀ₐ),
* indicates a binding site to M in Formula 1, and
*" indicates a binding site to ring CY₄ in Formula 2B.

For example, in Formula CY3(1), at least one of R₃(s) in the number of a33 may further include two or more carbons.

In an embodiment, a group represented by 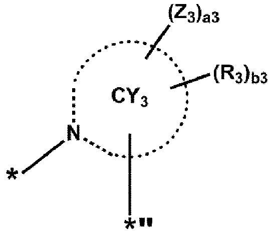 in Formula 2B may be a group represented by one of Formulae CY3-1 to CY3-16 and CY3-1F to CY3-32F: 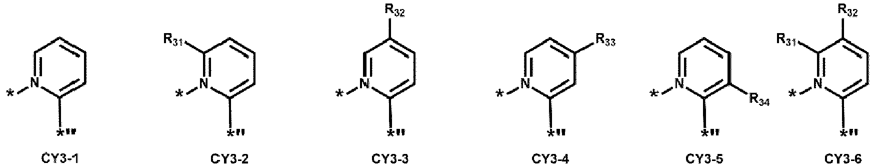 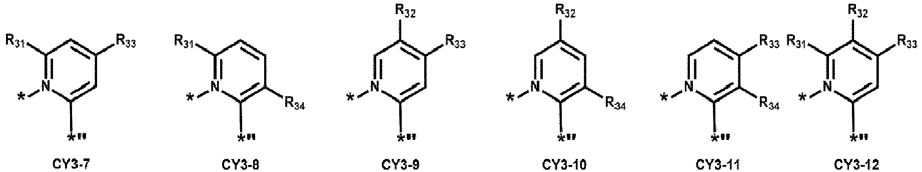 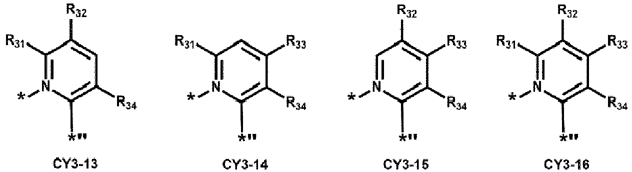 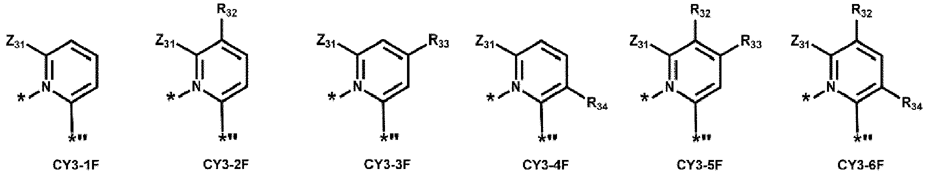 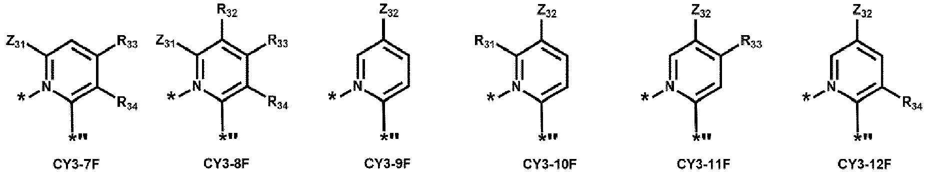 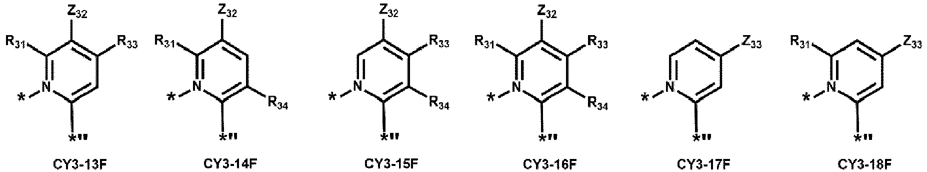 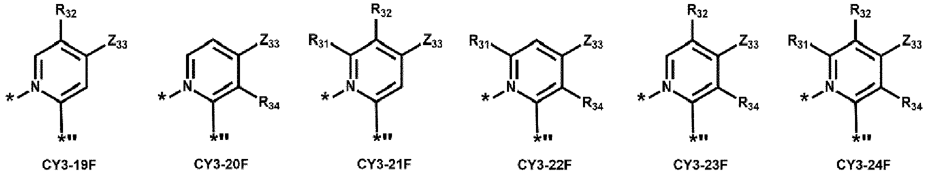 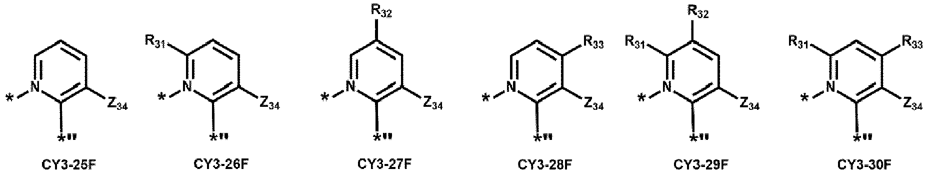 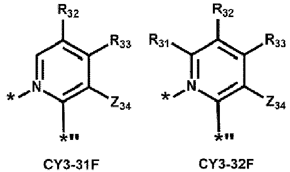
wherein, in Formulae CY3-1 to CY3-16 and CY3-1F to CY3-32F,
Z₃₁ to Z₃₄ may each be the same as described in connection with Z₃,
R₃₁ to R₃₄ may each be the same as described in connection with R₃, wherein each of R₃₁ to R₃₄ may not be hydrogen,
* indicates a binding site to M in Formula 1, and
*" indicates a binding site to ring CY₄ in Formula 2B.

In an embodiment, in Formulae CY3-1 to CY3-16 and CY3-1F to CY3-32F, R₃₂ may be a C₁-C₁₀ alkyl group substituted with at least one deuterium; -Si(Q₃)(Q₄)(Q₅); or -Ge(Q₃)(Q₄)(Q₅).

In an embodiment, in Formulae CY3-1 to CY3-16 and CY3-1F to CY3-32F, R₃₃ may include two or more carbons.

In an embodiment, in Formulae CY3-1 to CY3-16 and CY3-1F to CY3-32F, R₃₃ and R₃₄ may optionally be linked to each other to form a C₃-C₃₀ carbocyclic group that is unsubstituted or substituted with at least one R₁₀ₐ or a C₁-C₃₀ heterocyclic group that is unsubstituted or substituted with at least one R₁₀ₐ (for example, a cyclohexane group, a norbornane group, a benzene group, a pyridine group, a naphthalene group, a quinoline group, or an isoquinoline group, each independently unsubstituted or substituted with at least one R₁₀ₐ).

In an embodiment, a group represented by 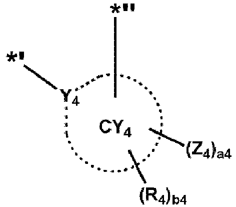 in Formula 2B may be a group represented by one of Formulae CY4-1 to CY4-16 and CY4-1F to CY4-32F: 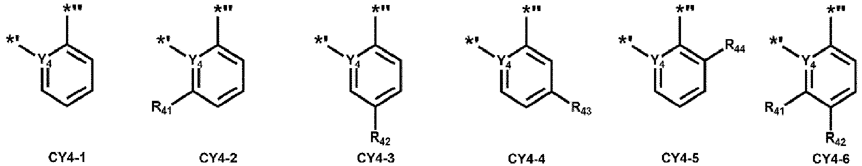 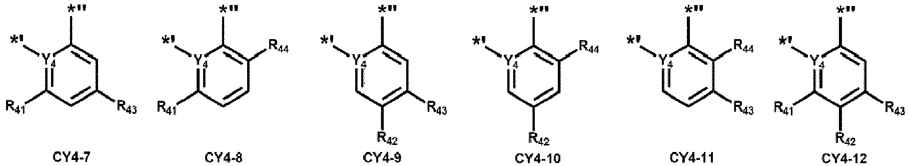 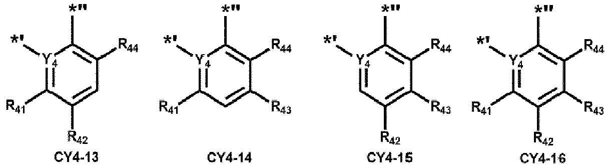 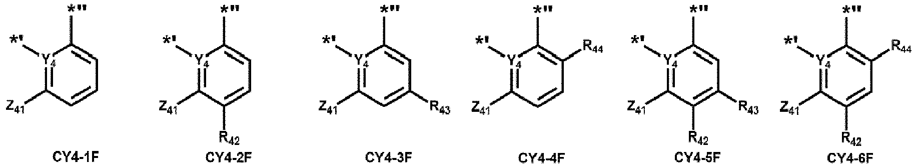 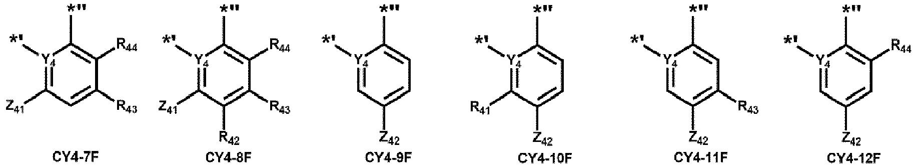 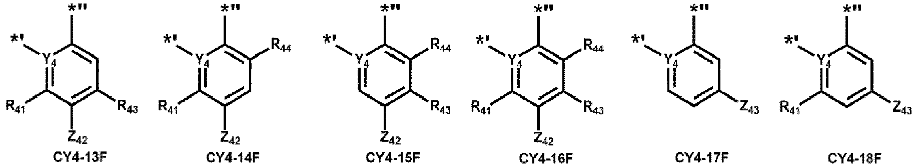 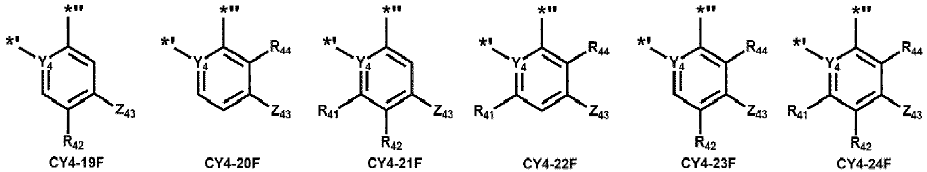 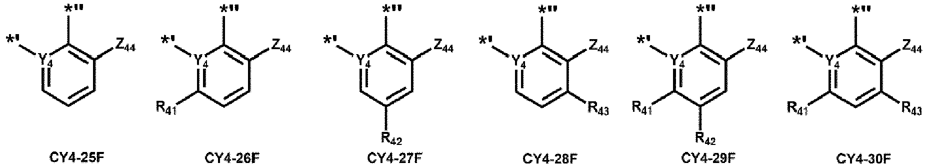 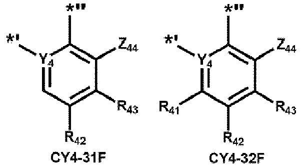
wherein, in Formulae CY4-1 to CY4-16 and CY4-1F to CY4-32F,
Z₄₁ to Z₄₄ may each be the same as described in connection with Z₄,
R₄₁ to R₄₄ may each be the same as described in connection with R₄, wherein each of R₄₁ to R₄₄ may not be hydrogen,
*' indicates a binding site to M in Formula 1, and
*" indicates a binding site to ring CY₃ in Formula 2B.

In an embodiment, the organometallic compound represented by Formula 1 may satisfy at least one of Condition 1 to Condition 4:
Condition 1 a group represented by 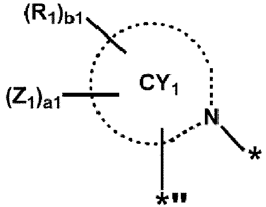 in Formula 2A is a group represented by one of Formulae CY1-1F to CY1-32F Condition 2 a group represented by 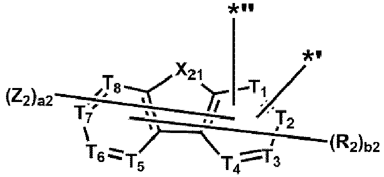 in Formula 2A is a group represented by one of Formulae CY2-1-1F to CY2-1-21F, CY2-1-1NF to CY2-1-15NF, CY2-4-1F to CY2-4-21F and CY2-4-1NF to CY2-4-15NF
Condition 3 a group represented by 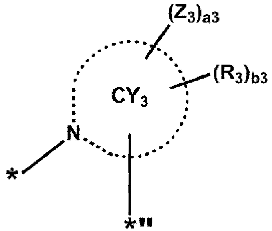 in Formula 2B is a group represented by one of Formulae CY3-1F to CY3-32F
Condition 4 a group represented by 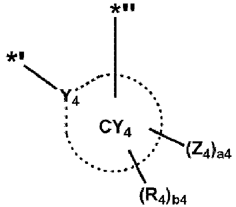 in Formula 2B is a group represented by one of Formulae CY4-1F to CY4-32F.

In an embodiment, the organometallic compound may be one of Compounds 1 to 1440:

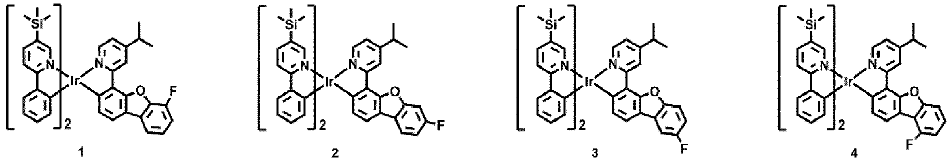

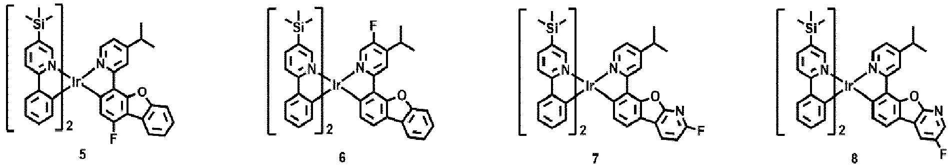

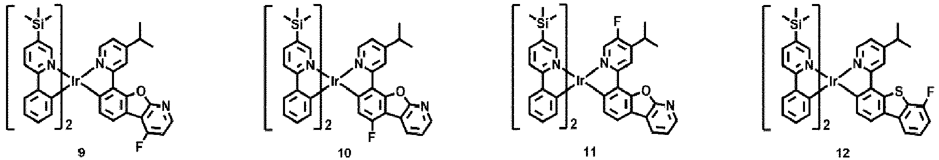

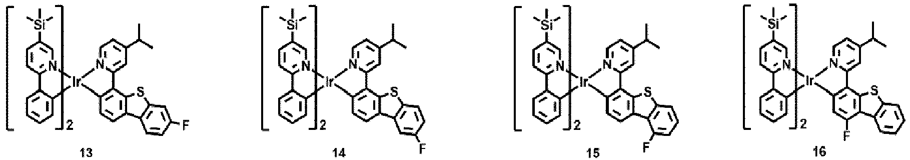

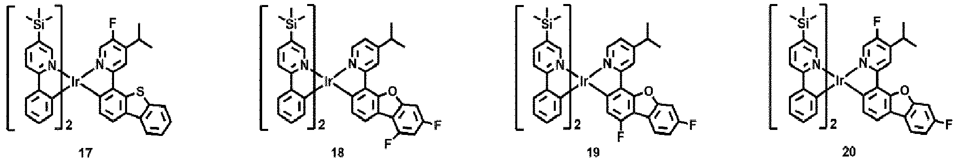

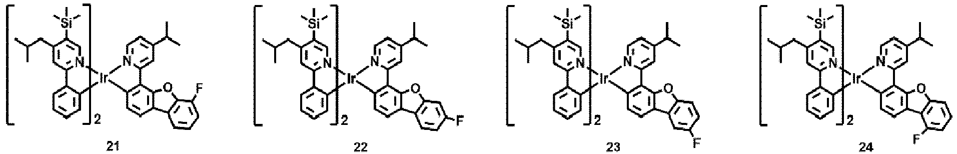

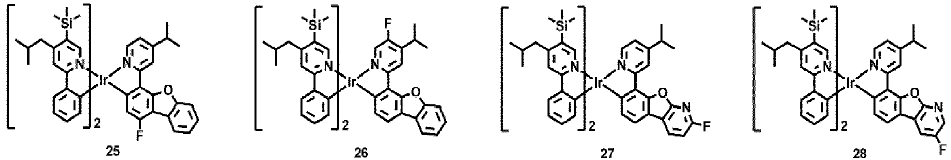

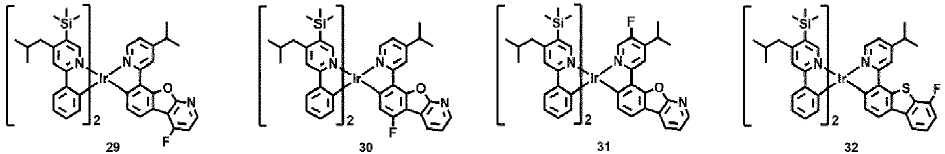

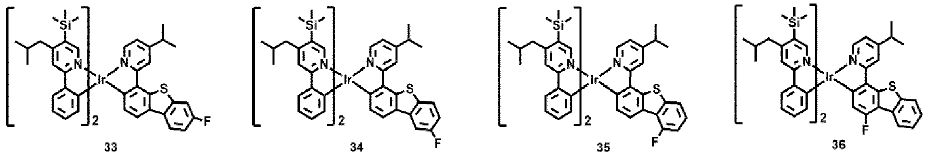

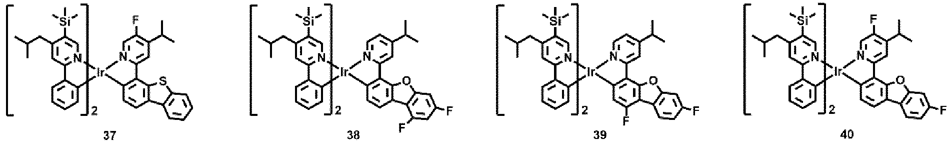

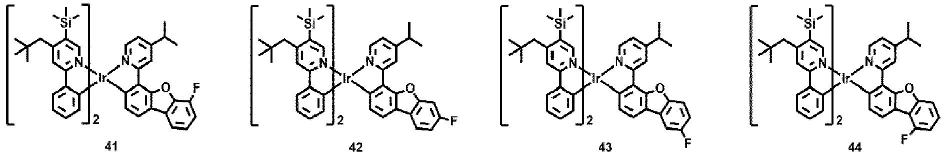

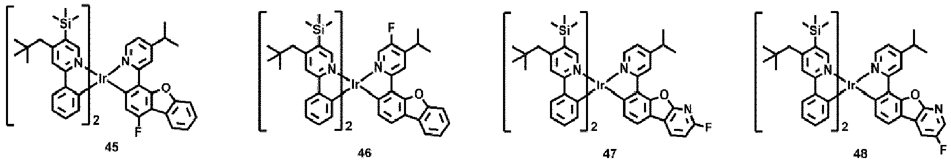

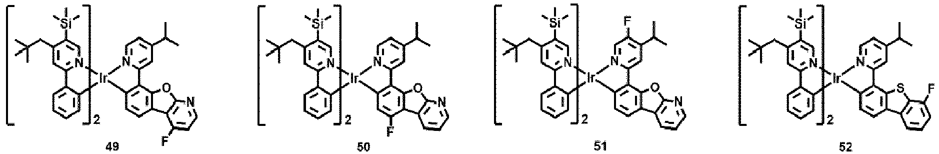

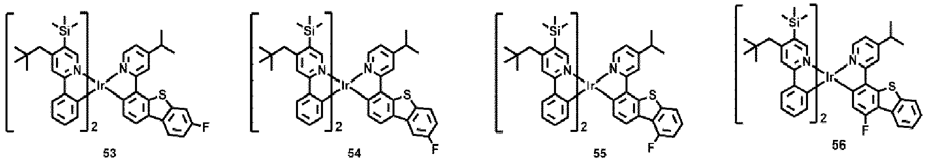

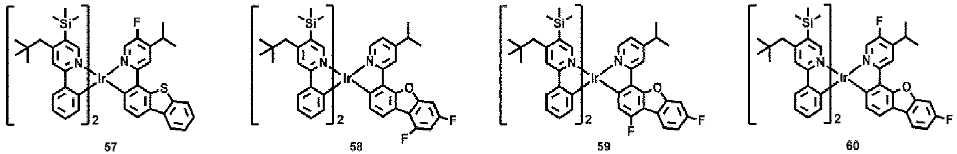

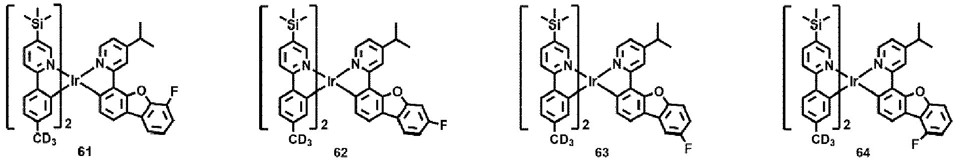

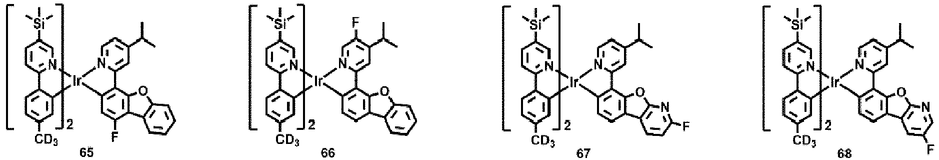

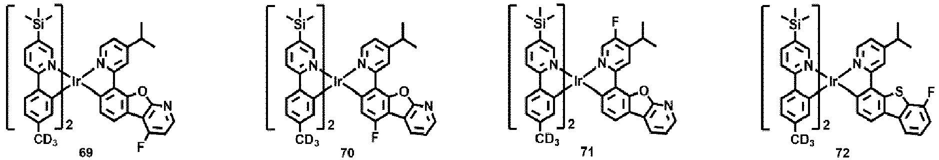

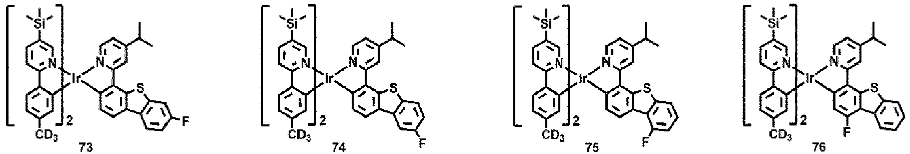

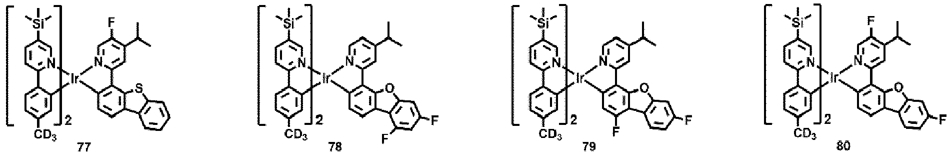

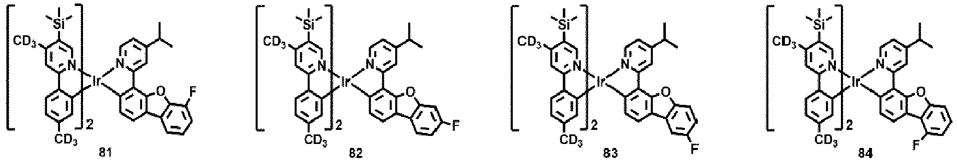

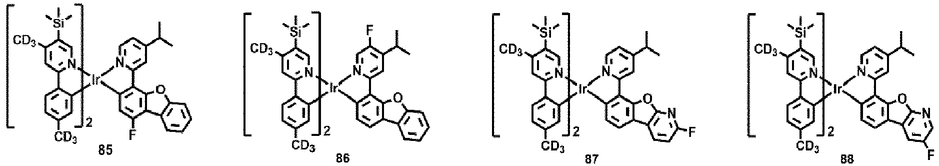

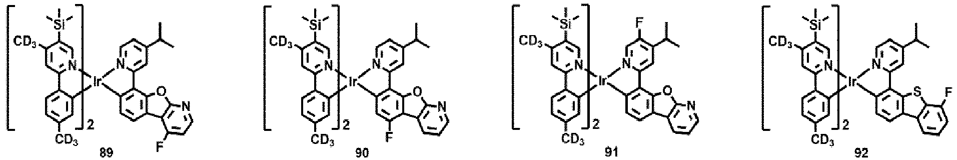

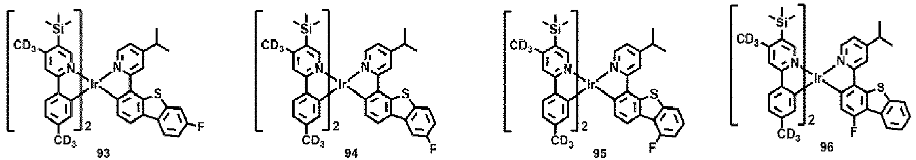

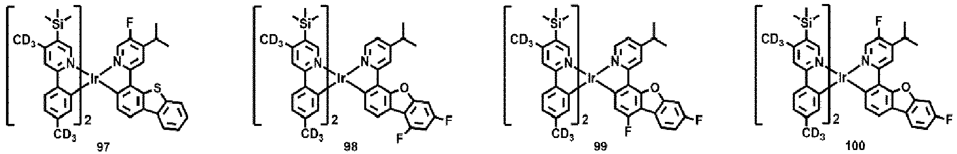

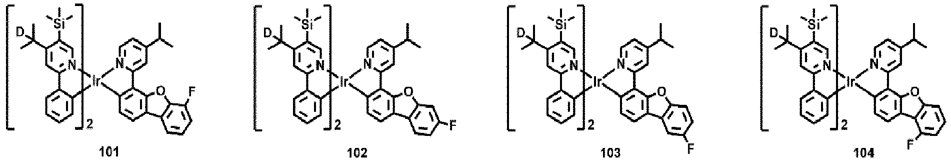

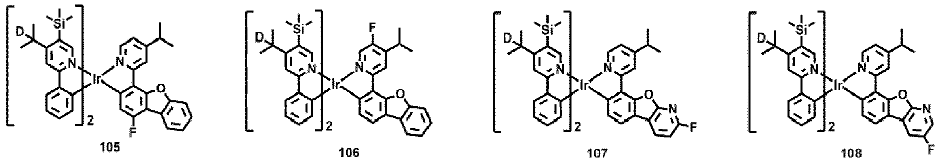

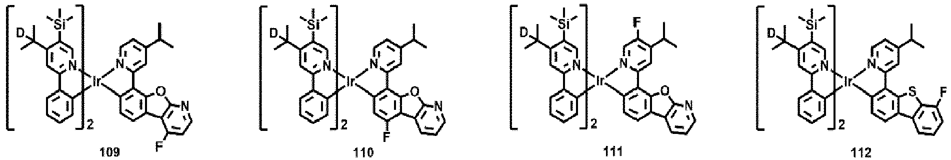

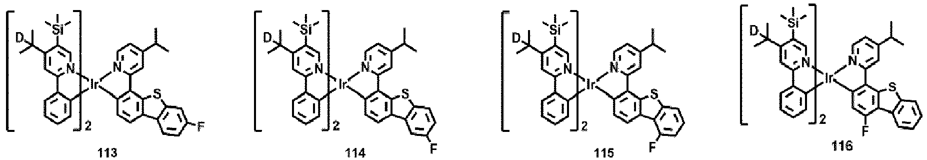

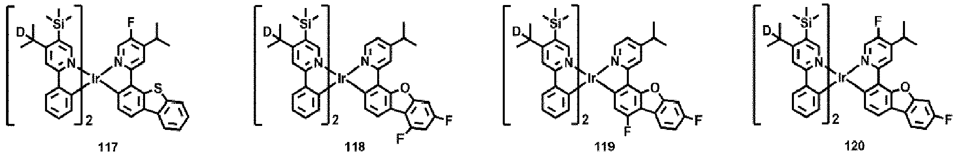

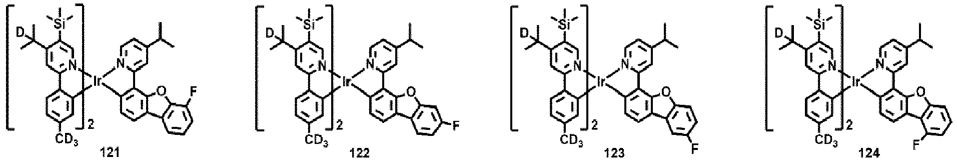

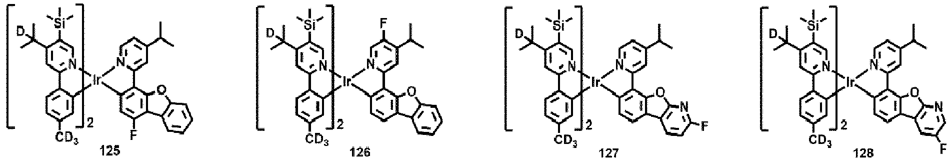

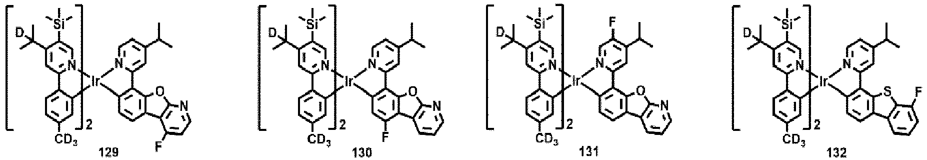

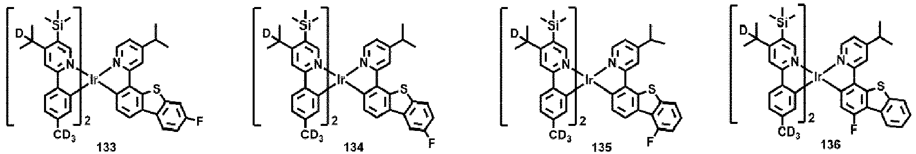

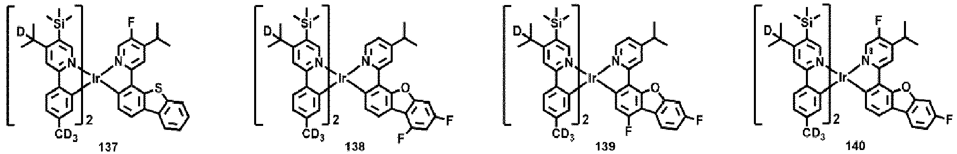

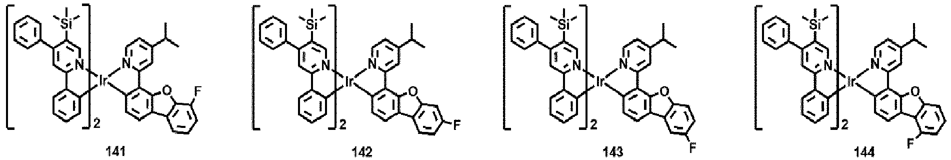

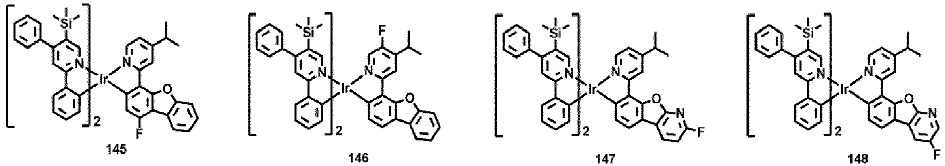

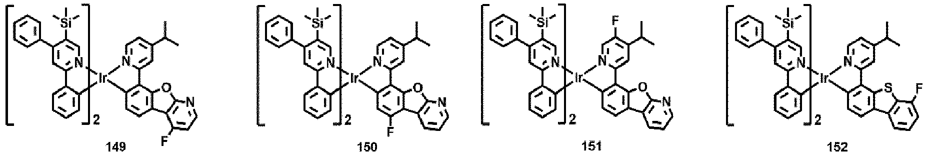

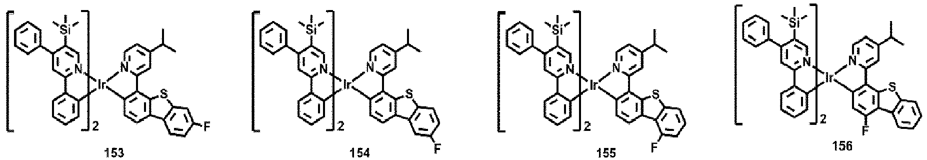

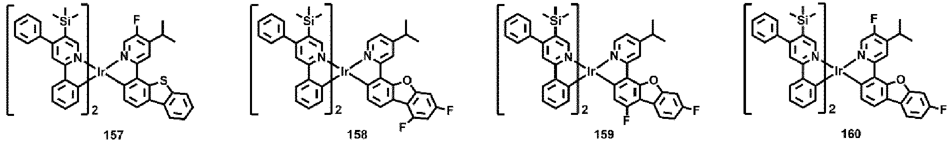

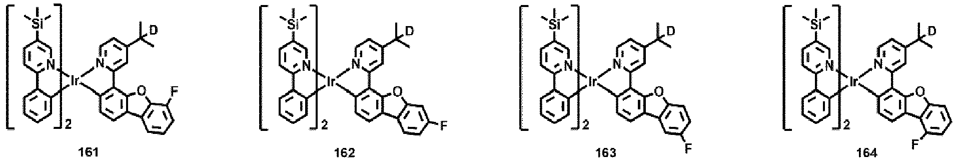

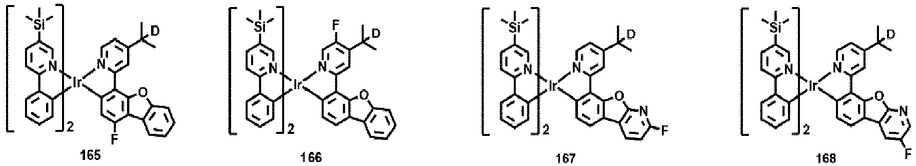

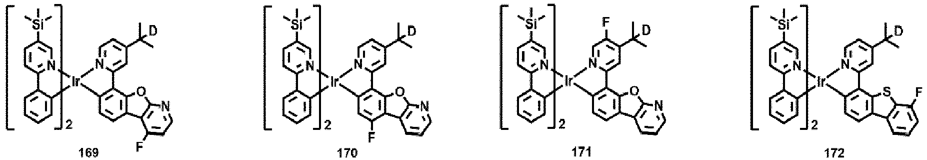

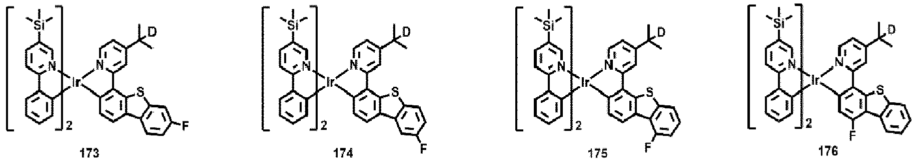

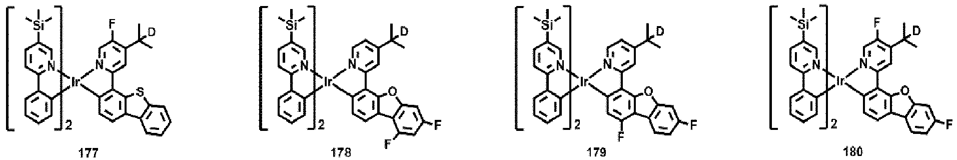

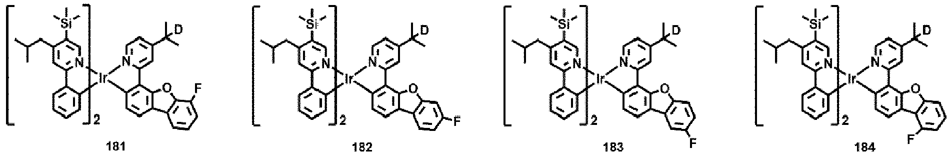

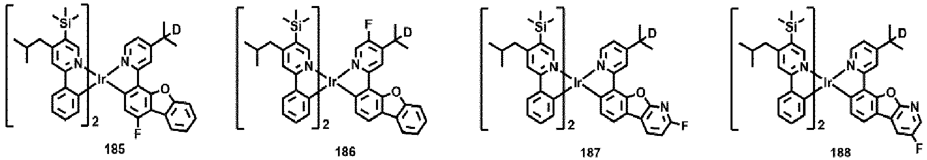

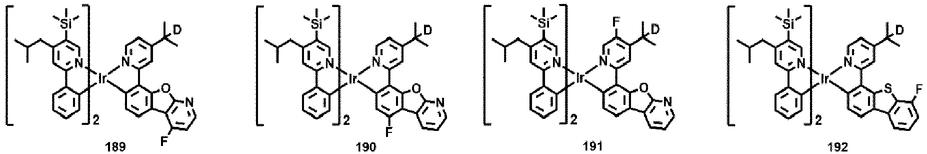

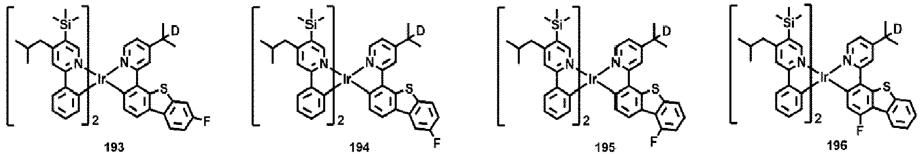

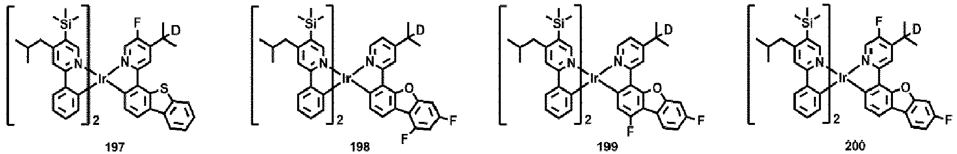

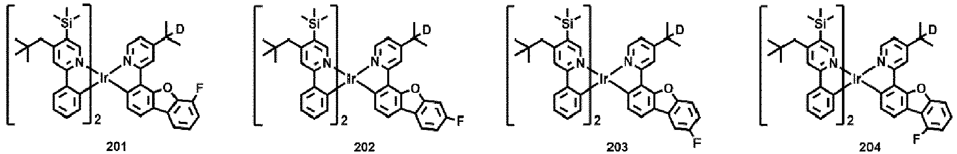

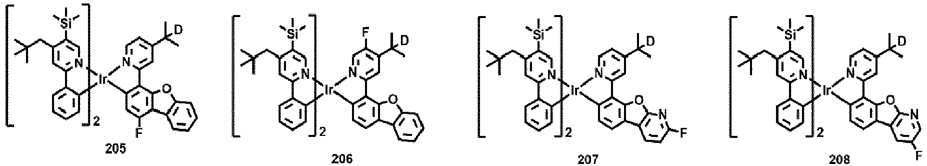

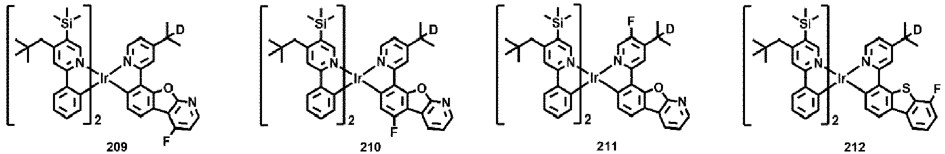

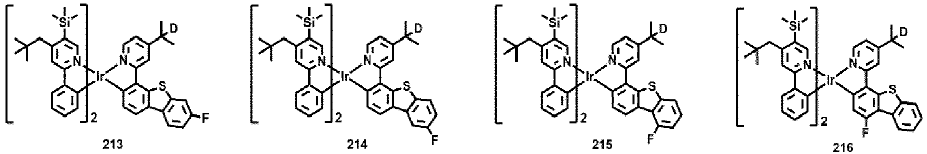

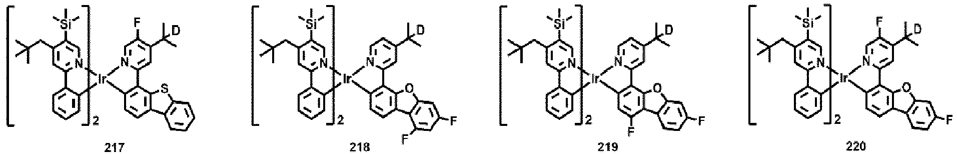

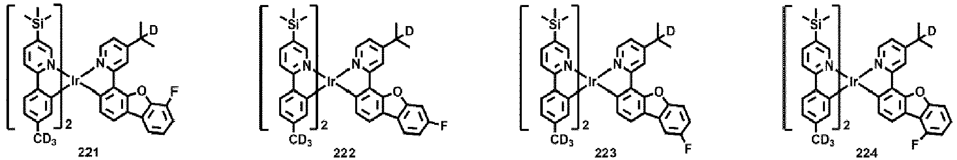

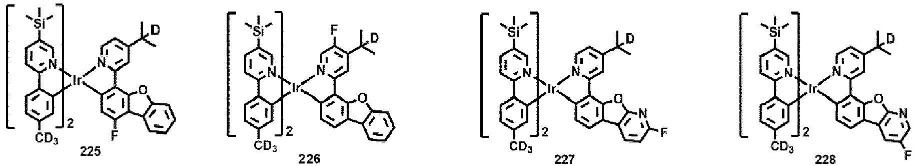

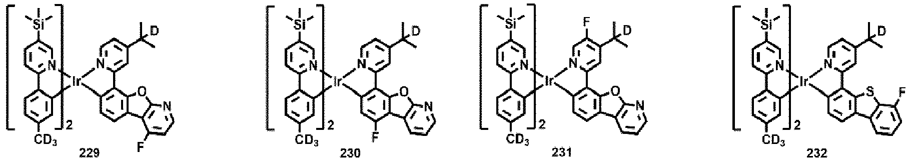

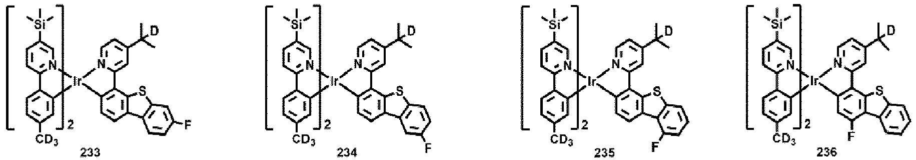

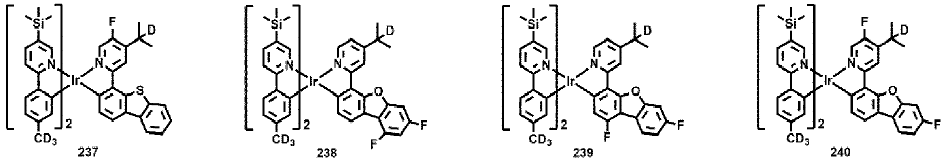

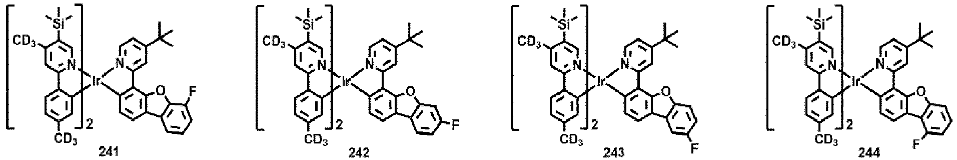

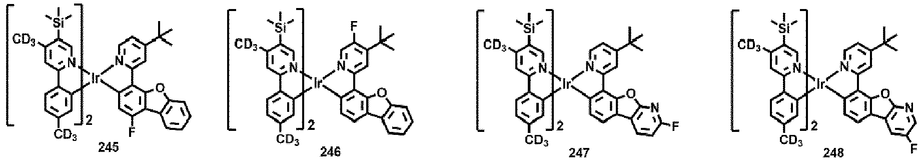

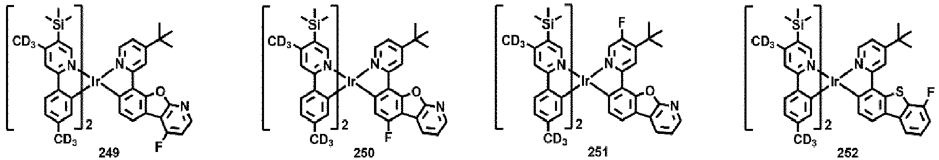

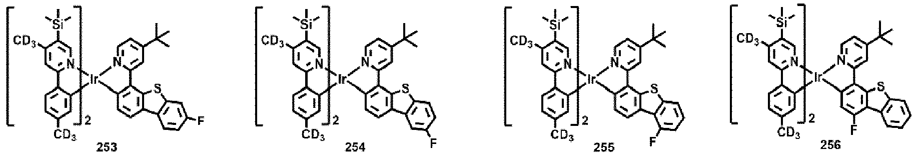

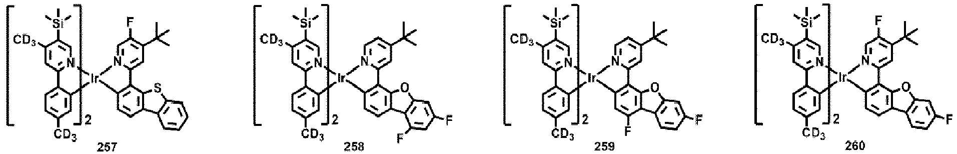

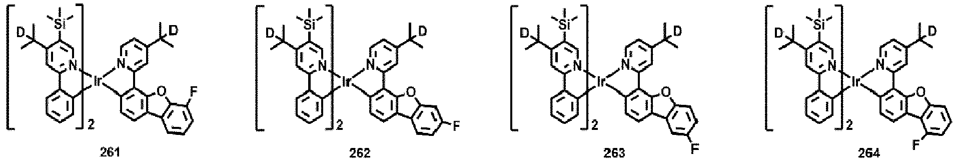

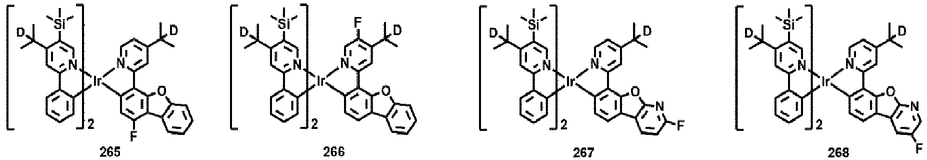

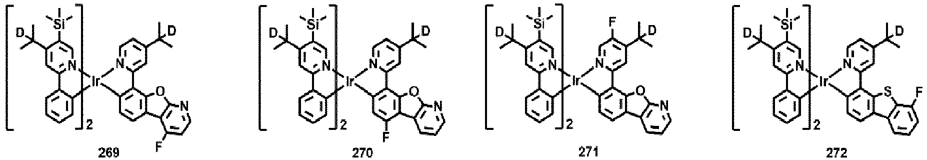

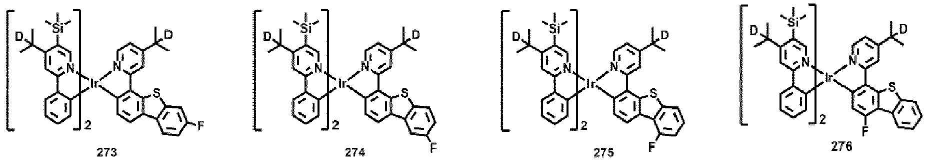

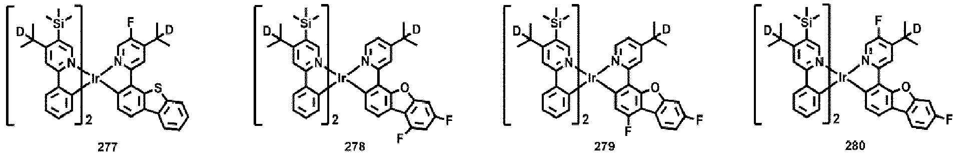

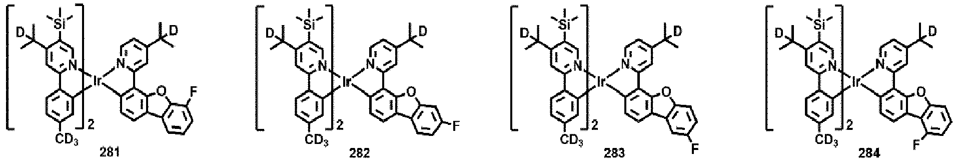

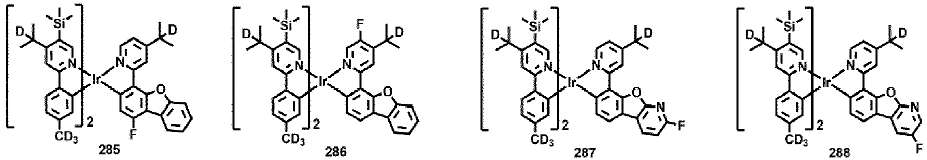

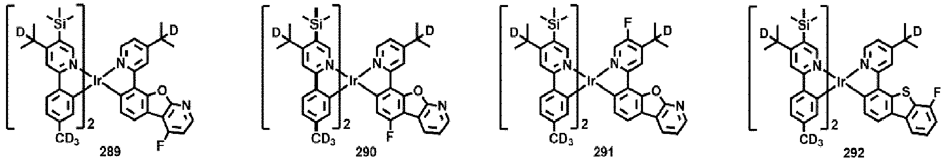

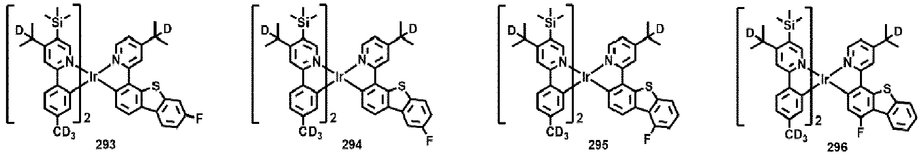

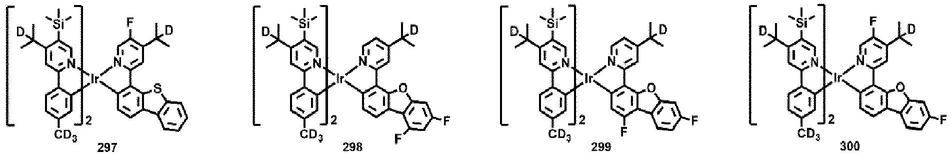

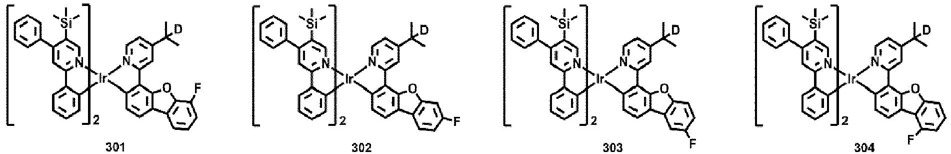

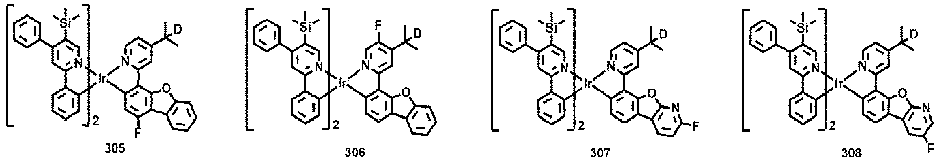

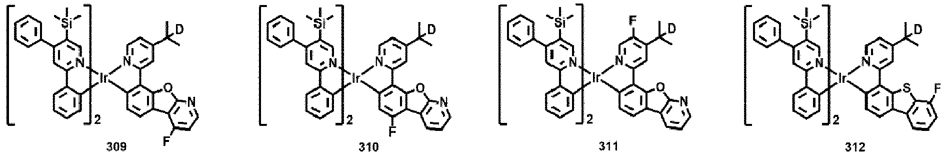

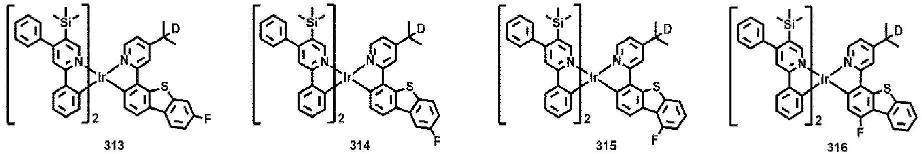

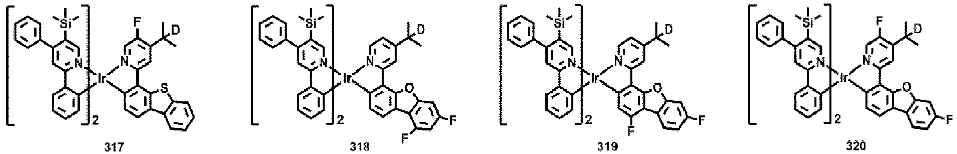

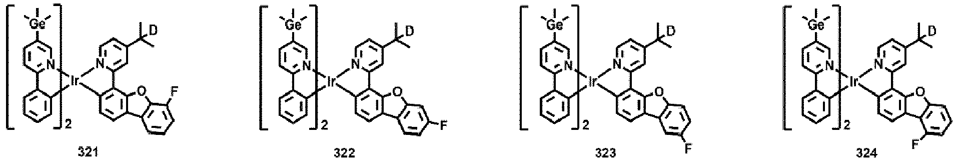

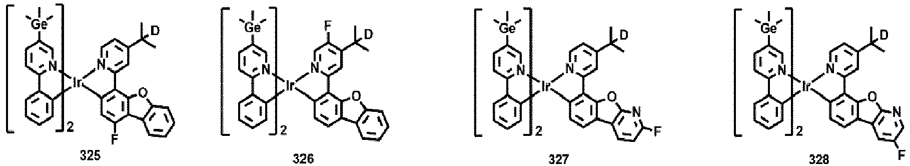

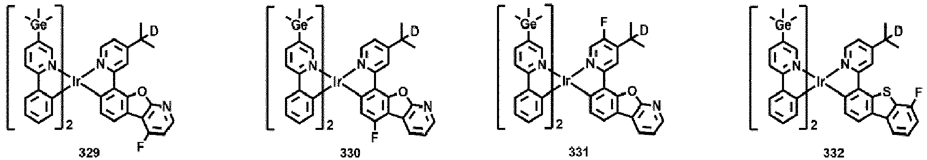

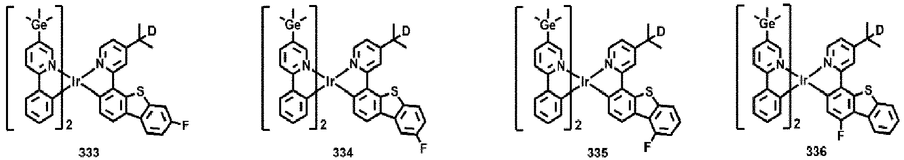

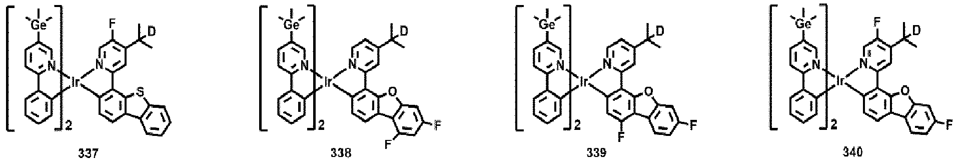

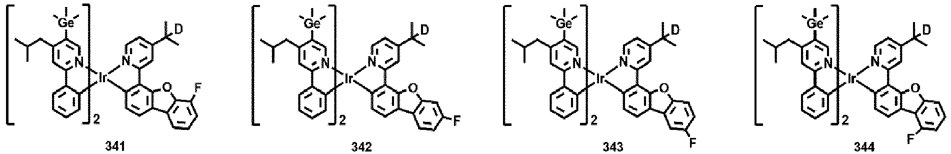

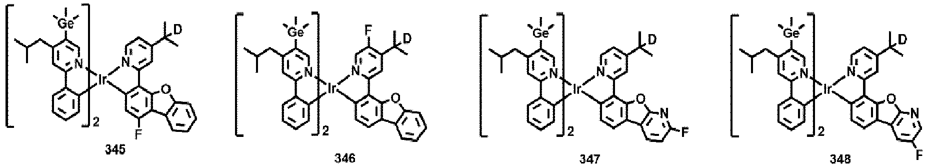

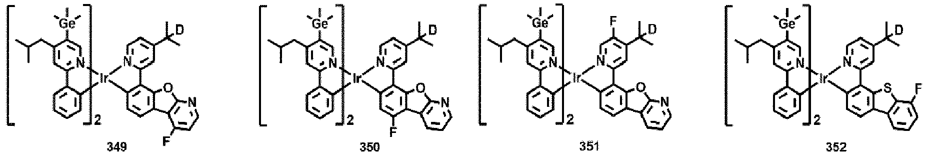

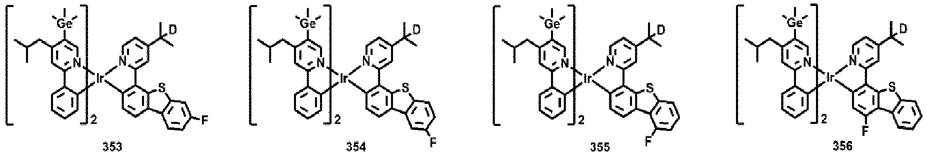

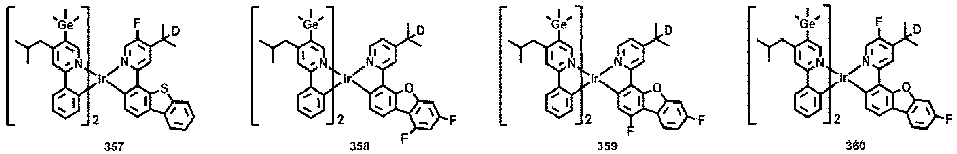

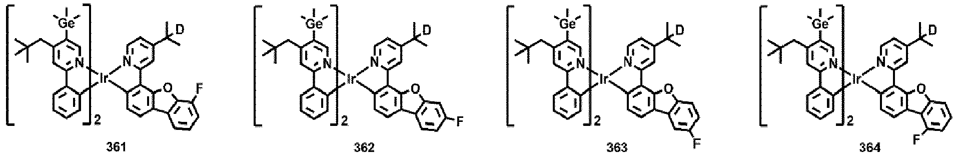

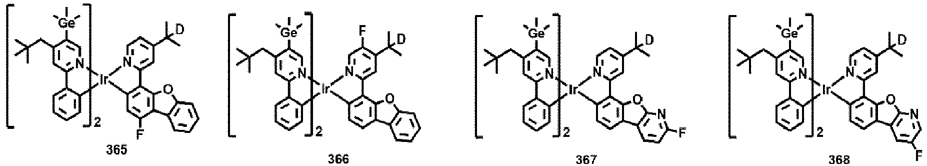

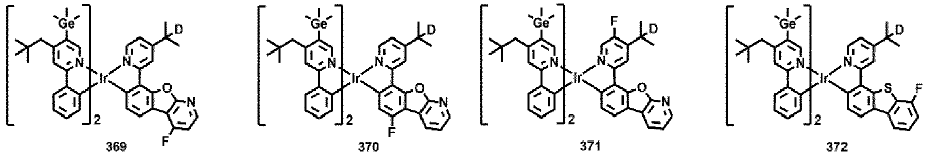

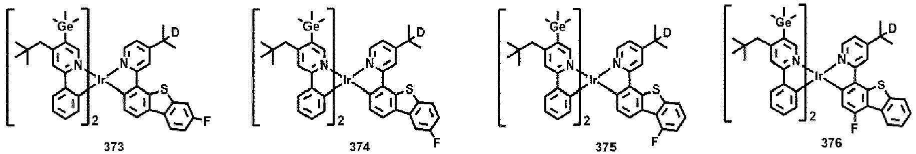

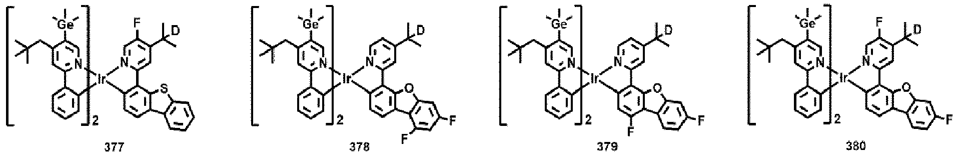

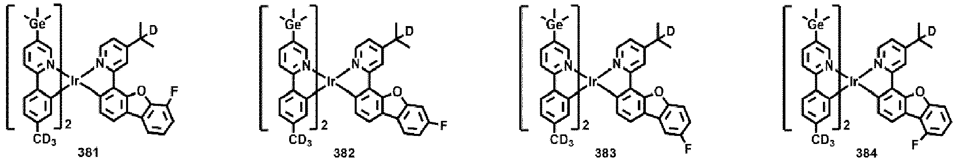

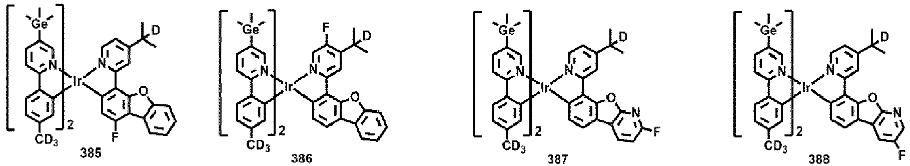

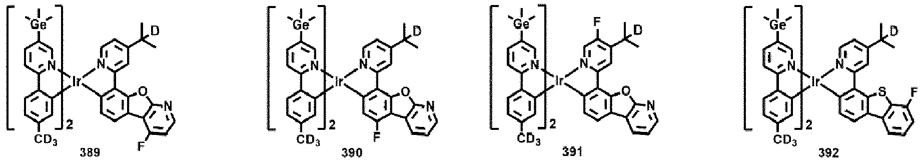

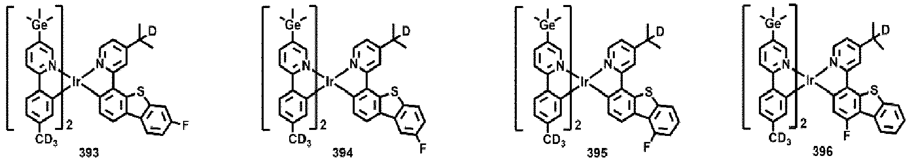

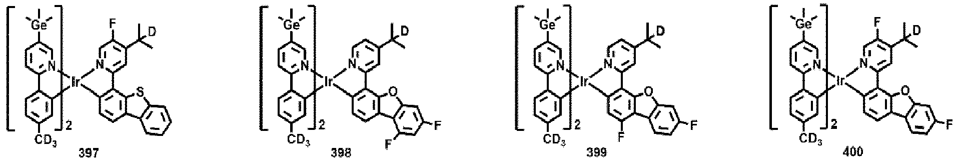

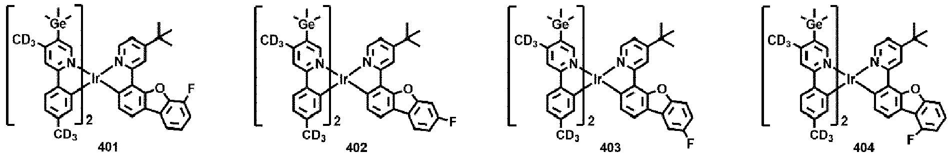

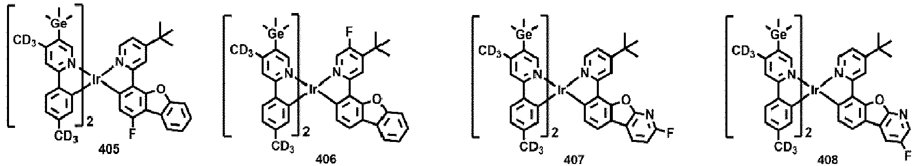

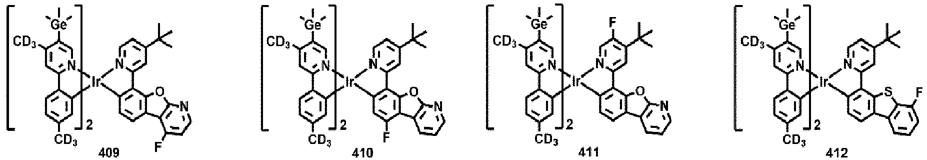

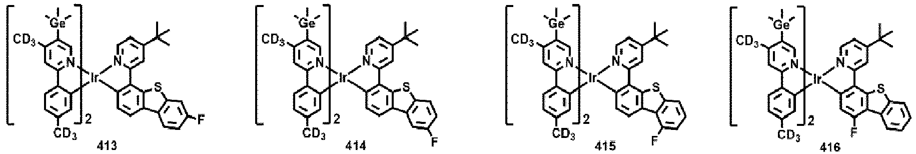

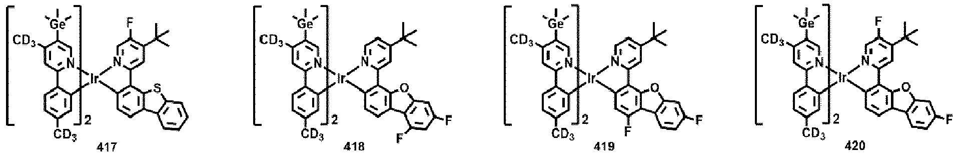

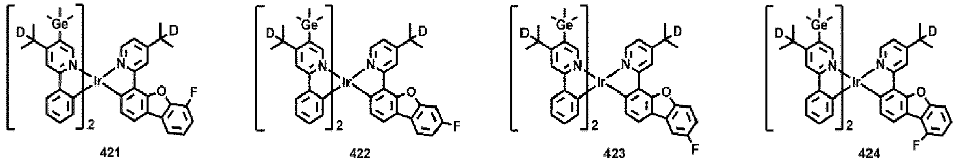

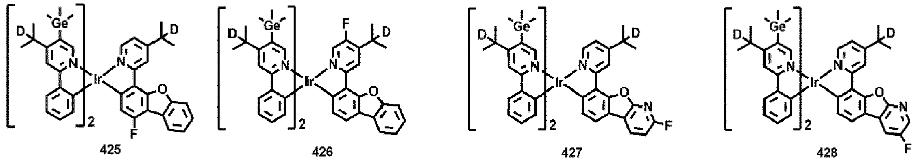

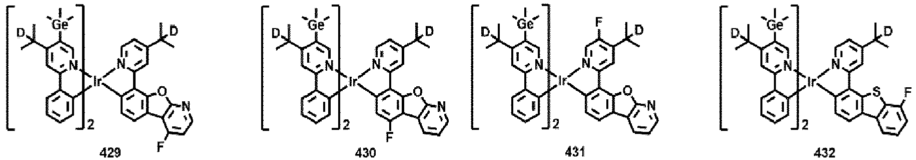

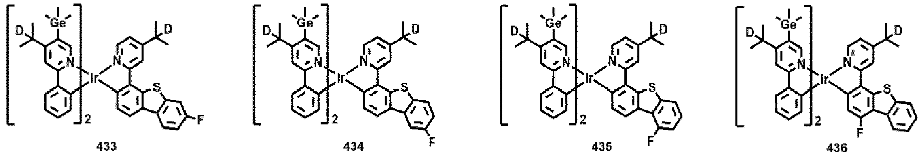

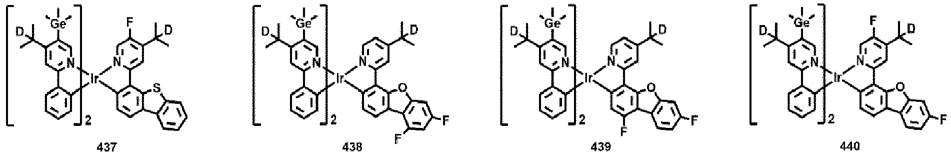

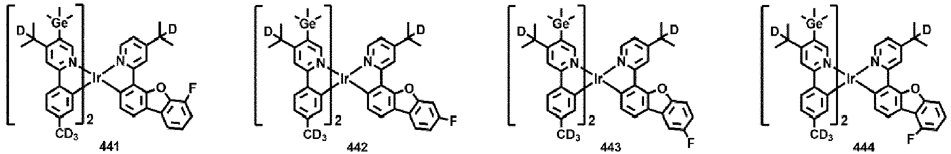

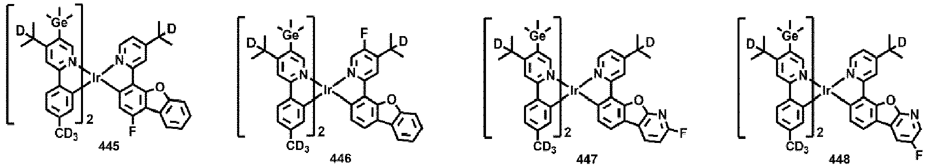

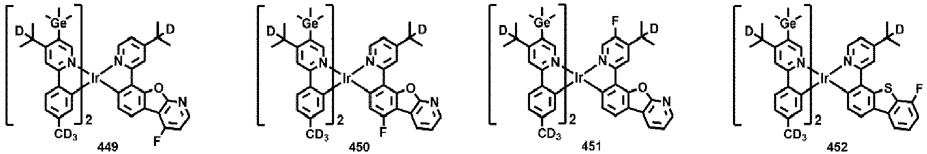

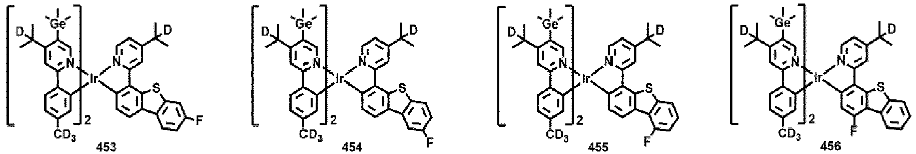

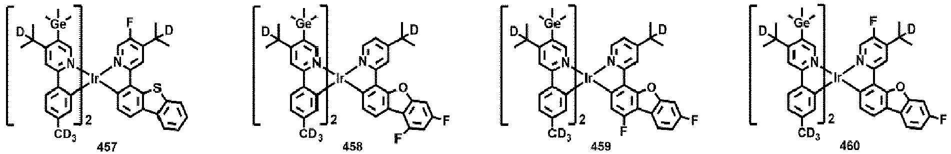

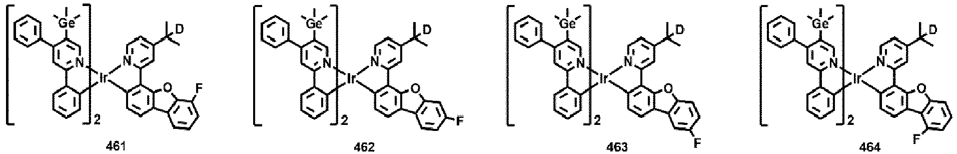

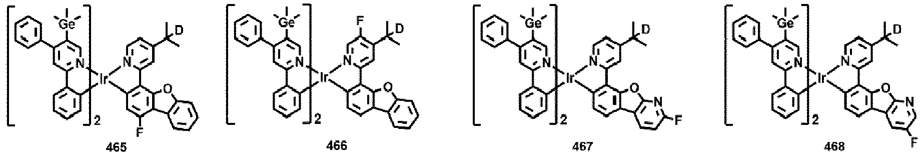

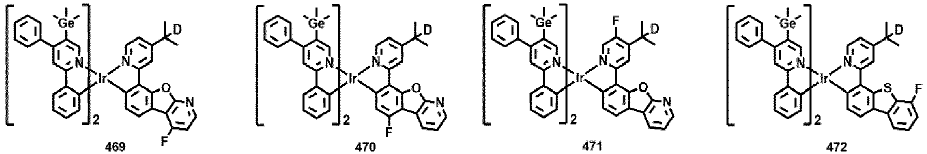

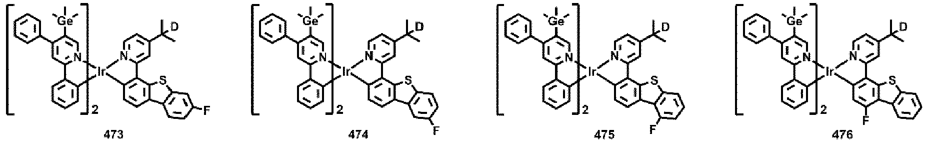

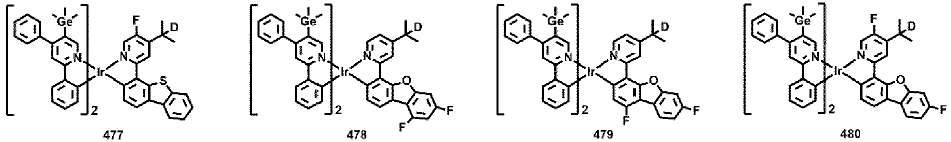

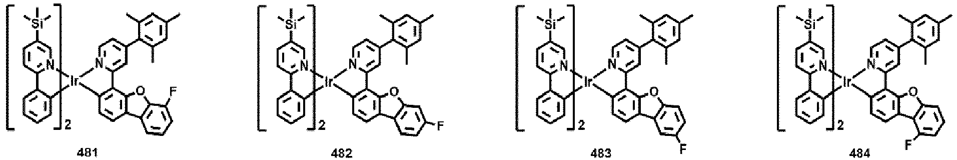

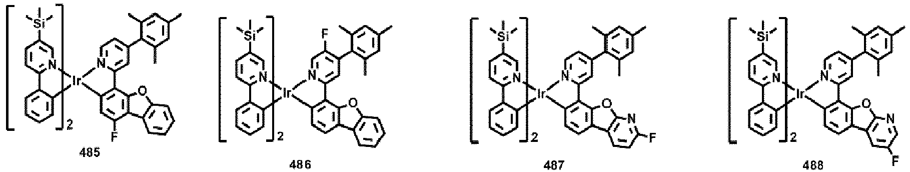

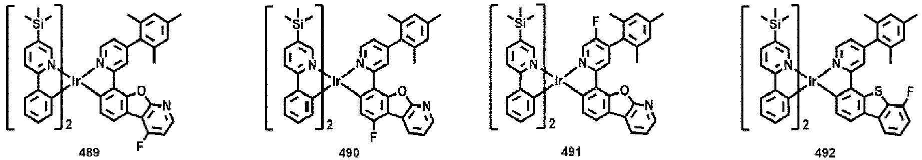

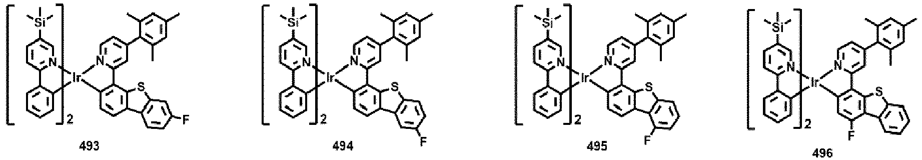

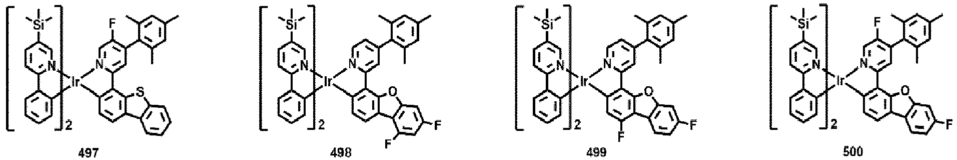

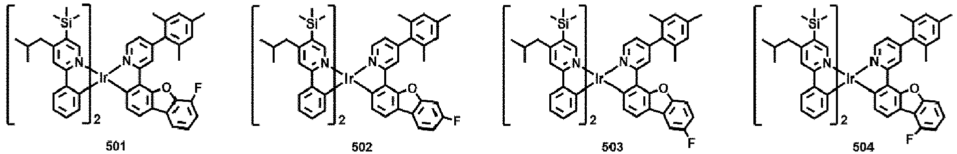

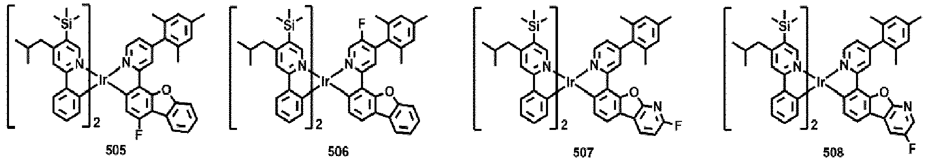

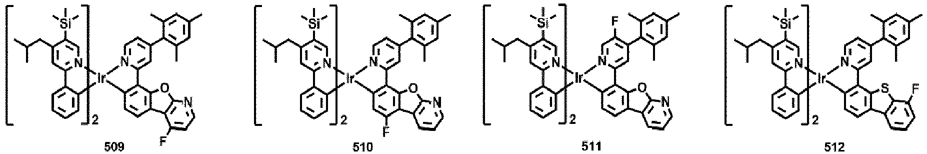

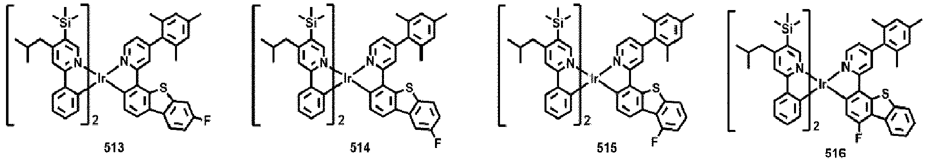

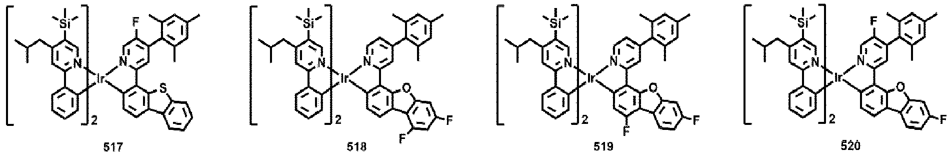

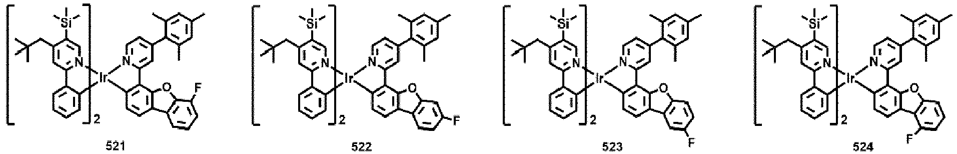

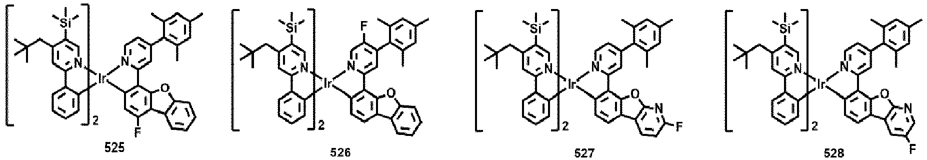

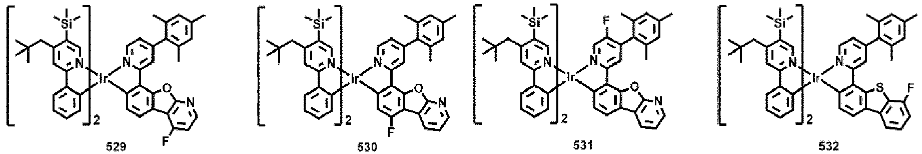

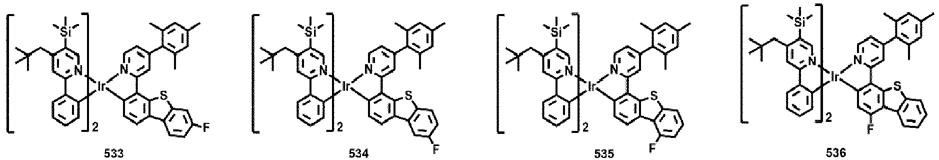

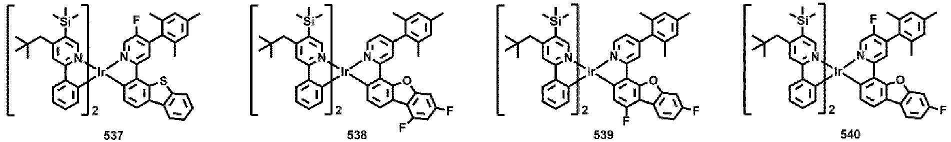

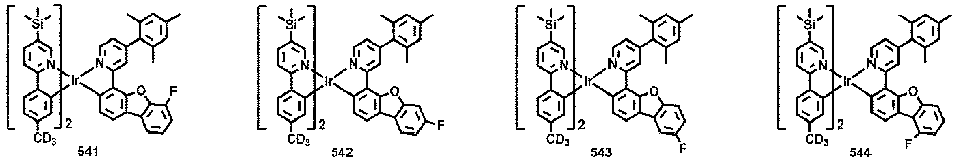

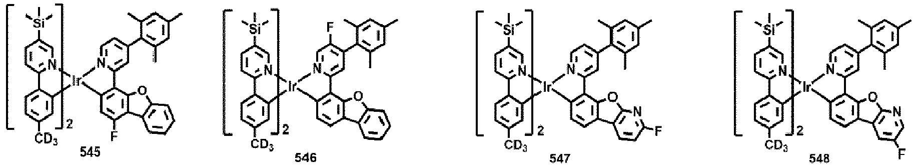

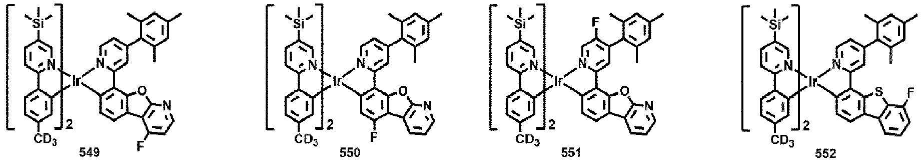

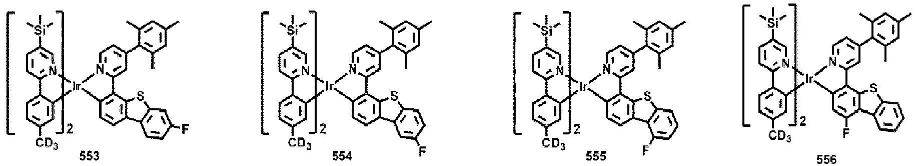

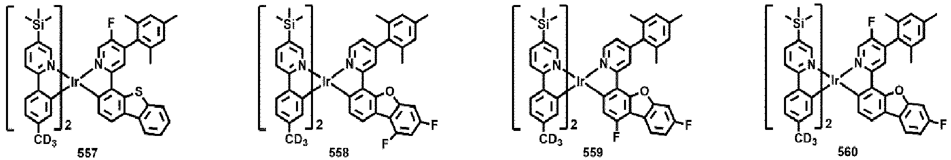

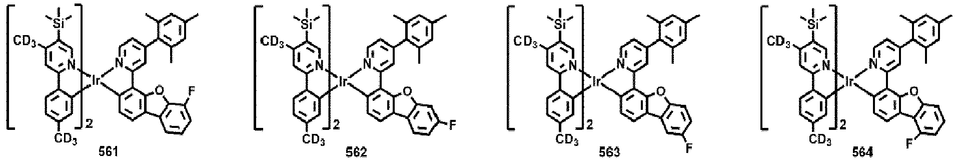

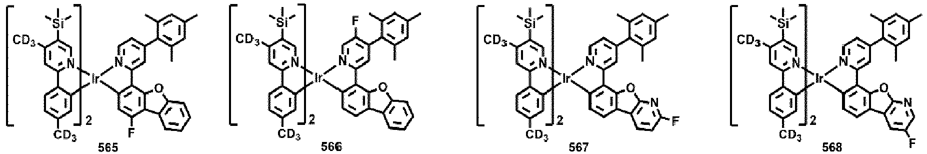

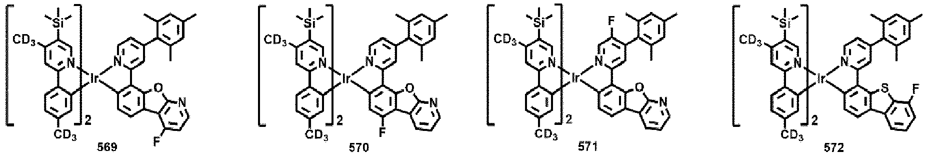

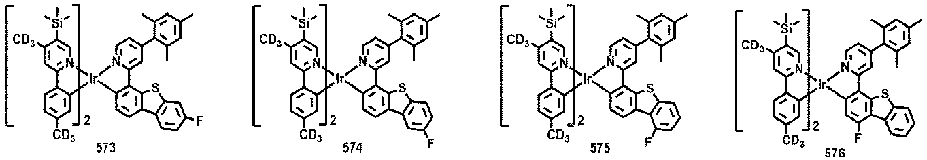

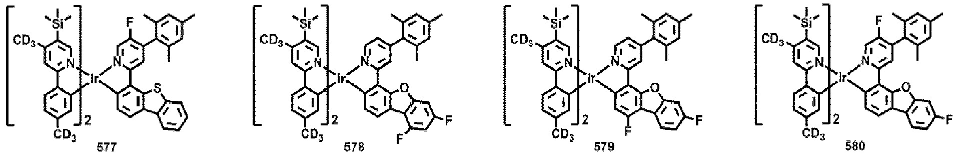

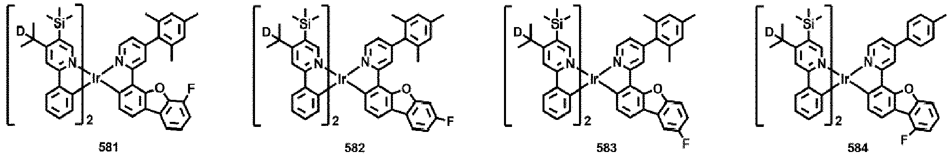

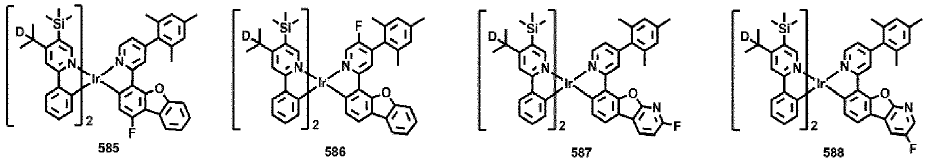

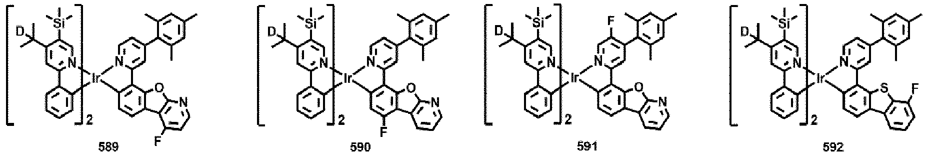

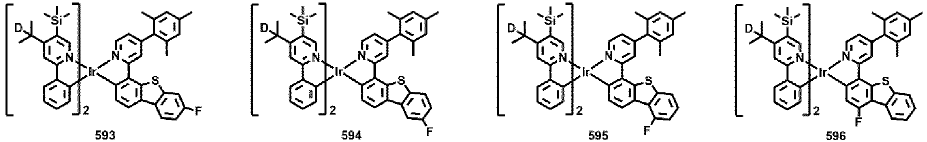

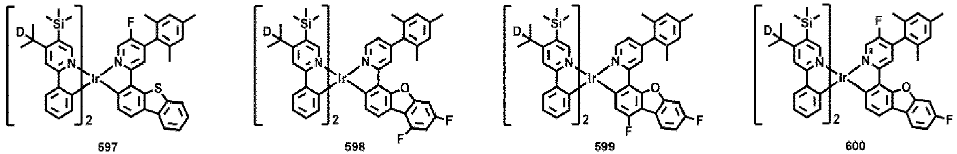

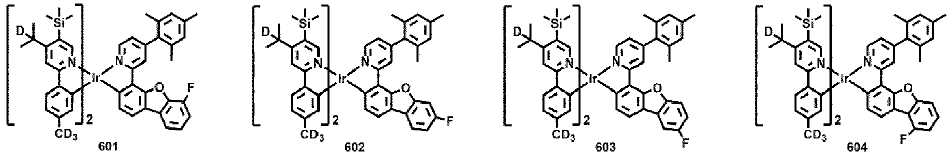

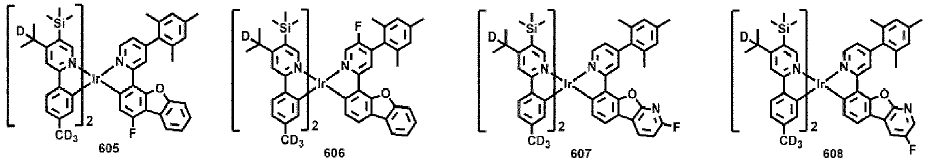

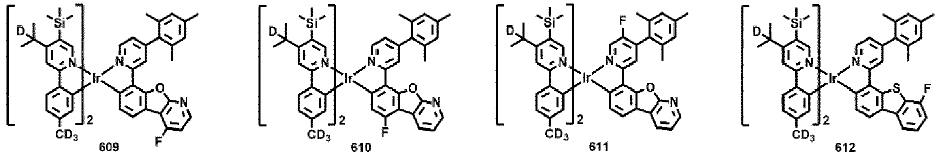

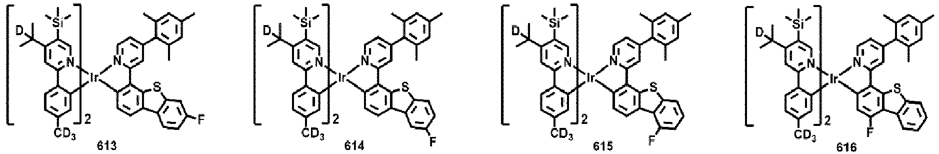

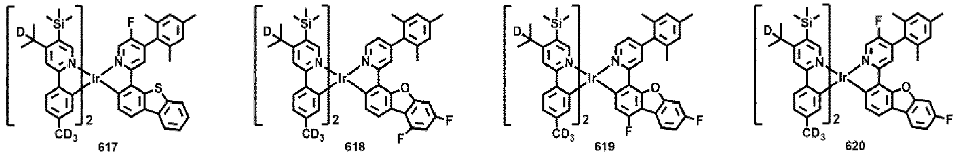

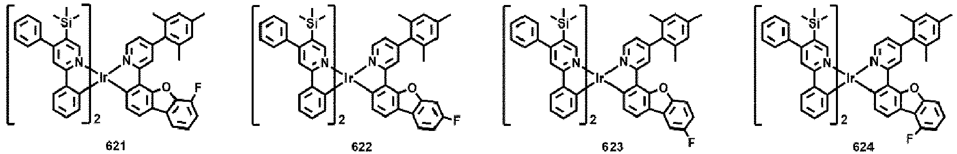

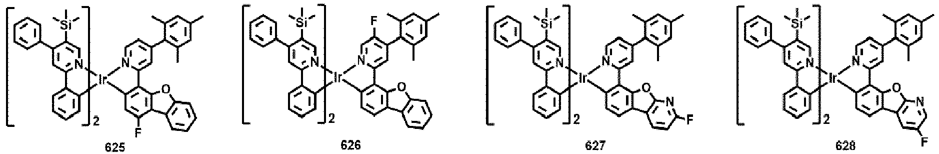

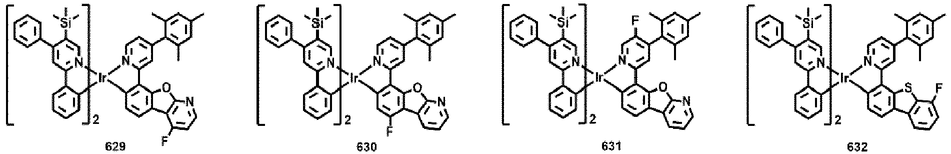

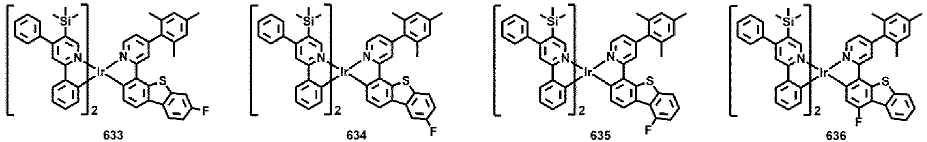

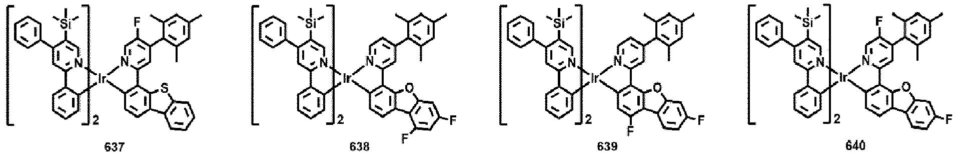

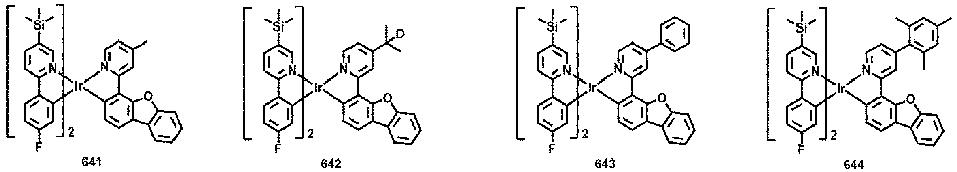

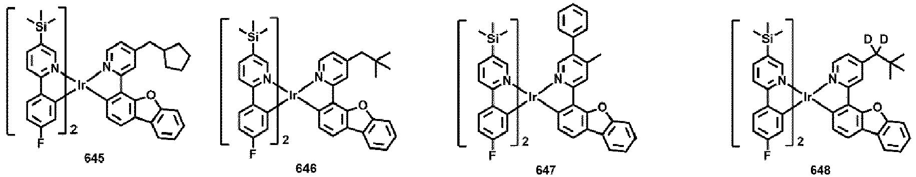

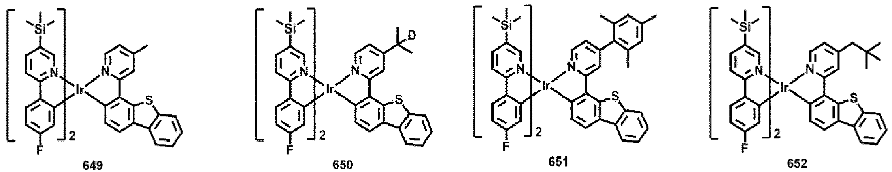

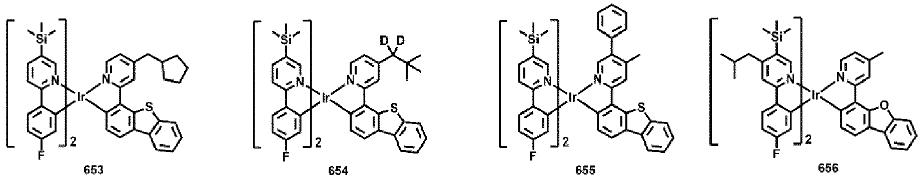

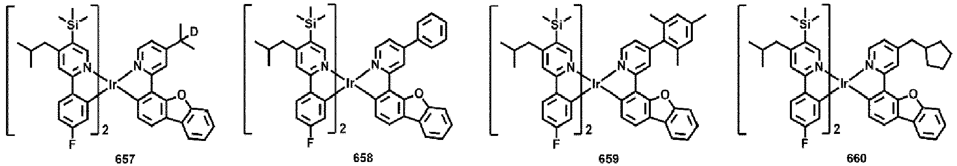

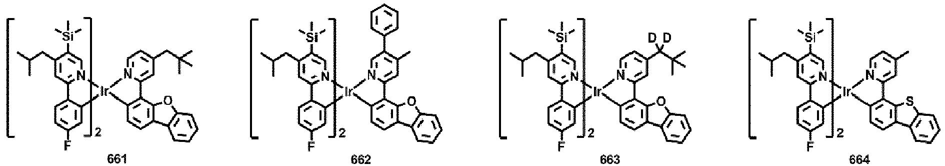

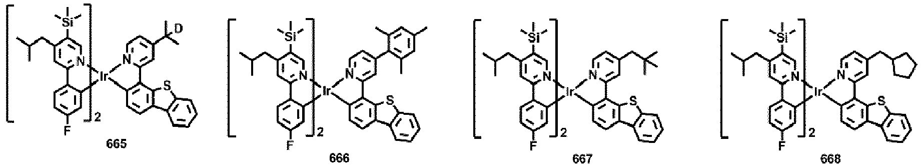

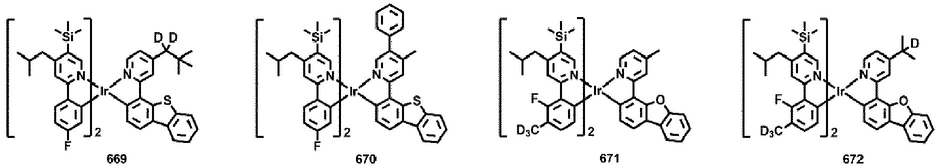

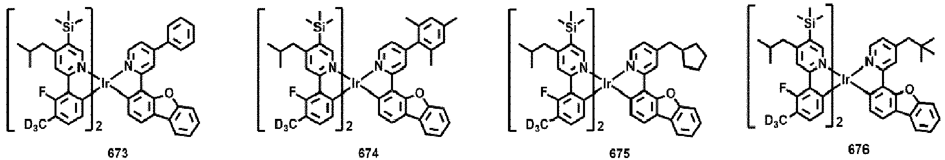

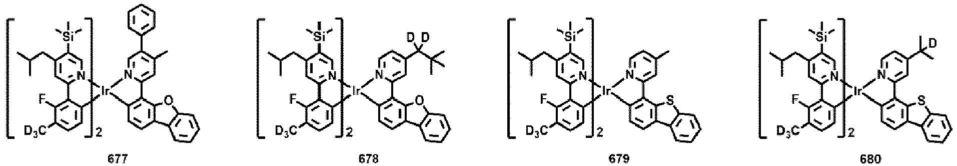

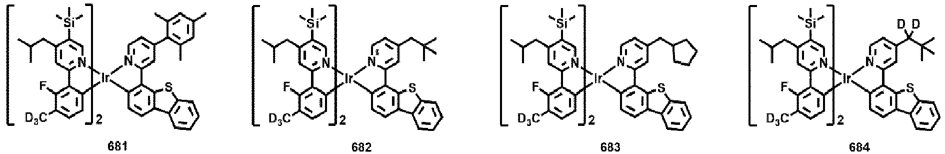

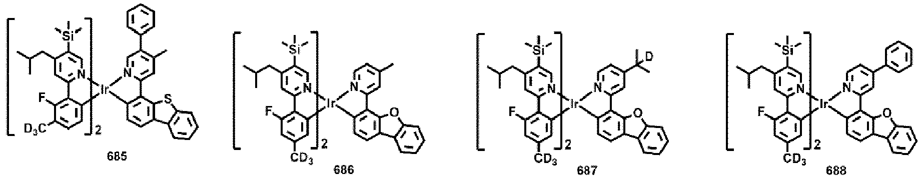

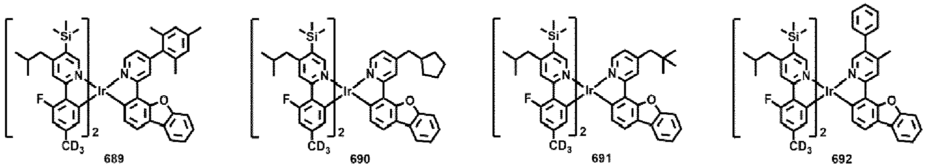

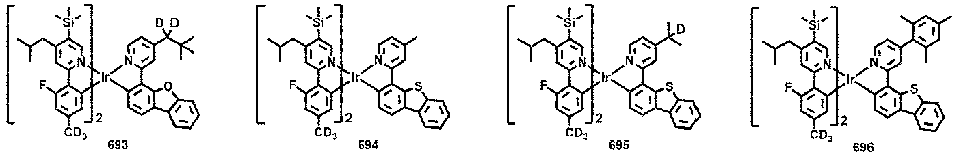

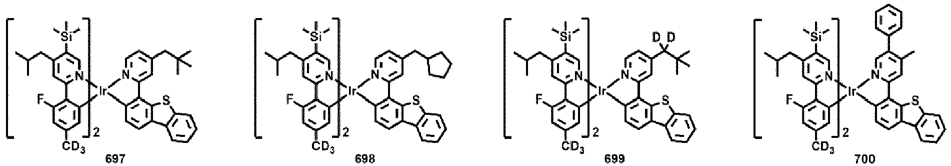

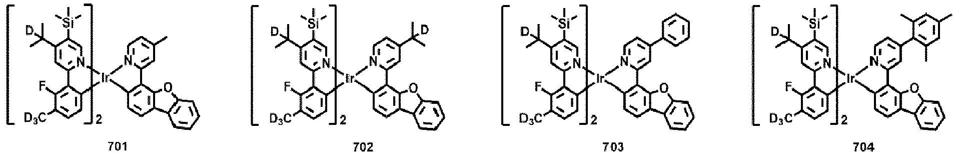

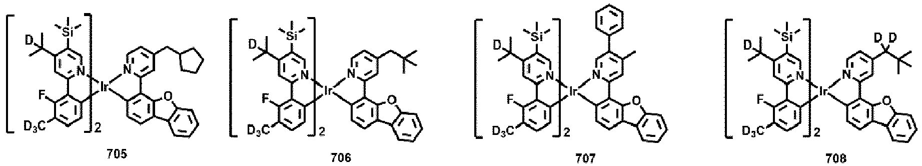

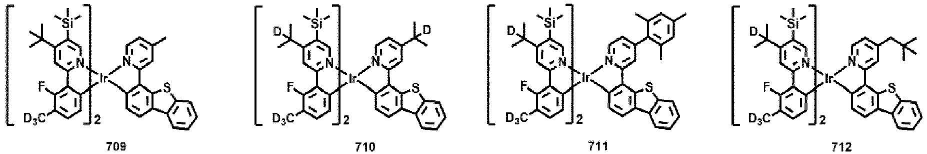

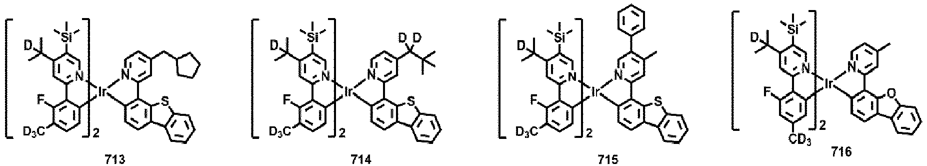

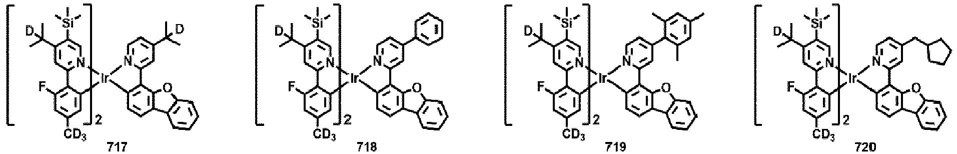

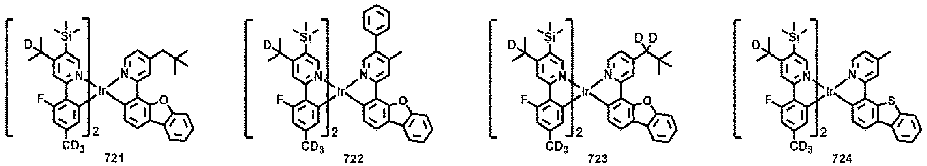

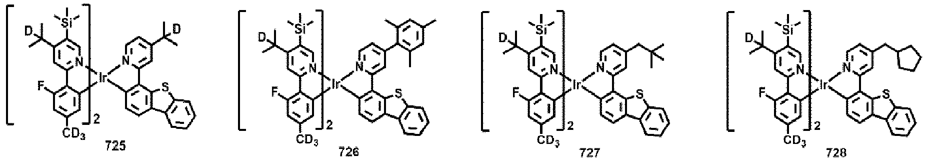

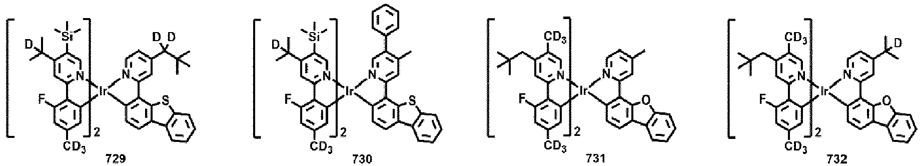

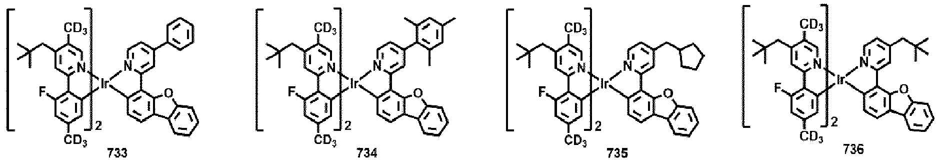

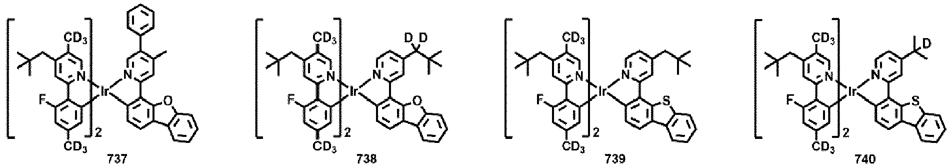

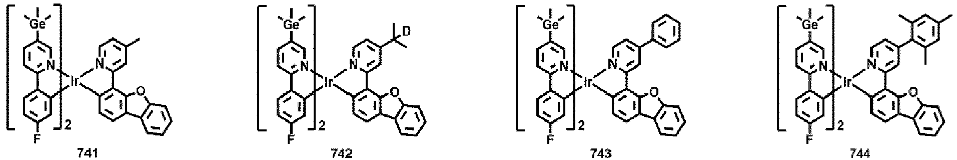

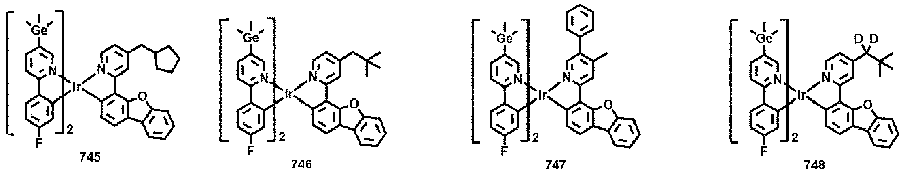

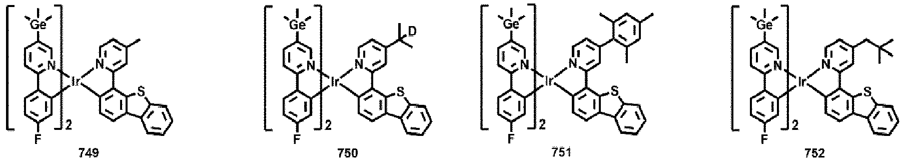

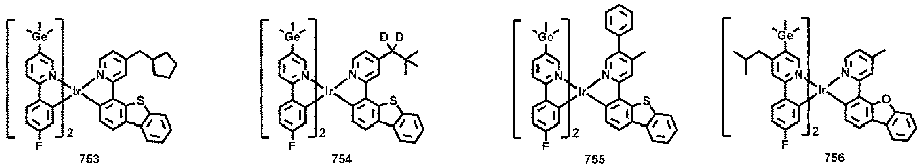

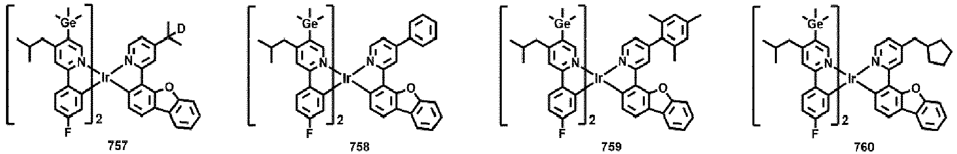

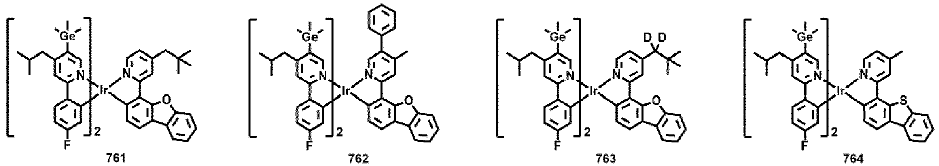

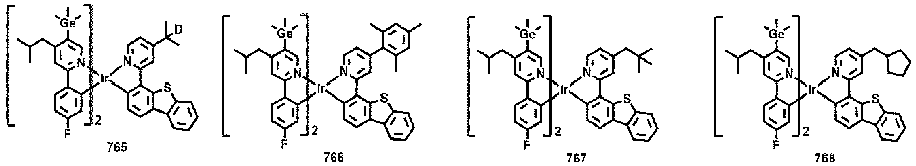

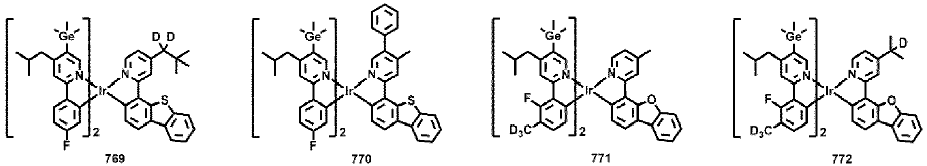

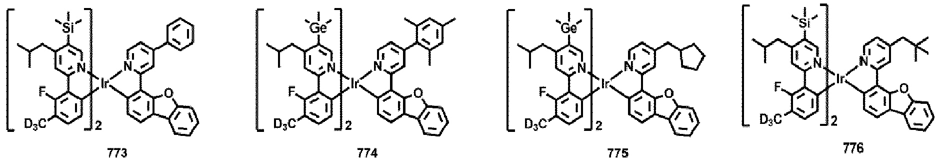

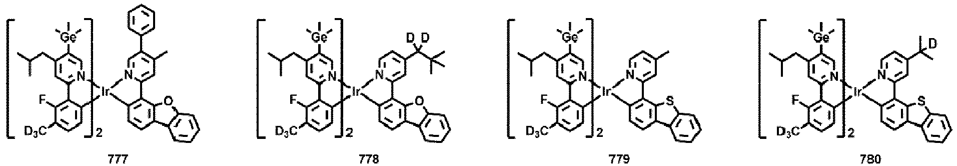

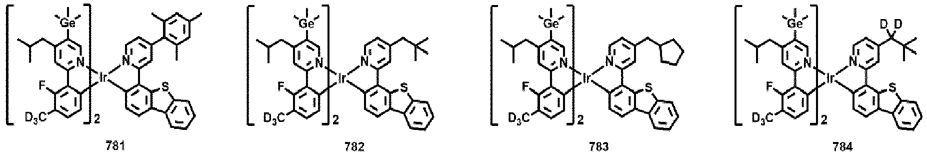

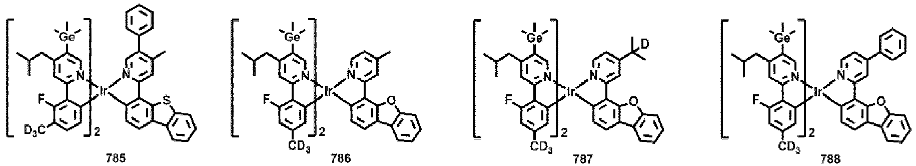

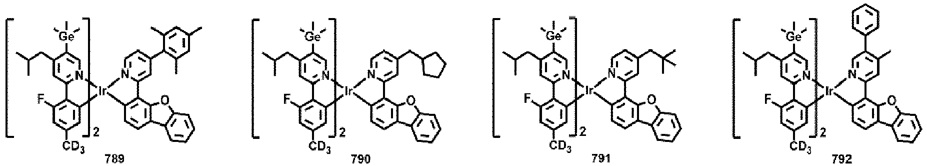

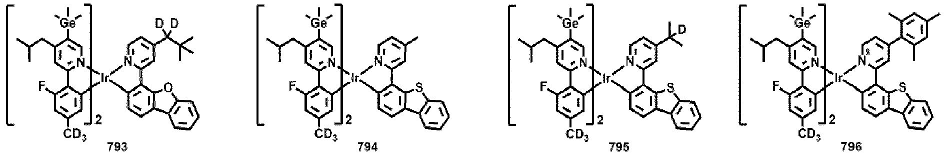

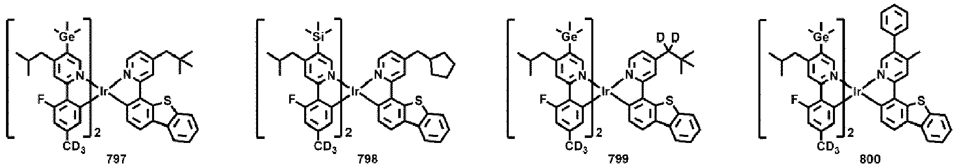

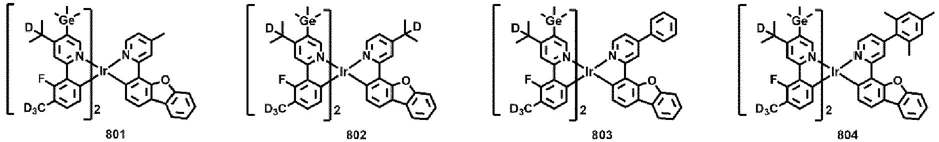

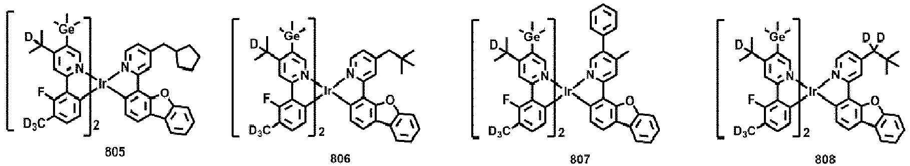

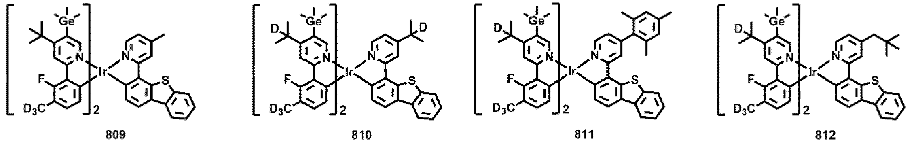

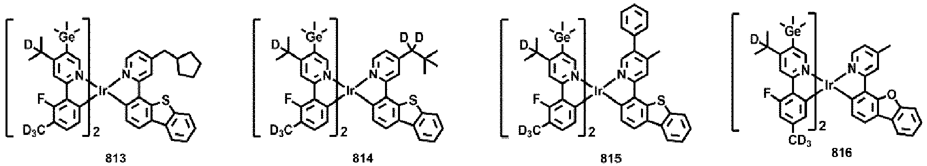

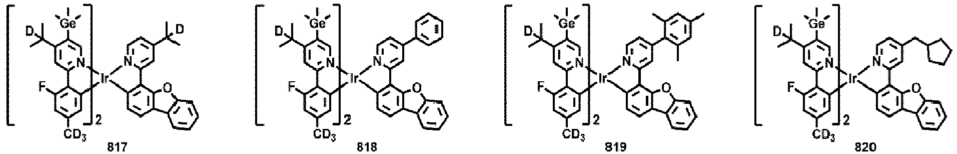

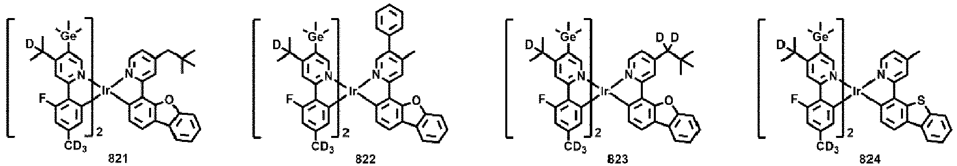

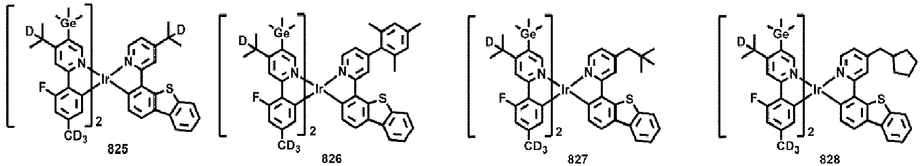

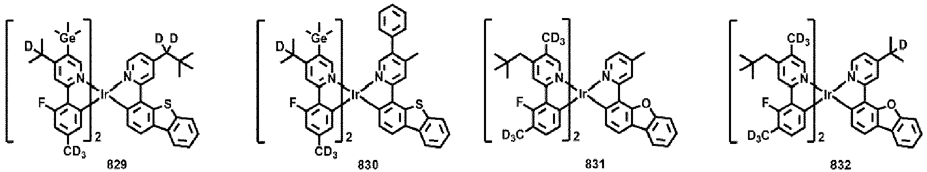

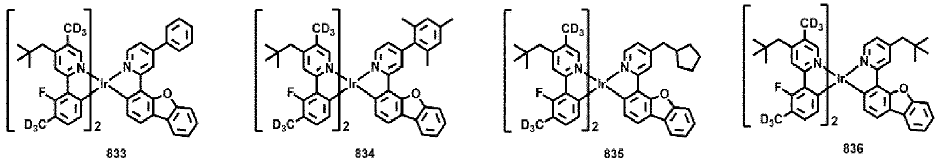

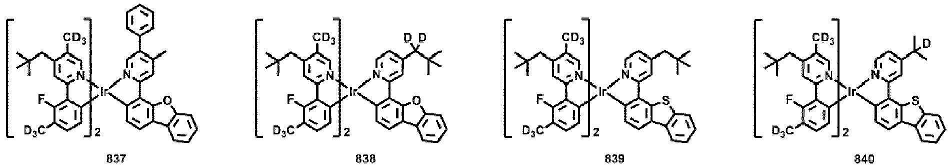

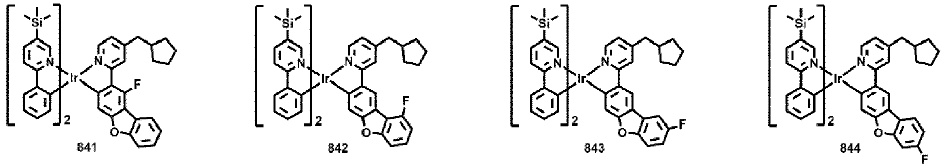

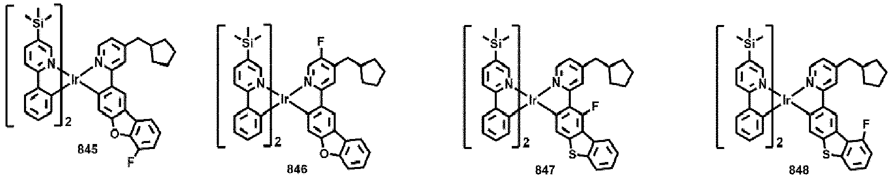

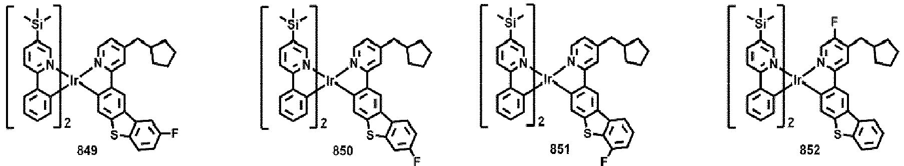

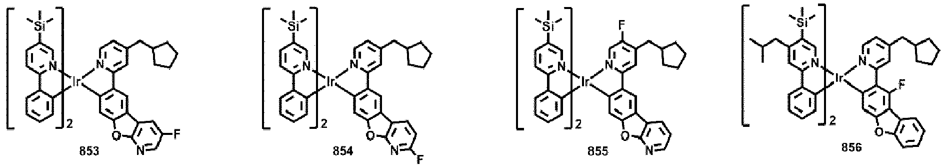

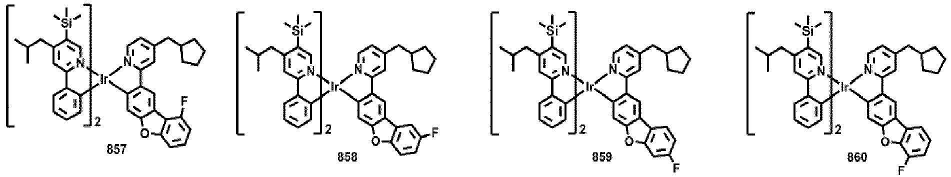

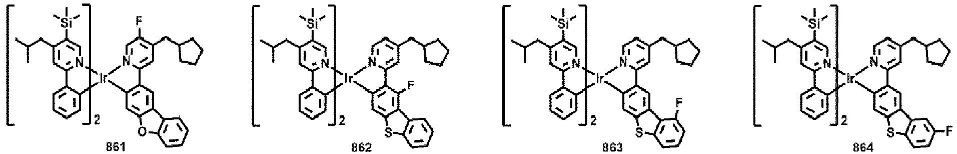

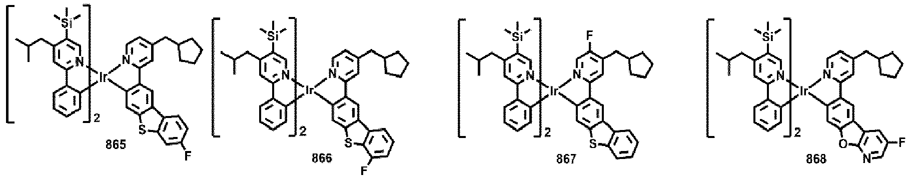

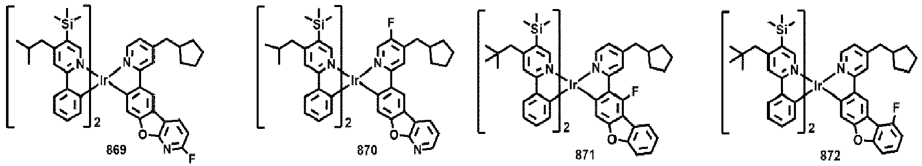

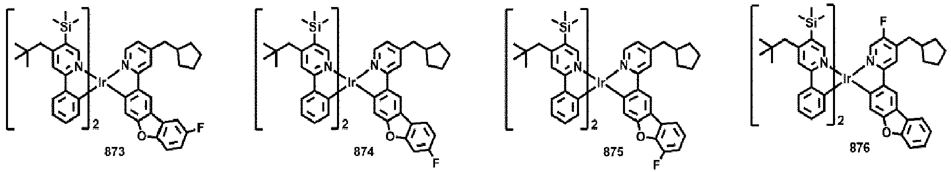

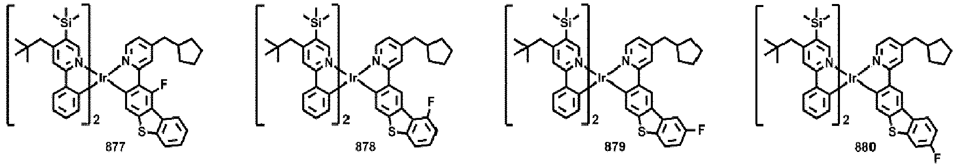

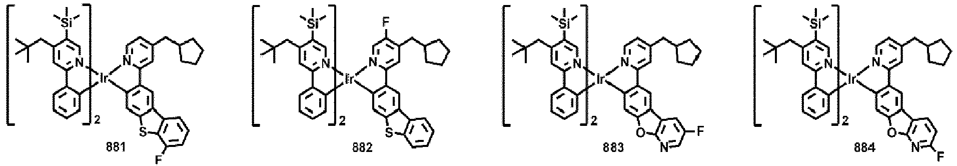

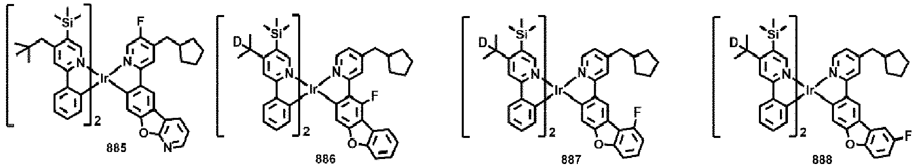

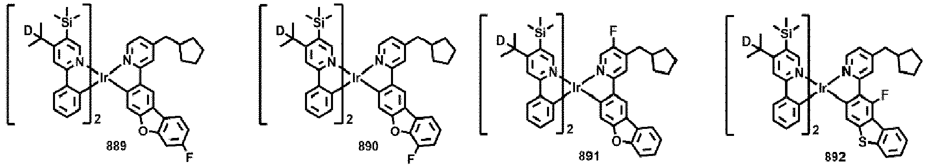

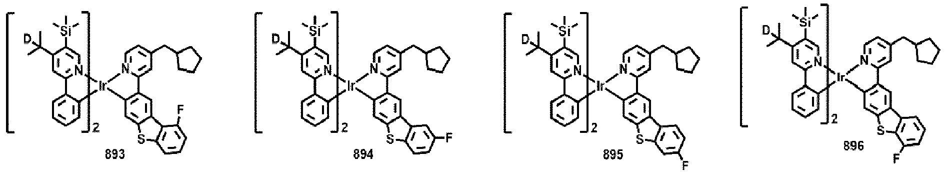

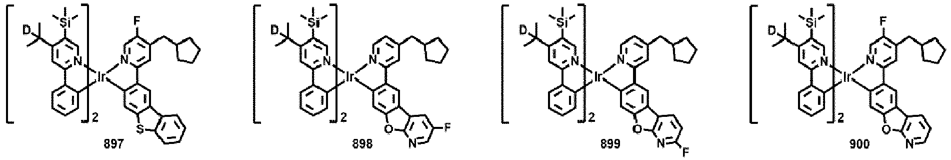

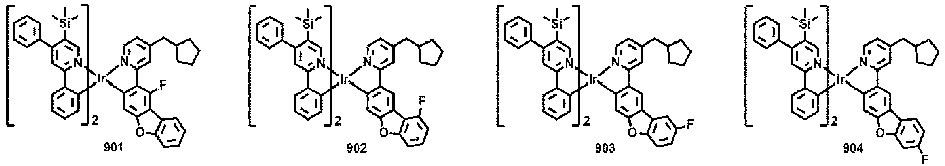

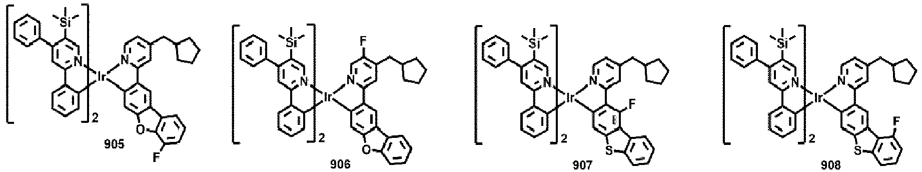

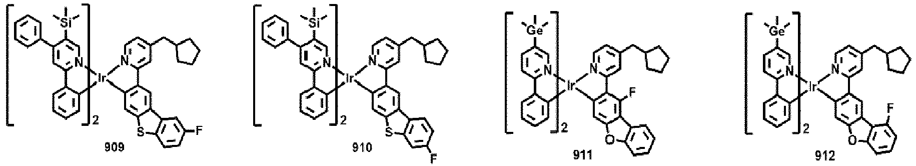

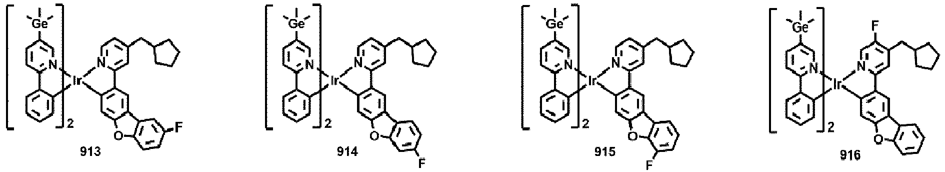

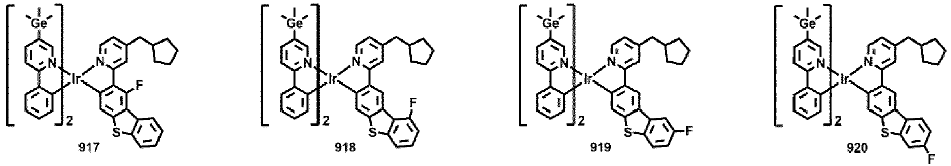

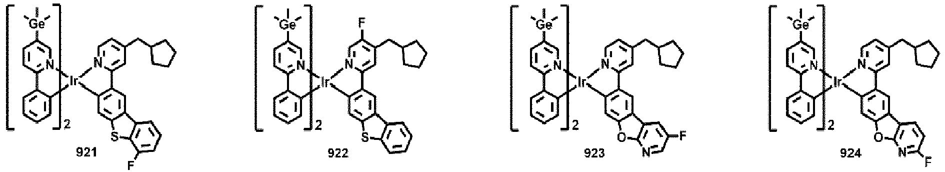

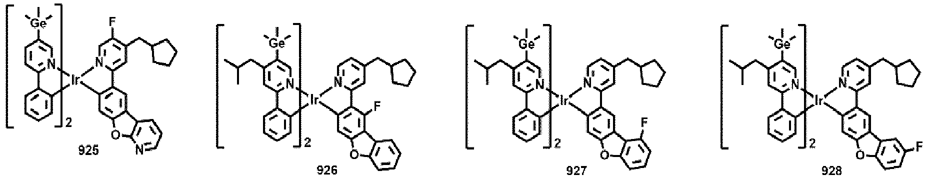

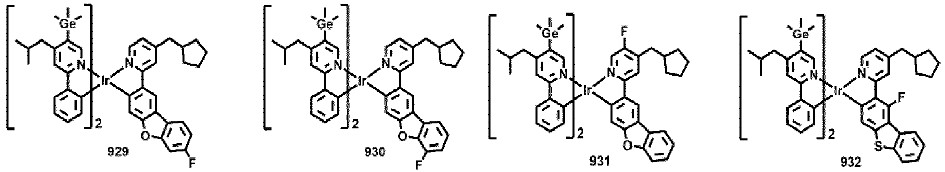

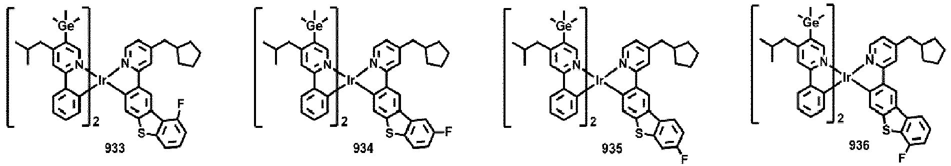

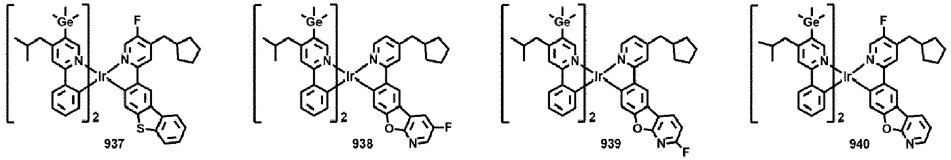

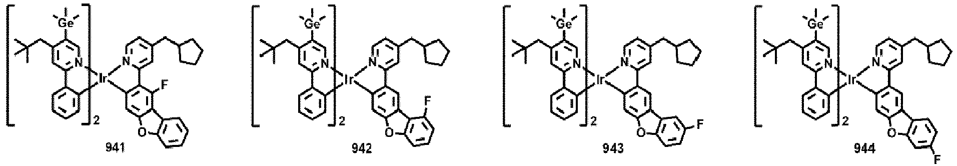

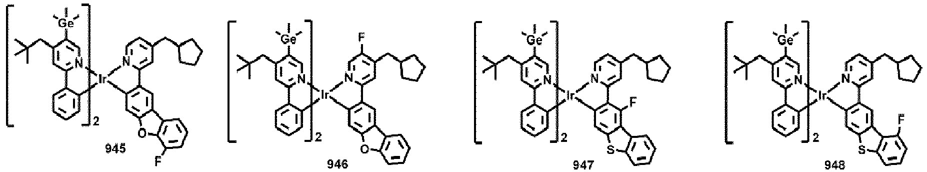

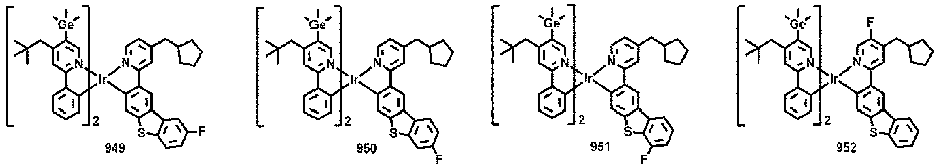

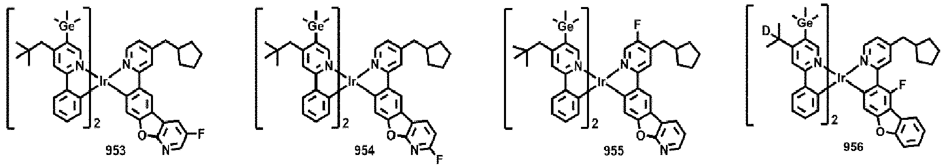

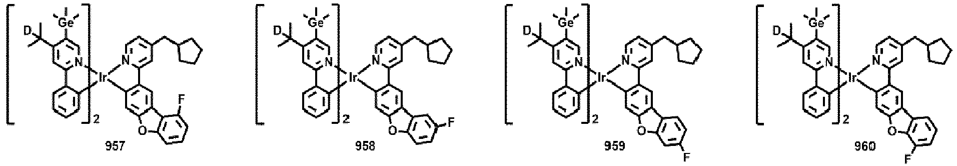

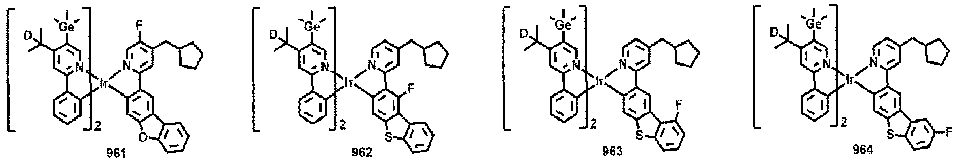

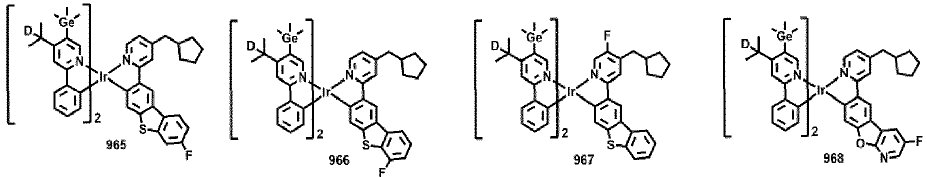

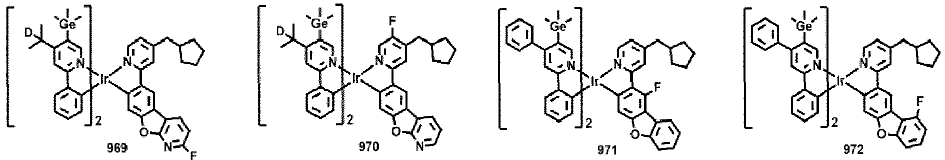

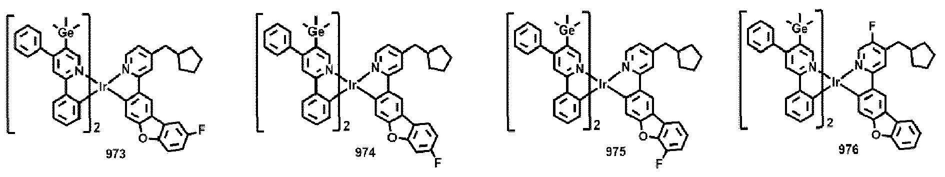

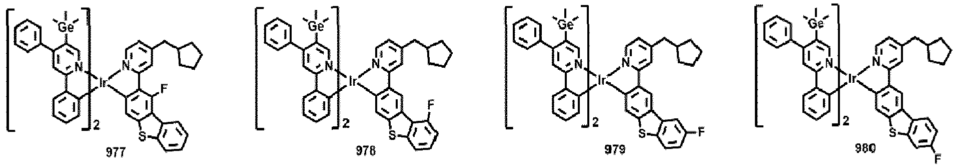

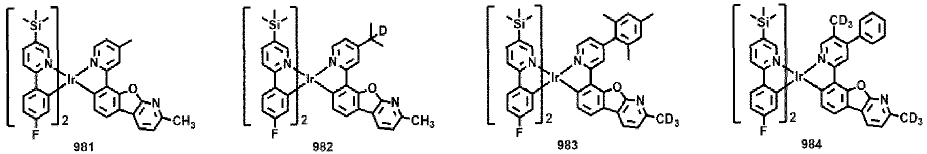

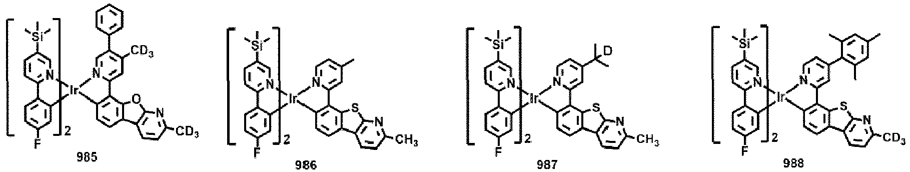

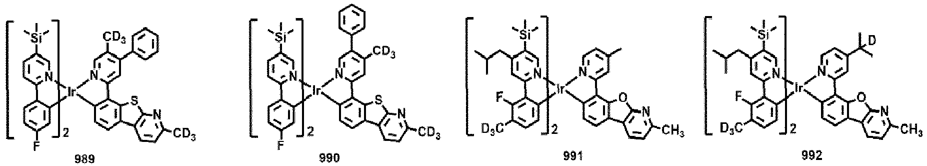

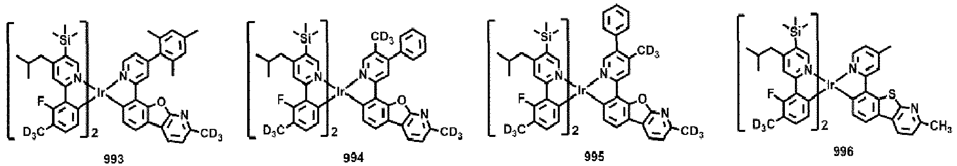

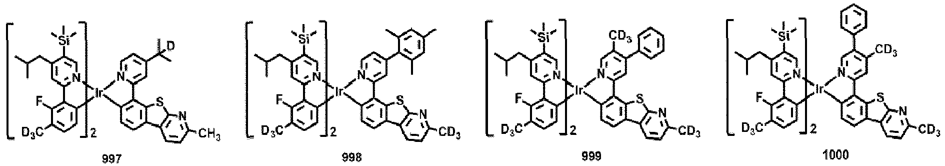

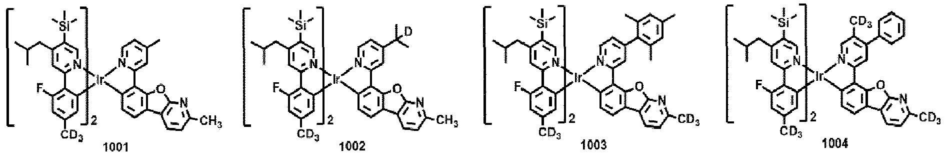

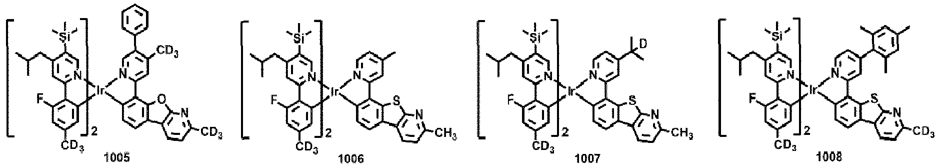

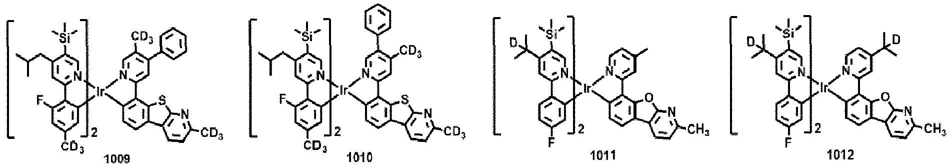

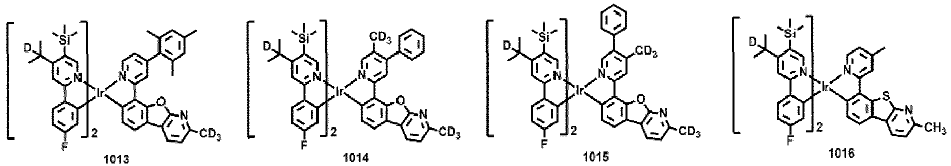

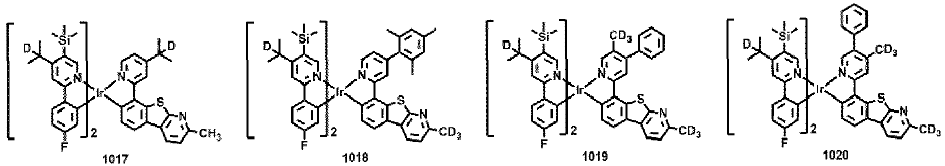

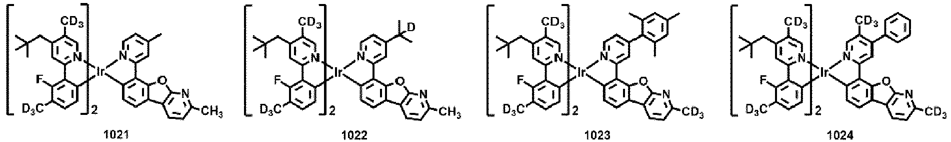

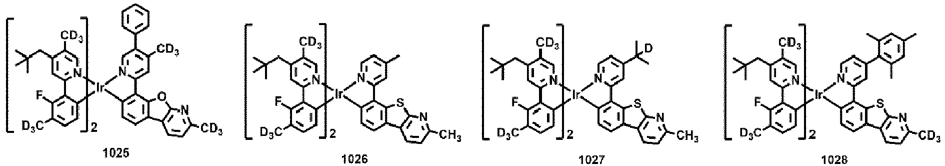

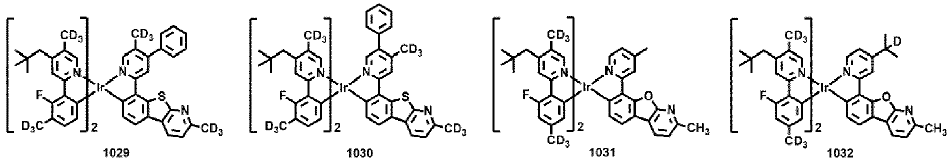

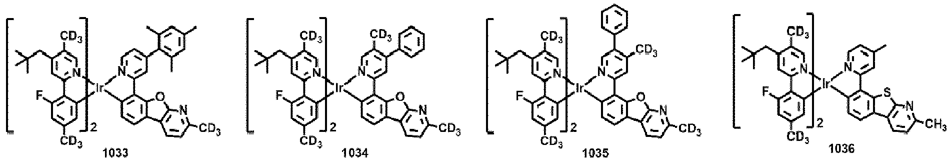

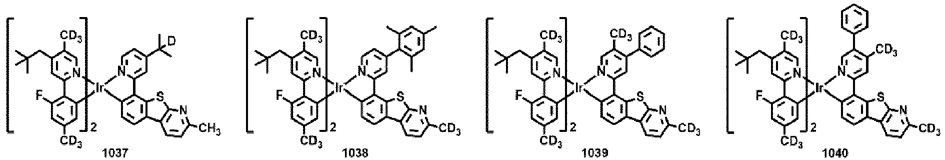

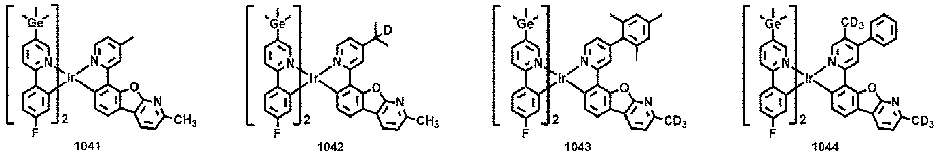

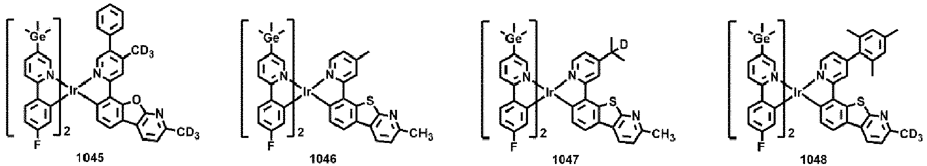

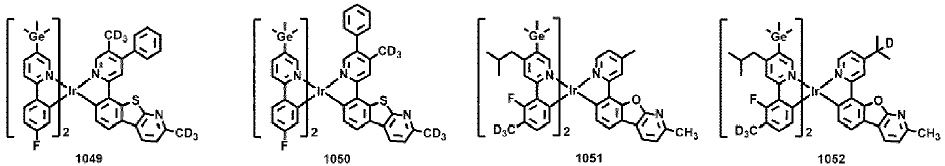

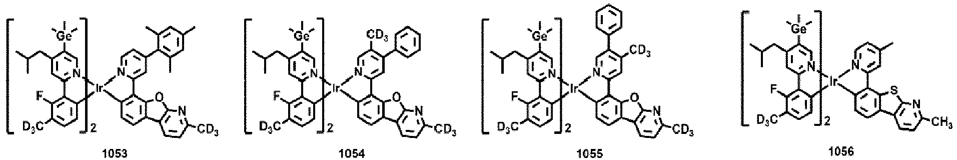

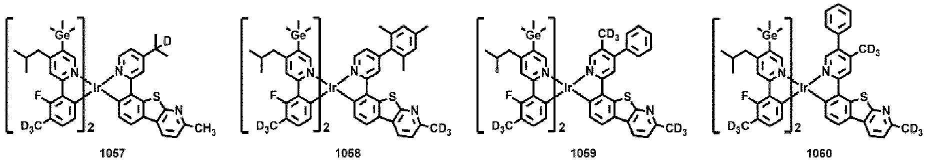

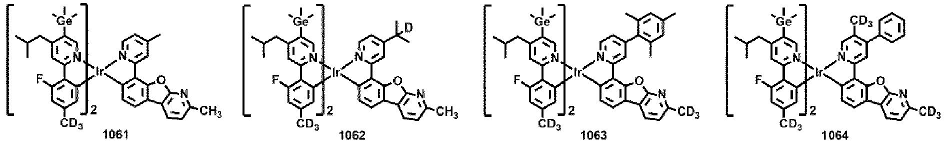

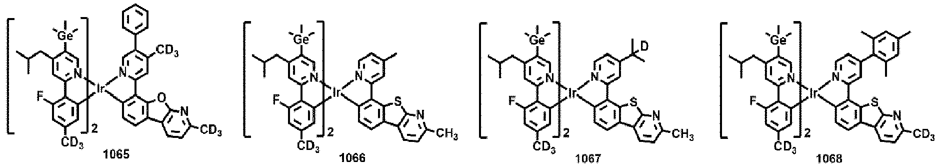

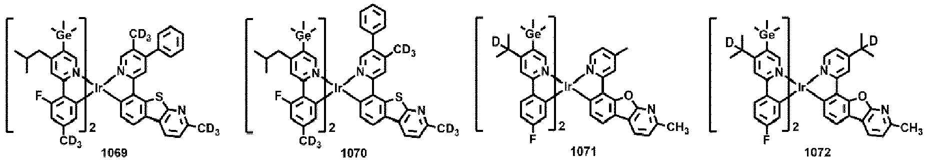

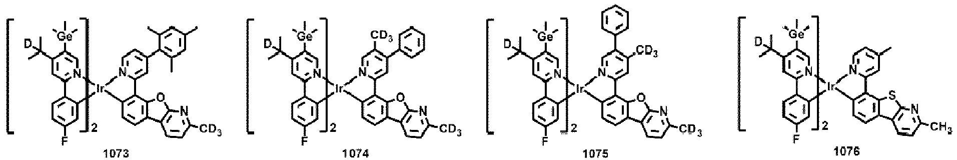

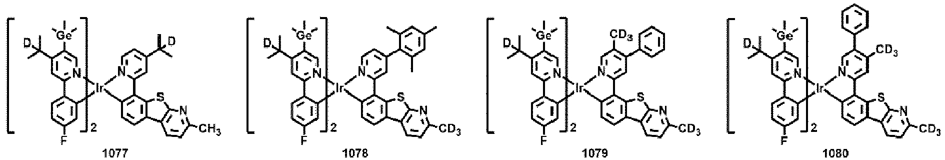

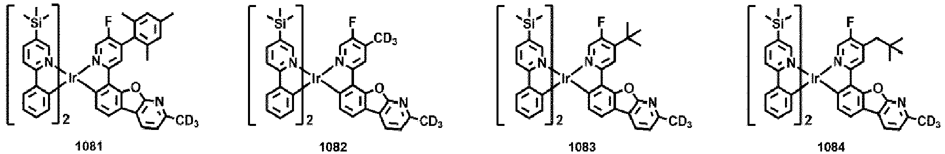

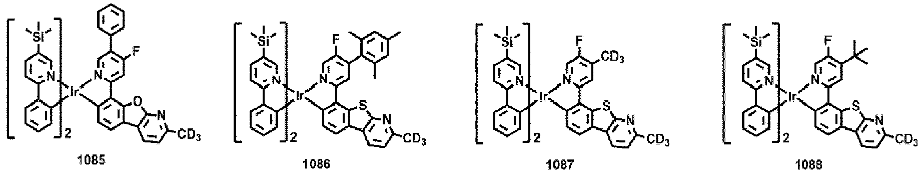

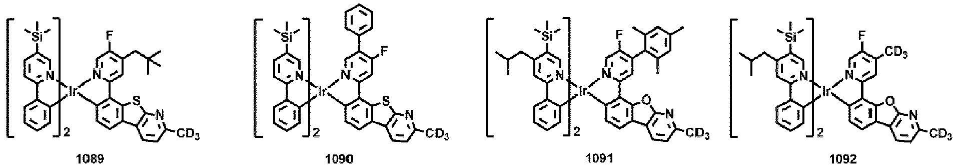

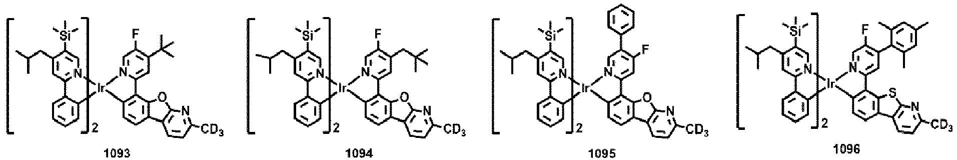

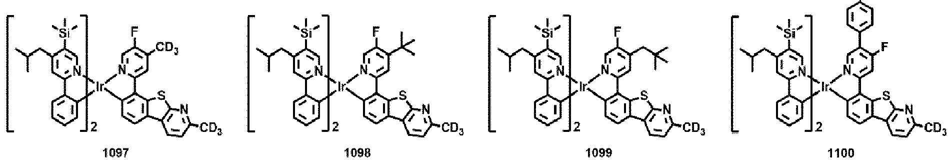

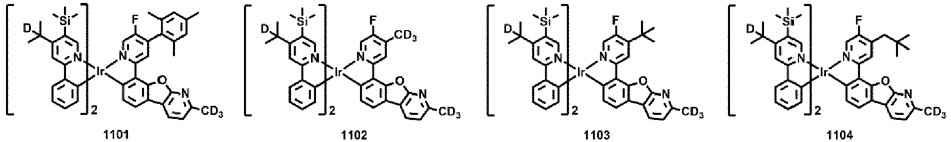

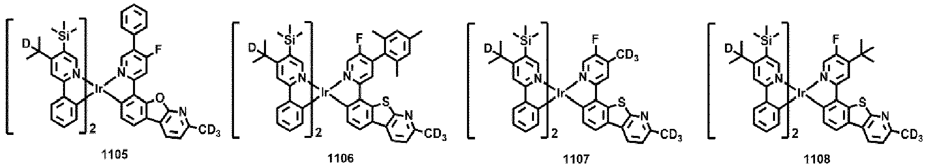

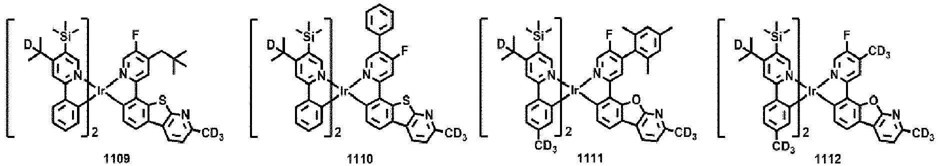

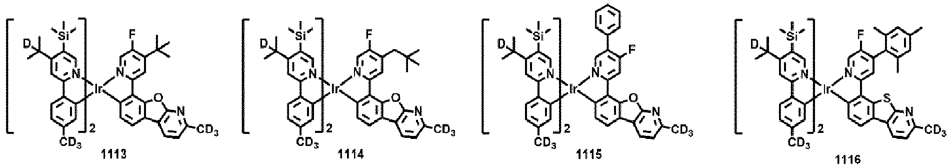

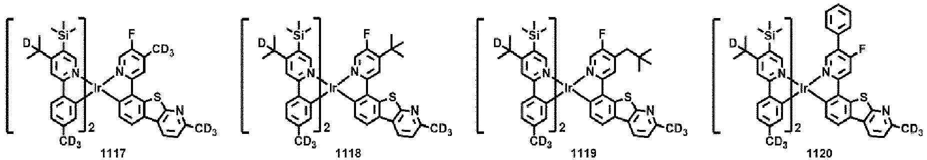

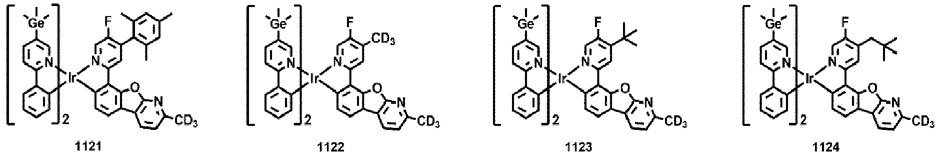

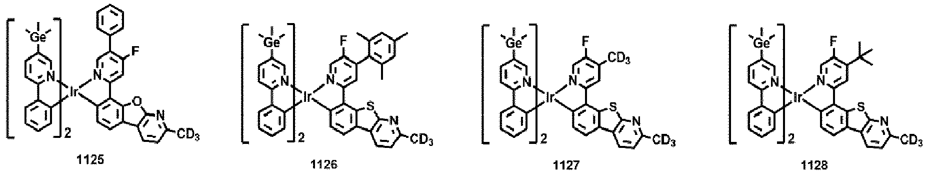

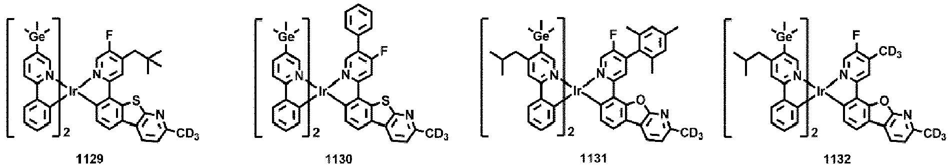

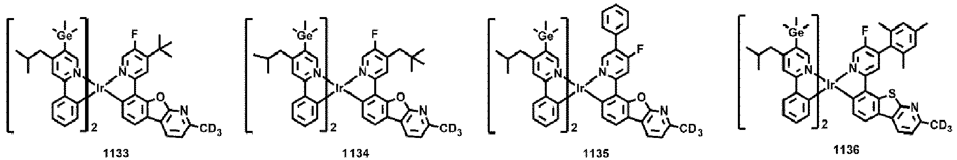

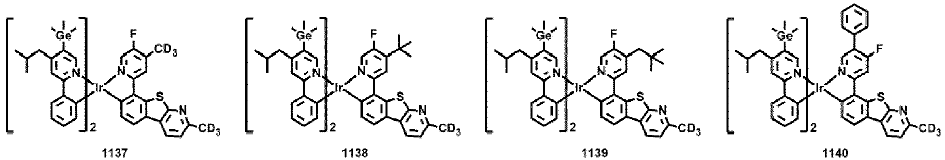

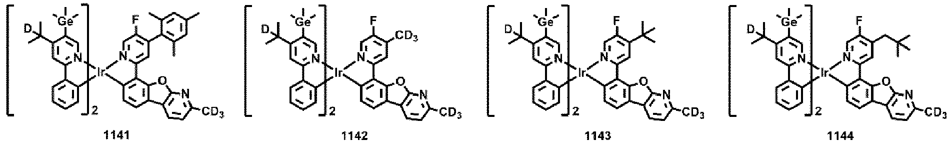

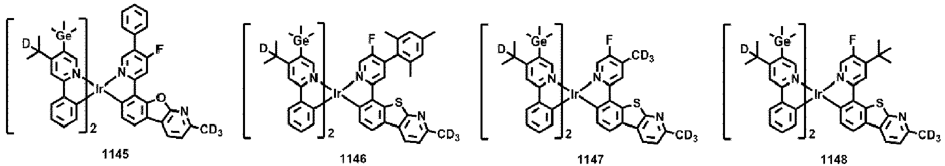

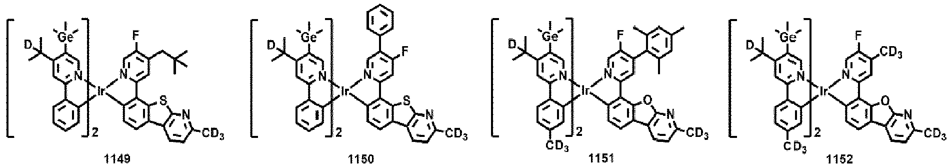

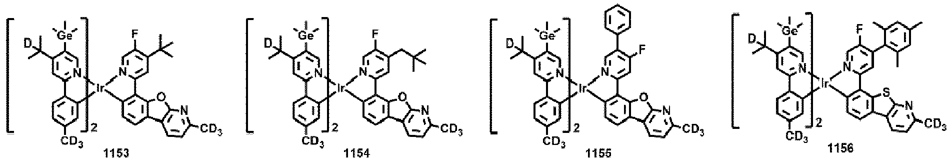

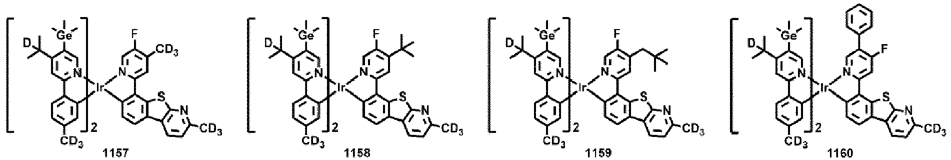

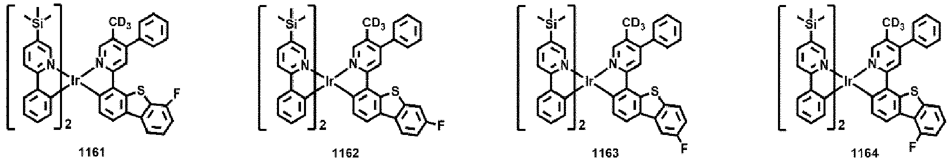

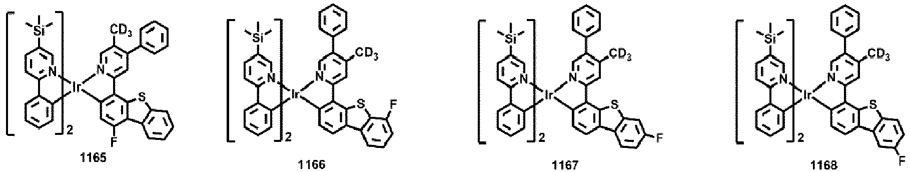

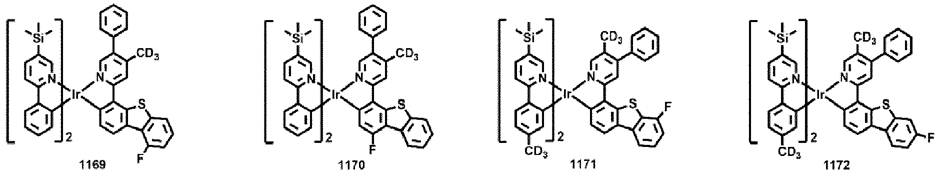

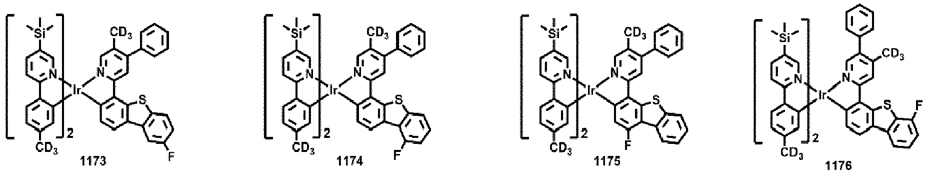

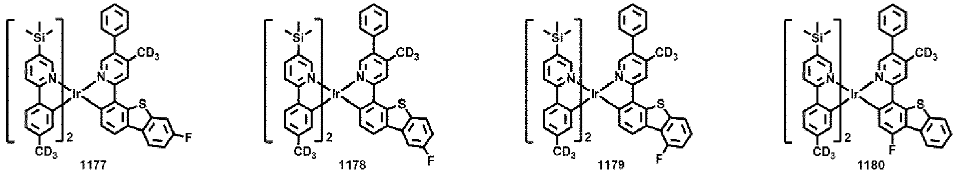

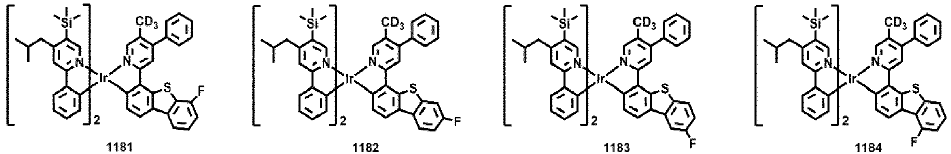

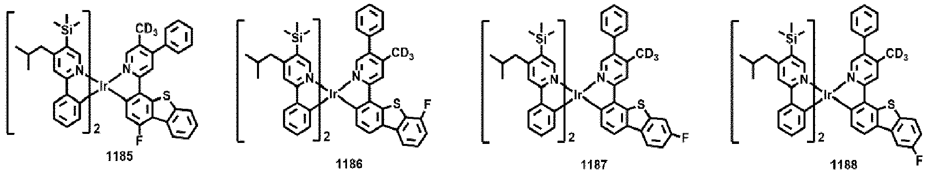

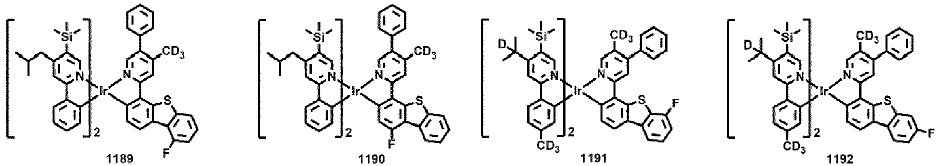

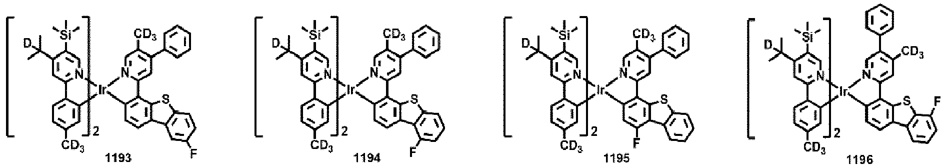

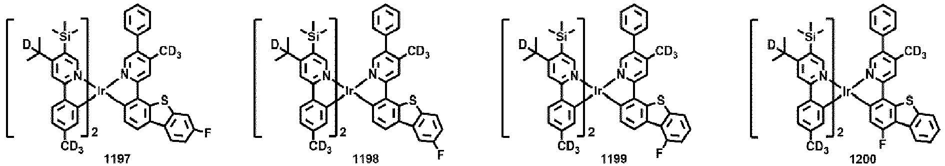

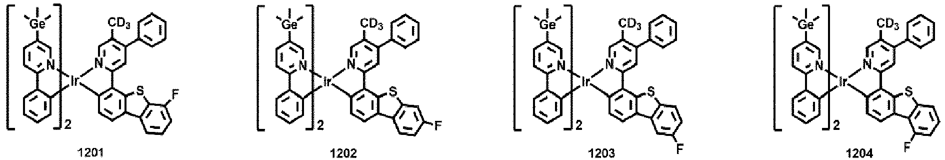

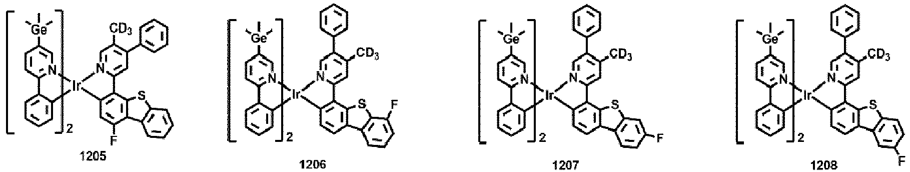

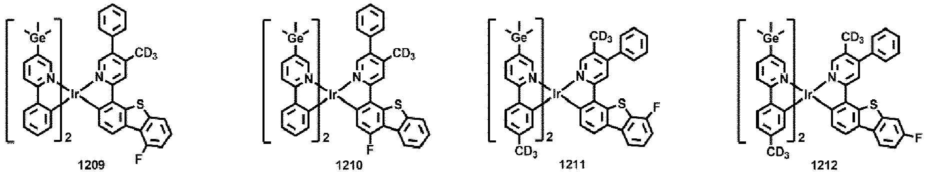

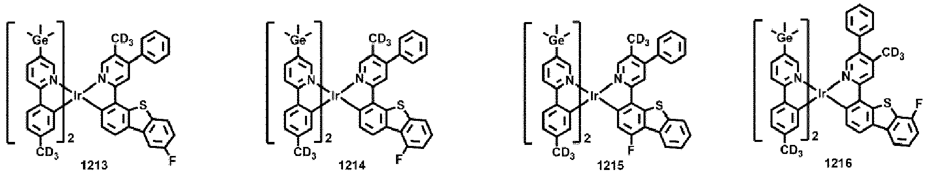

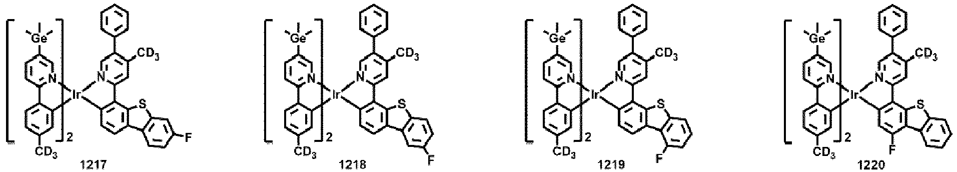

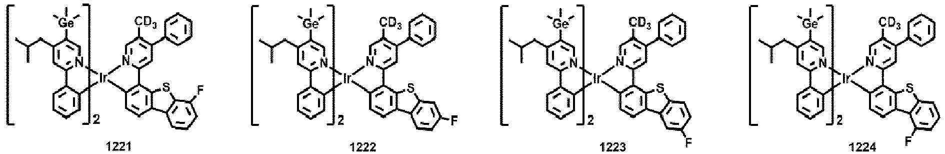

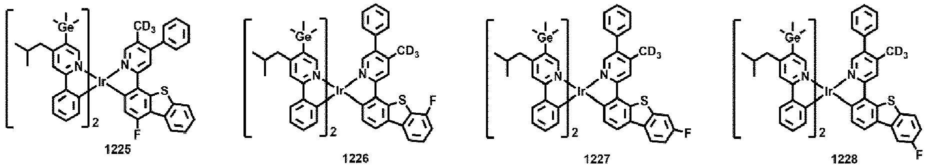

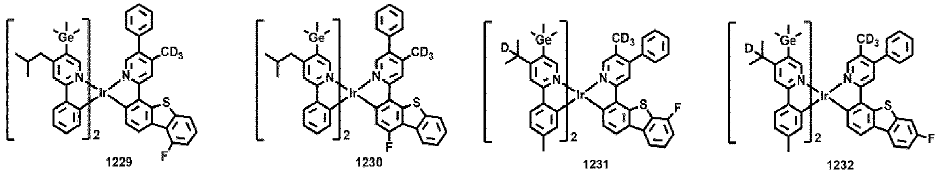

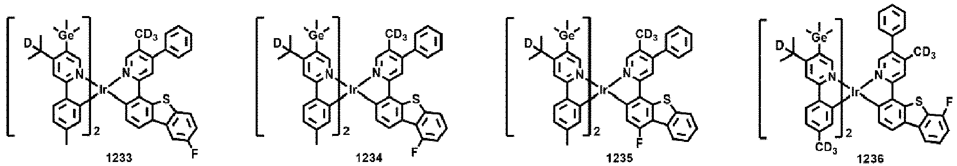

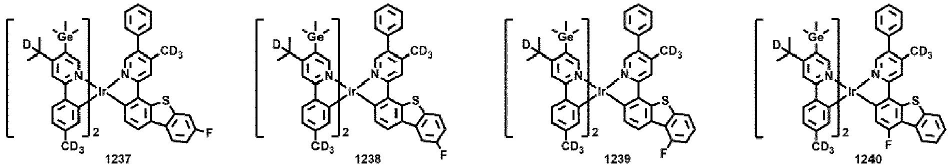

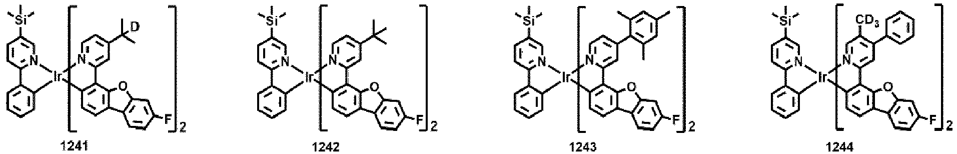

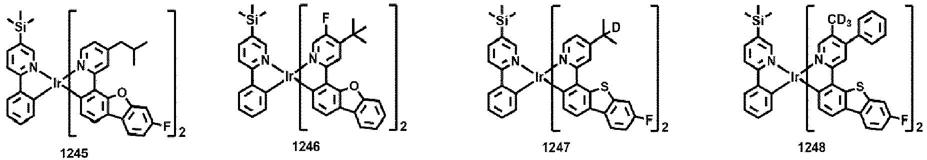

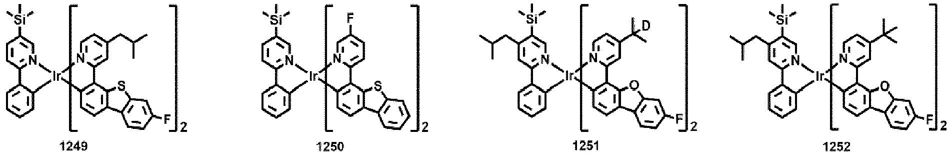

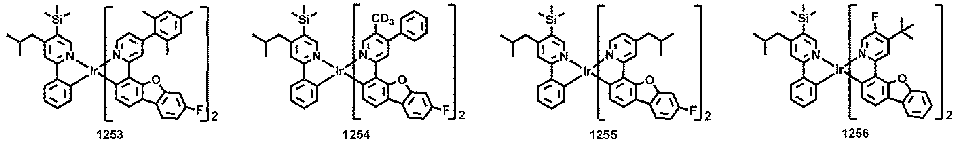

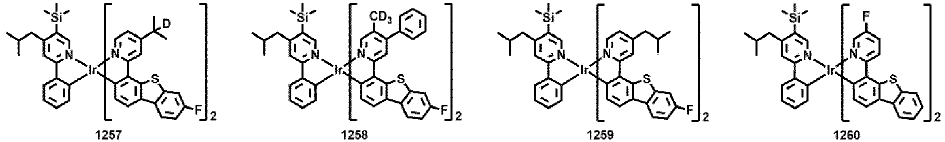

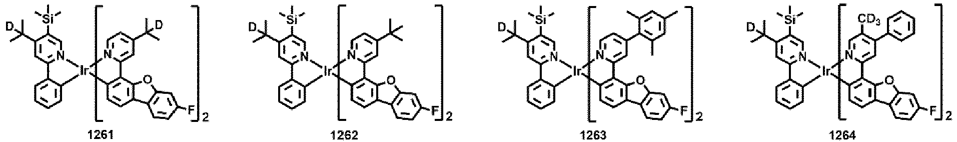

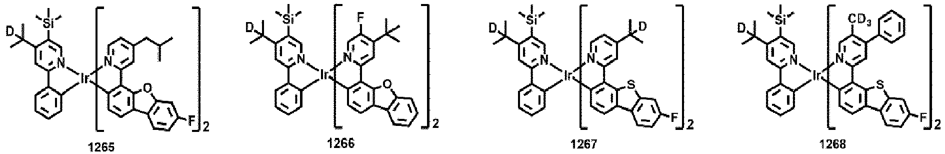

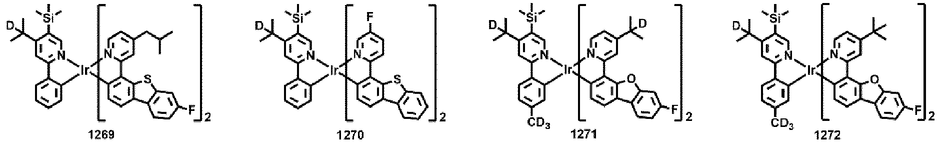

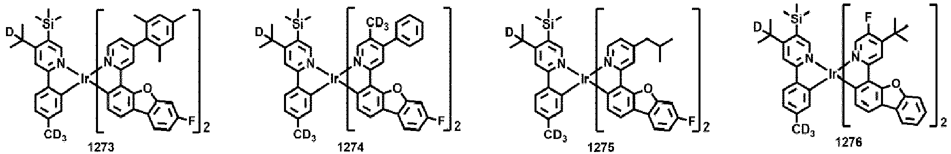

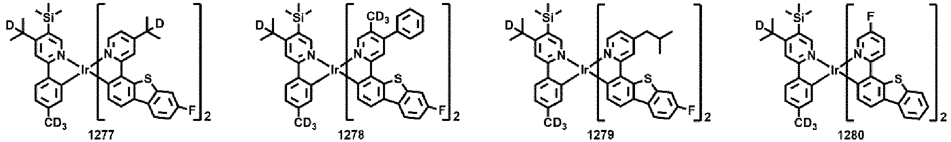

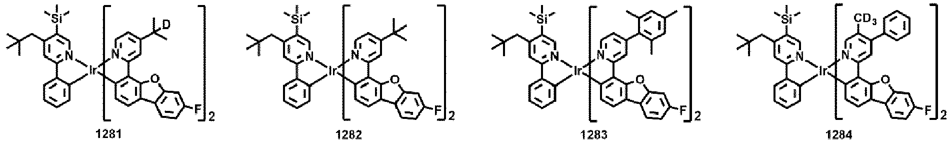

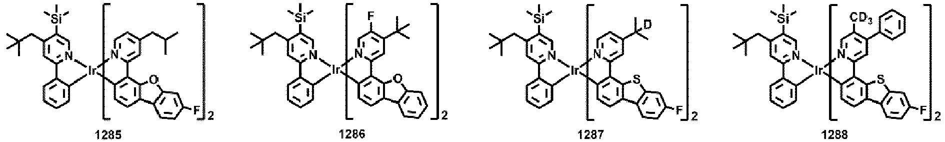

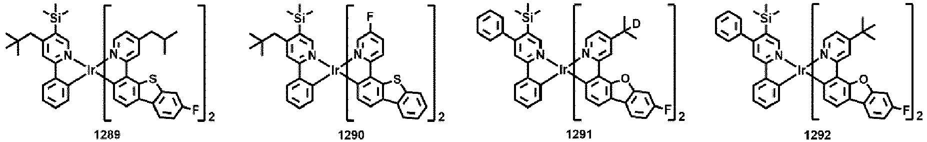

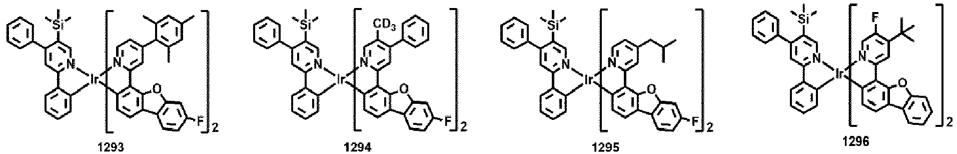

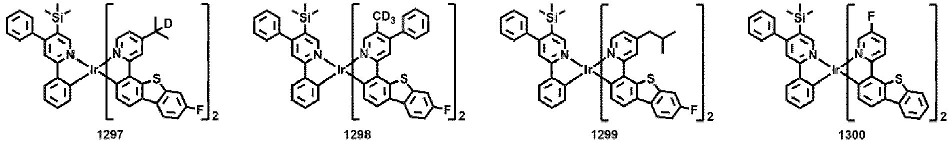

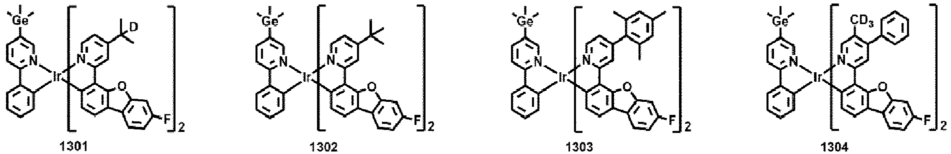

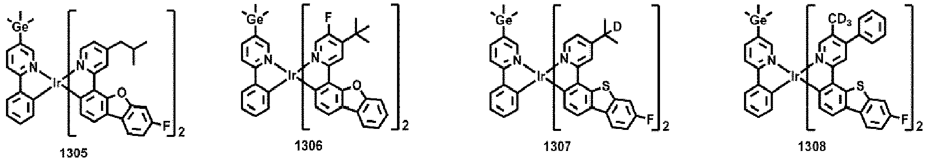

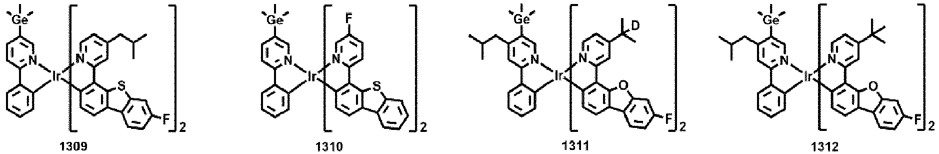

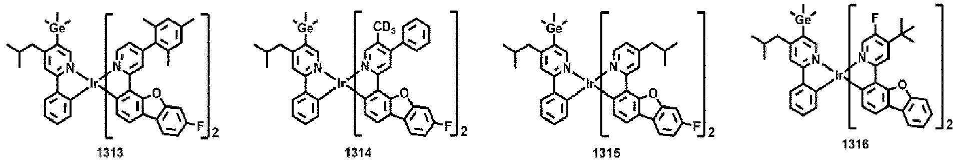

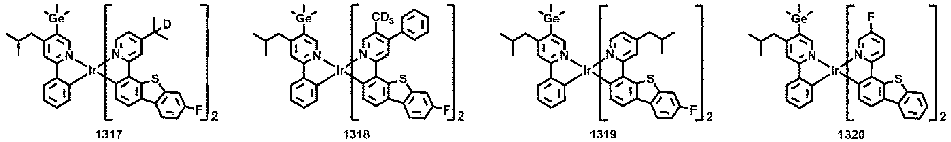

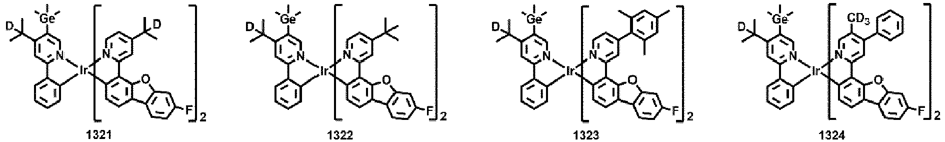

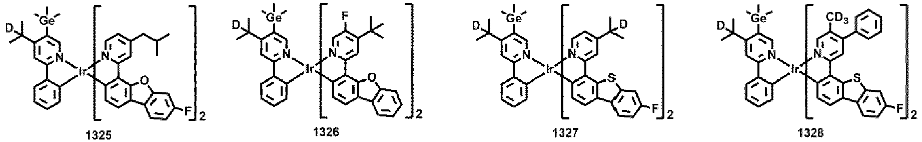

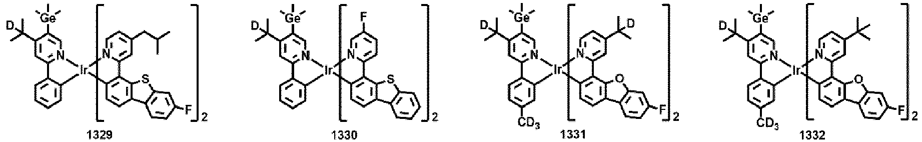

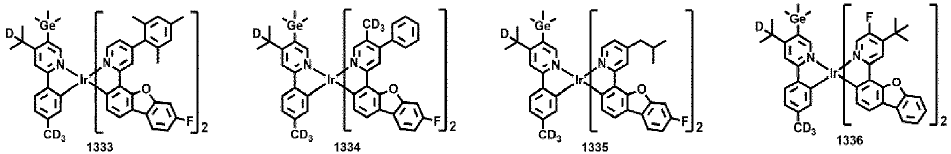

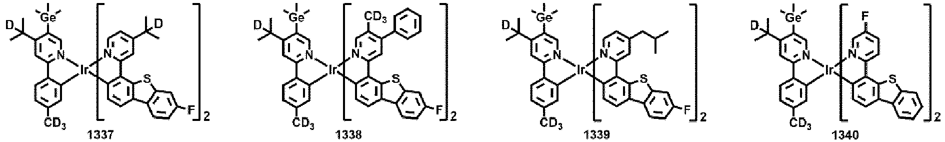

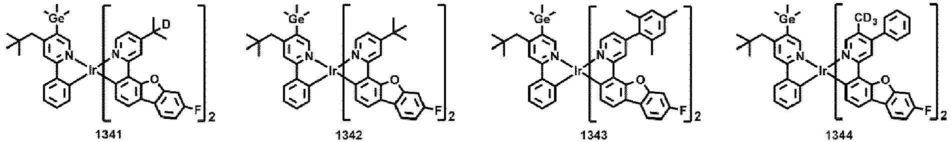

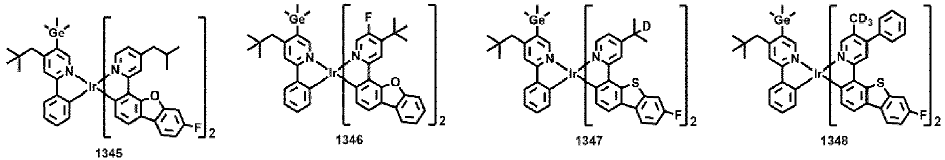

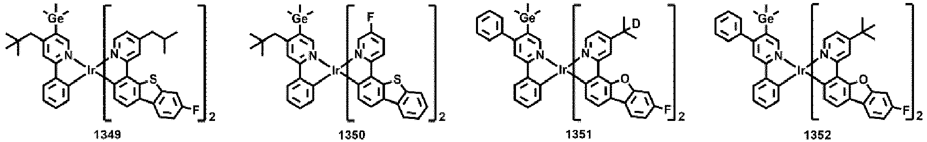

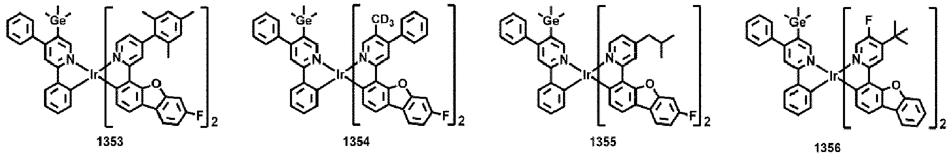

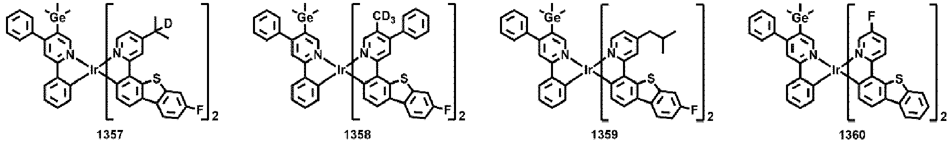

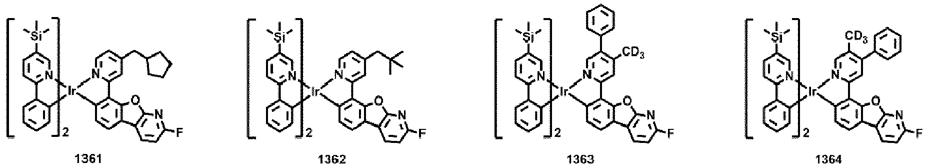

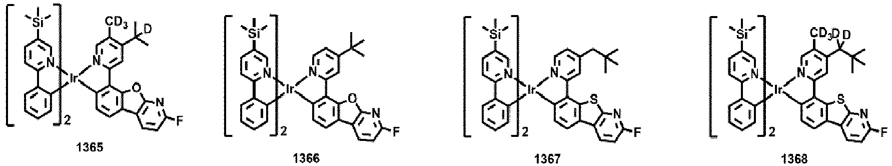

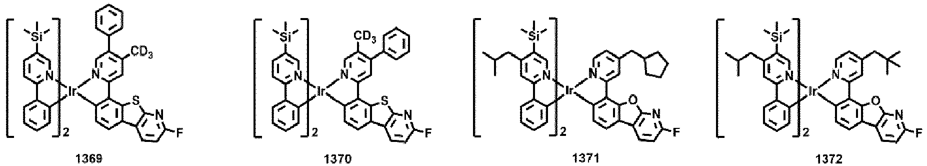

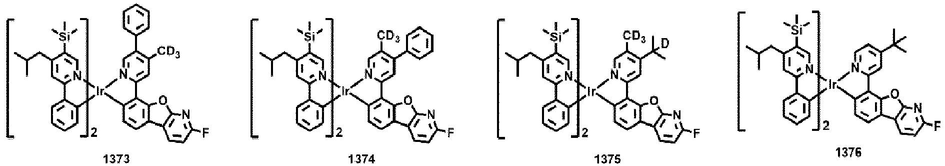

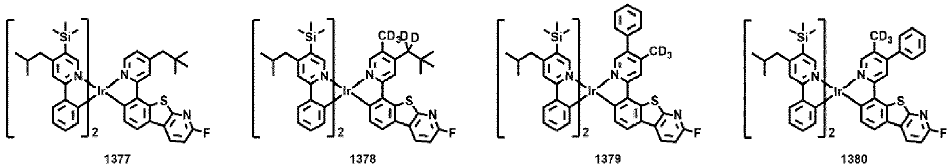

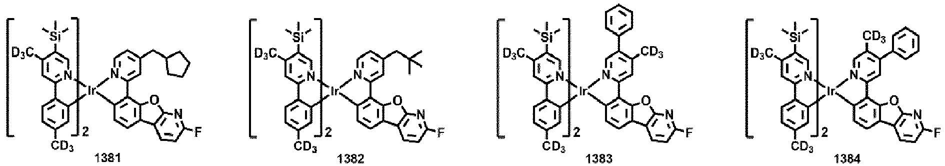

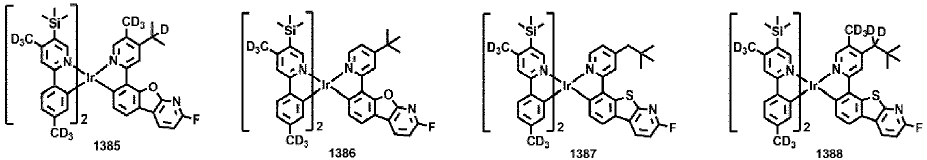

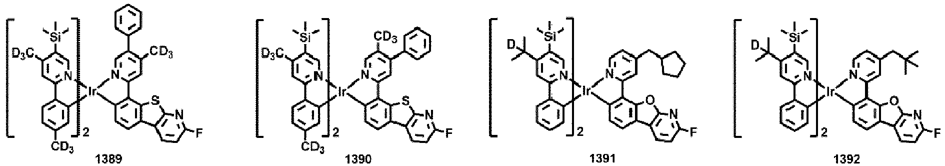

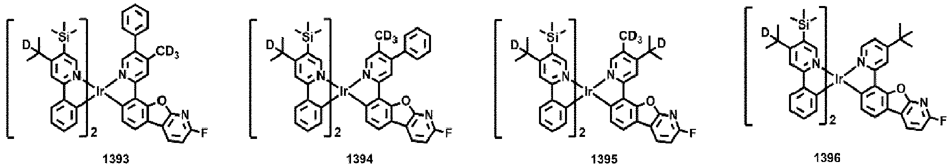

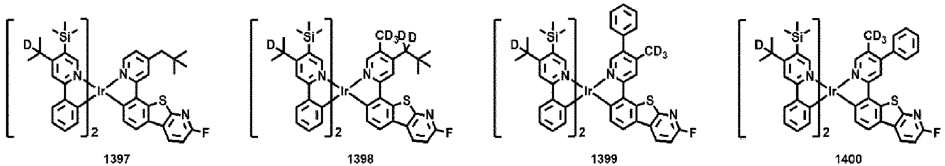

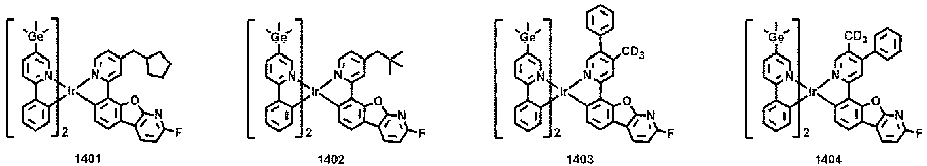

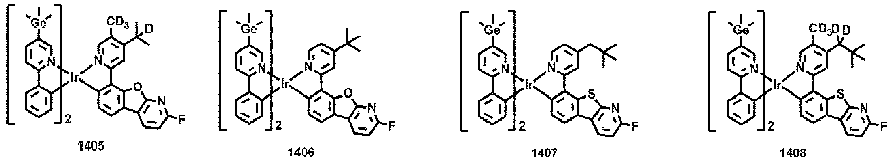

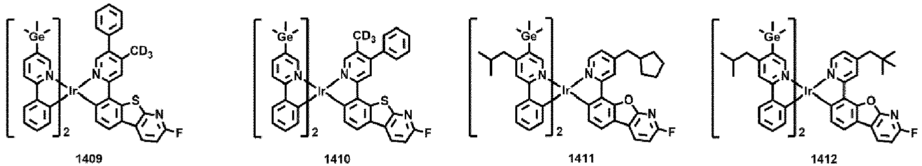

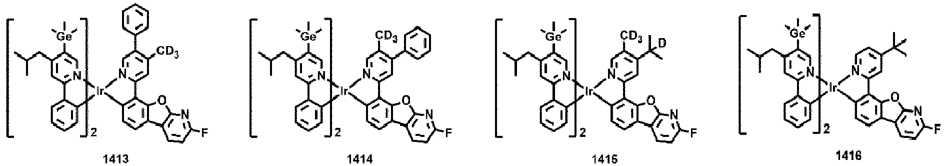

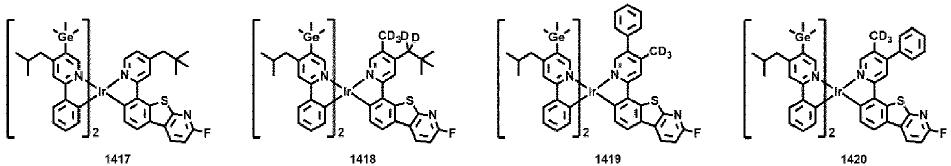

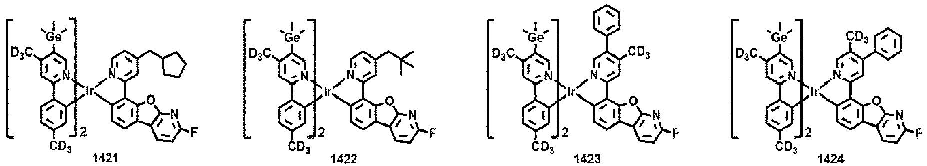

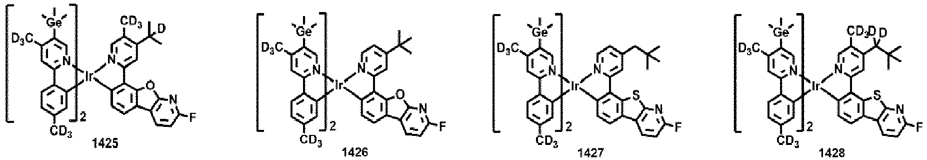

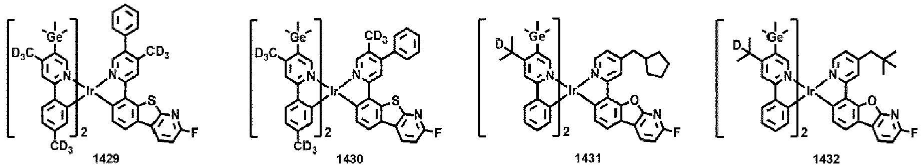

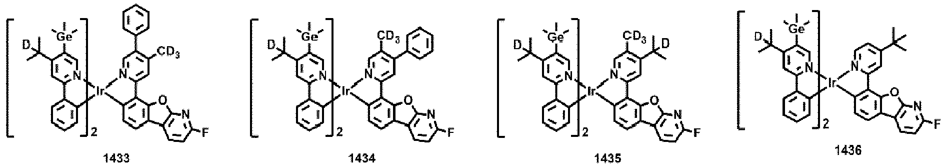

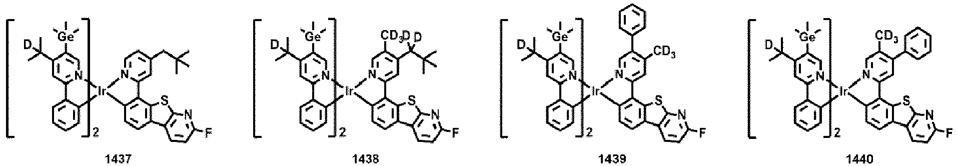

In the organometallic compound represented by Formula 1, L₁ may be a ligand represented by Formula 2A, n1 which indicates the number of L₁ may be 1 or 2, L₂ may be a ligand represented by Formula 2B, n2 which indicates the number of L₂ may be 1 or 2, and L₁ and L₂ may be different from each other. That is, the organometallic compound may be a heteroleptic complex that includes, as a ligand bonded to metal M, at least one ligand represented by Formula 2A and at least one ligand represented by Formula 2B.

In Formulae 2A and 2B, Z₁, Z₃, and Z₄ may each independently be a fluoro group or a fluorinated group, Z₂ may be a fluoro group, a fluorinated non-cyclic group, or a fluorinated saturated cyclic group, and the sum of a1, a2, a3, and a4 may be 1 or more. That is, the organometallic compound represented by Formula 1 may include at least one fluoro group. Accordingly, the organometallic compound represented by Formula 1 may have a relatively deep highest occupied molecular orbital (HOMO) energy level (that is, a large absolute value of HOMO energy level) and improved charge mobility.

In an embodiment, when i) none of T₁ to T₈ in Formula 2A is N, ii) a2 in Formula 2A is not 0, and iii) Z₂ in Formula 2A is a fluoro group, then a) b3 in Formula 2B may not be 0, and b) at least one of R₃(s) in the number of b3 in Formula 2B may be - Si(Q₃)(Q₄)(Q₅) or -Ge(Q₃)(Q₄)(Q₅). Accordingly, the organometallic compound represented by Formula 1 may have improved molecular orientation, so that the orientation of the organometallic compound represented by Formula 1 with a compound, such as a host, used with the organometallic compound may be also improved.

In an embodiment, an electronic device using the organometallic compound represented by Formula 1, for example, an organic light-emitting device using the organometallic compound represented by Formula 1 may have improved luminescence efficiency and/or long lifespan characteristics.

The HOMO energy level, lowest unoccupied molecular orbital (LUMO) energy level, S₁ energy level, and T₁ energy level of some compounds of the organometallic compound represented by Formula 1 are evaluated using the Gaussian 09 program with the molecular structure optimization obtained by B3LYP-based density functional theory (DFT), and results thereof are shown in Table 1.

**Table 1**

| Compound No. | HOMO (eV) | LUMO (eV) | S₁ (eV) | T₁ (eV) |
|---|---|---|---|---|
| 182 | -4.766 | -1.206 | 2.878 | 2.544 |
| 486 | -4.834 | -1.325 | 2.810 | 2.499 |
| 717 | -4.818 | -1.199 | 2.942 | 2.561 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of an organic light-emitting device, for example, a dopant in an emission layer of the organic layer. Thus, an aspect of the present disclosure provides an organic light-emitting device including: a first electrode; a second electrode; and an organic layer arranged between the first electrode and the second electrode, wherein the organic layer includes an emission layer, wherein he organic layer further includes at least one organometallic compound represented by Formula 1.

While not wishing to be bound by theory, it is understood that due to the inclusion of the organic layer including the organometallic compound represented by Formula 1 described above, the organic light-emitting device may have high external quantum efficiency and long lifespan characteristics.

The organometallic compound of Formula 1 may be used between a pair of electrodes of the organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). The emission layer may emit, for example, green light to blue light.

The expression "(an organic layer) includes at least one of organometallic compounds" as used herein may include a case in which "(an organic layer) includes identical organometallic compounds represented by Formula 1" and a case in which "(an organic layer) includes two or more different organometallic compounds represented by Formula 1".

In an embodiment, the organic layer may include, as the organometallic compound, only Compound 1. In an embodiment, Compound 1 may be included in the emission layer of the organic light-emitting device. In an embodiment, the organic layer may include, as the organometallic compound, Compound 1 and Compound 2. In an embodiment, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the organic light-emitting device, the first electrode may be an anode, and the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

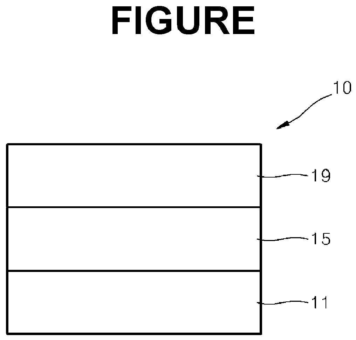

FIGURE is a schematic cross-sectional view of an organic light-emitting device 10 according to an embodiment. Hereinafter, the structure of an organic light-emitting device according to an embodiment of the present disclosure and a method of manufacturing an organic light-emitting device according to an embodiment of the present disclosure will be described in connection with the FIGURE. The organic light-emitting device 10 includes a first electrode 11, an organic layer 15, and a second electrode 19, which are sequentially stacked.

A substrate may be additionally arranged under the first electrode 11 or above the second electrode 19. For use as the substrate, any suitable substrate that is used in organic light-emitting devices available in the art may be used, and the substrate may be a glass substrate or a transparent plastic substrate, each having suitable mechanical strength, thermal stability, transparency, surface smoothness, ease of handling, and water resistance.

In an embodiment, the first electrode 11 may be formed by, for example, depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. In an embodiment, the material for forming the first electrode 11 may be indium tin oxide (ITO), indium zinc oxide (IZO), tin oxide (SnO₂), or zinc oxide (ZnO). In an embodiment, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is arranged on the first electrode 11.

The organic layer 15 may include: a hole transport region; an emission layer; and an electron transport region.

The hole transport region may be arranged between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. The hole transport region may have a hole injection layer/hole transport layer structure or a hole injection layer/hole transport layer/electron blocking layer structure, wherein, in each structure, layers are sequentially stacked on the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature in a range about 100 °C to about 500 °C, for example, from about 100 °C to about 400 °C, from about 100 °C to about 300 °C, from about 100 °C to about 200 °C, a vacuum pressure in a range of about 10⁻⁸ torr to about 10⁻³ torr, for example, from about 10⁻⁸ torr to about 10⁻⁷ torr, from about 10⁻⁸ torr to about 10⁻⁶ torr, from about 10⁻⁸ torr to about 10⁻⁵ torr, from about 10⁻⁸ torr to about 10⁻⁴ torr, and a deposition rate in a range of about 0.01 Å/sec to about 100 Å/sec, for example, from about 0.01 Å/sec to about 10 Å/sec, from about 0.01 Å/sec to about 30 Å/sec, about 0.01 Å/sec to about 50 Å/sec, from about 0.01 Å/sec to about 70 Å/sec, or from about 0.01 Å/sec to about 90 Å/sec.

When the hole injection layer is formed by spin coating, the coating conditions may vary according to a material that is used to form the hole injection layer, and the structure and thermal characteristics of the hole injection layer. For example, the coating conditions may include a coating speed in a range of about 2,000 rpm (revolutions per minute) to about 5,000 rpm, for example, from about 2,000 rpm to about 3,000 rpm, from about 2,000 rpm to about 4,000 rpm, and a temperature at which a heat treatment is performed to remove a solvent after coating in a range of about 80 °C to about 200 °C, for example, from about 80 °C to about 100 °C, from about 80 °C to about 120 °C, from about 80 °C to about 140 °C, from about 80 °C to about 160 °C, or from about 80 °C to about 180 °C.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof: 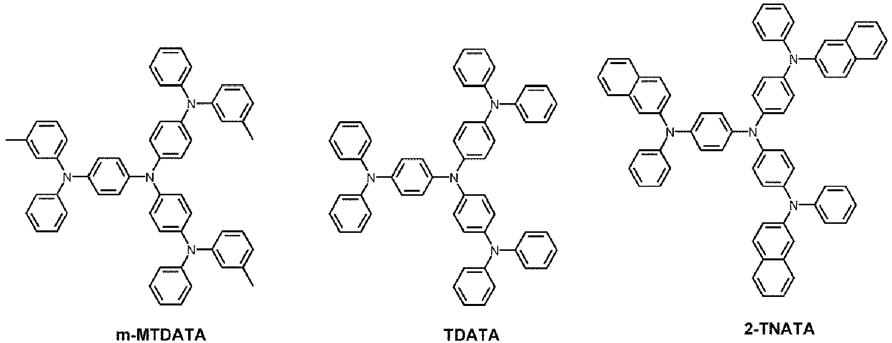 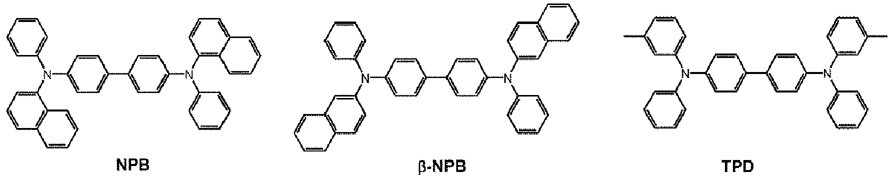 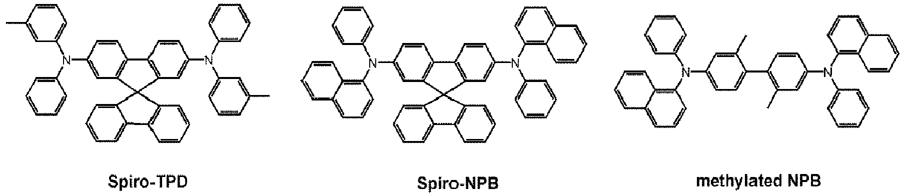 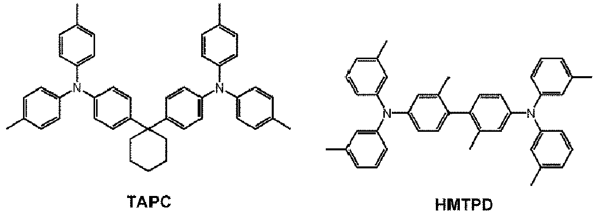 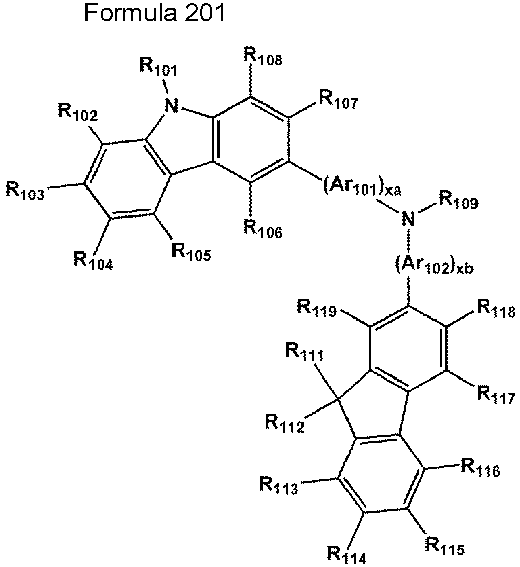 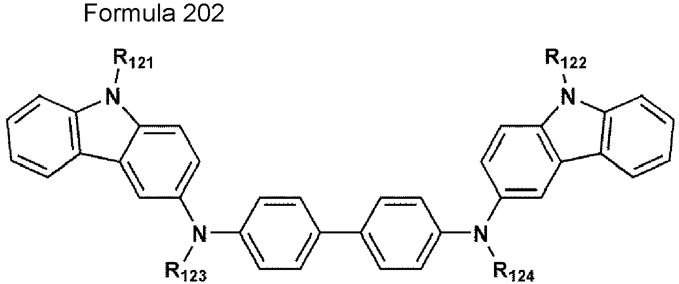 wherein, Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each independently unsubstituted or substituted with deuterium, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C1-C₆₀ heteroarylthio group, a C₂-C₆₀ heteroarylalkyl group, a monovalent non-aromatic condensed polycyclic group, a monovalent non-aromatic condensed heteropolycyclic group, or a combination thereof.

In Formula 201, xa and xb may each independently be an integer from 0 to 5, or may be 0, 1, or 2. For example, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each independently unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group or a pyrenyl group, each independently unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof.

In Formula 201, R₁₀₉ may be a phenyl group, a naphthyl group, an anthracenyl group, or a pyridinyl group, each independently unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or a combination thereof.

In an embodiment, the compound represented by Formula 201 may be represented by Formula 201A: 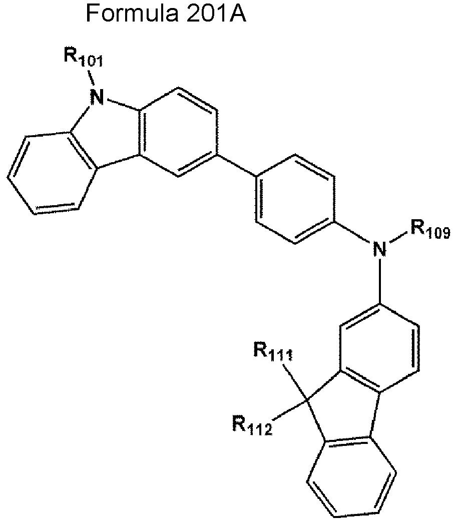 wherein, in Formula 201A, R₁₀₁, R₁₁₁, R₁₁₂, and R₁₀₉ may each be the same as described herein.

For example, the hole transport region may include one of Compounds HT1 to HT20 or a combination thereof:

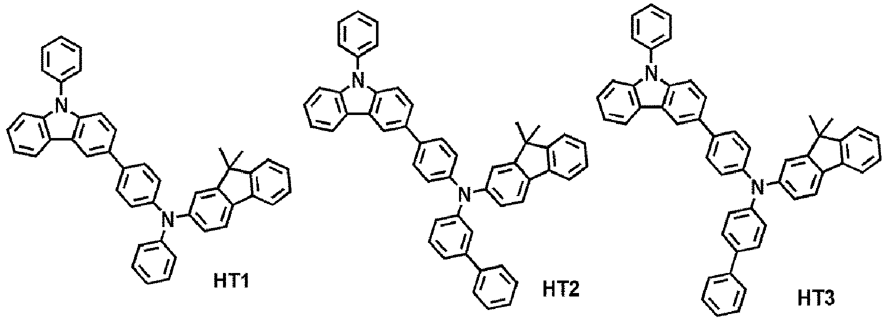

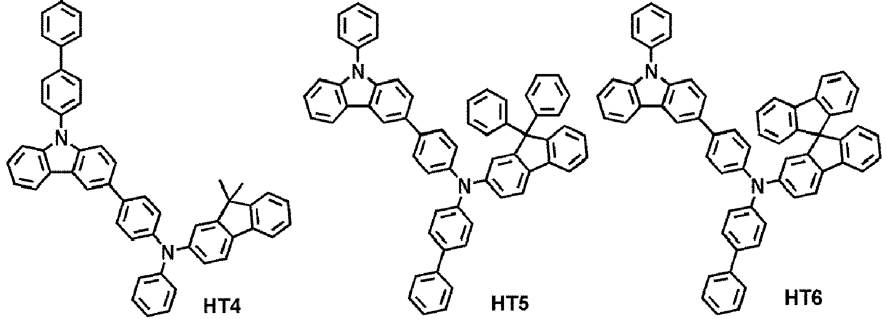

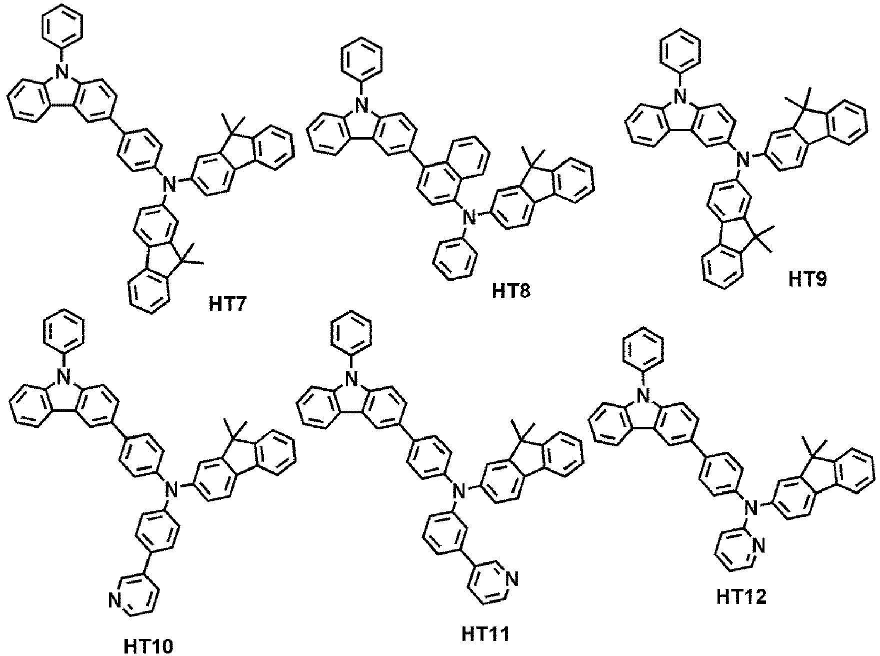

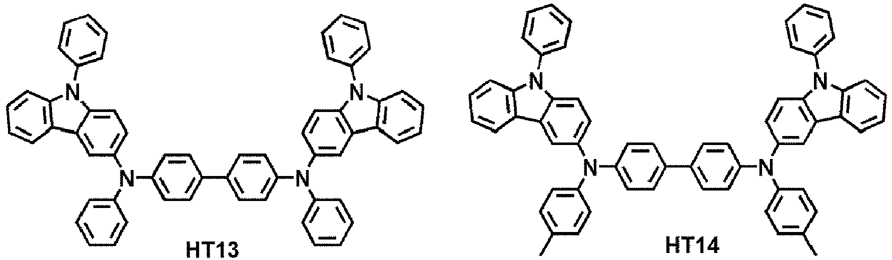

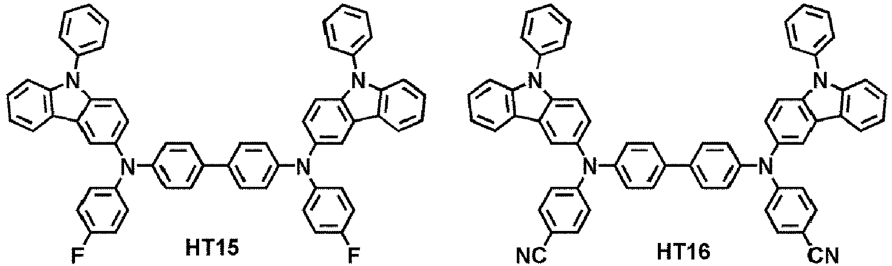

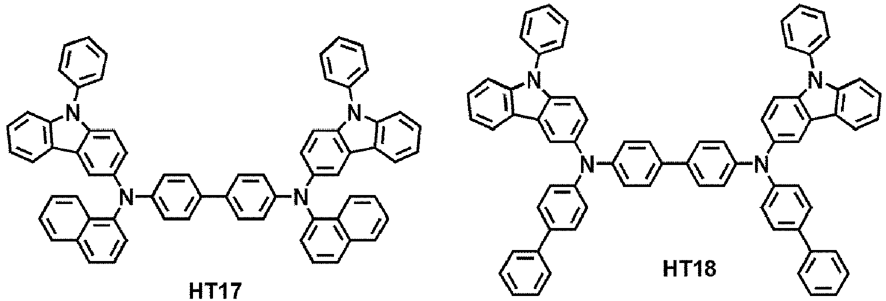

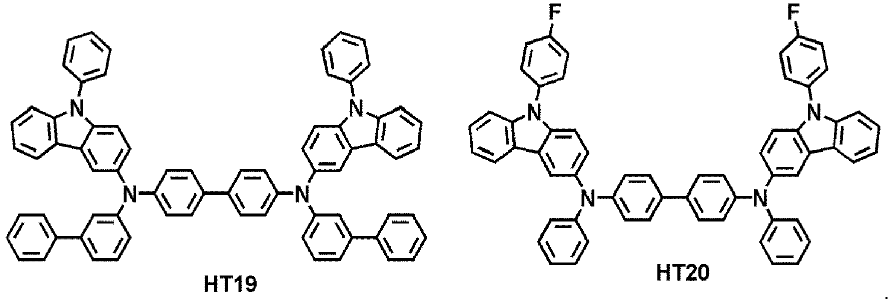

A thickness of the hole transport region may be in a range of about 100 Angstroms (Å) to about 10,000 Å, for example, about 100 Å to about 1,000 Å, about 100 Å to about 2,000 Å, about 100 Å to about 3000 Å, about 100 Å to about 5,000 Å, about 100 Å to about 7,000 Å, or about 100 Å to about 9,000 Å. When the hole transport region includes at least one of a hole injection layer and a hole transport layer, a thickness of the hole injection layer may be in a range of about 100 Å to about 10,000 Å, for example, about 100 Å to about 1,000 Å, about 100 Å to about 2,000 Å, about 100 Å to about 3000 Å, about 100 Å to about 5,000 Å, about 100 Å to about 7,000 Å, or about 100 Å to about 9,000 Å, and a thickness of the hole transport layer may be in a range of about 50 Å to about 2,000 Å, for example, about 100 Å to about 500 Å, about 100 Å to about 1,000 Å, or about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof. For example, the p-dopant may be: a quinone derivative such as tetracyanoquinodimethane (TCNQ), 2,3,5,6-tetrafluoro-tetracyano-1,4-benzoquinonedimethane (F4-TCNQ), or F6-TCNNQ; a metal oxide, such as tungsten oxide and molybdenum oxide; a cyano group-containing compound, such as Compound HT-D1; or a combination thereof.

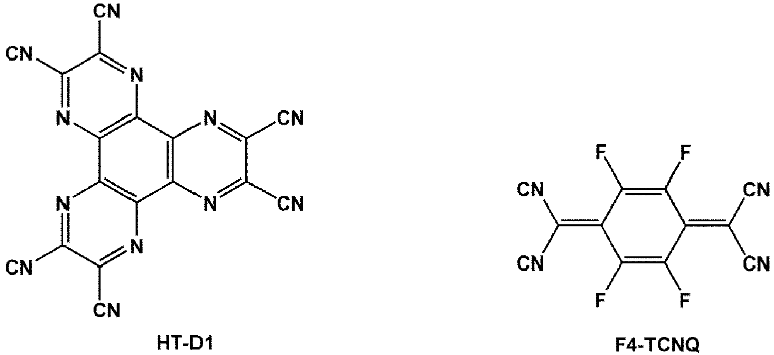

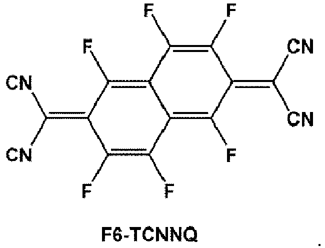

The hole transport region may further include a buffer layer.

The buffer layer may compensate for an optical resonance distance according to a wavelength of light emitted from the emission layer, and thus, efficiency of a formed organic light-emitting device may be improved.

In an embodiment, when the hole transport region includes an electron blocking layer, a material for forming the electron blocking layer may include a material that is used in the hole transport region as described above, a host material described below, or a combination thereof. For example, when the hole transport region includes an electron blocking layer, a material for forming the electron blocking layer may be mCP, which is described below.

In an embodiment, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1 described above.

The host may include TPBi, TBADN, ADN (also referred to as "DNA"), CBP, CDBP, TCP, mCP, Compound H50, Compound H51, Compound H52, or a combination thereof:

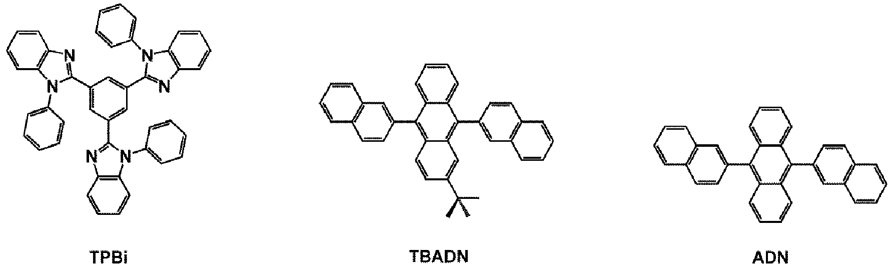

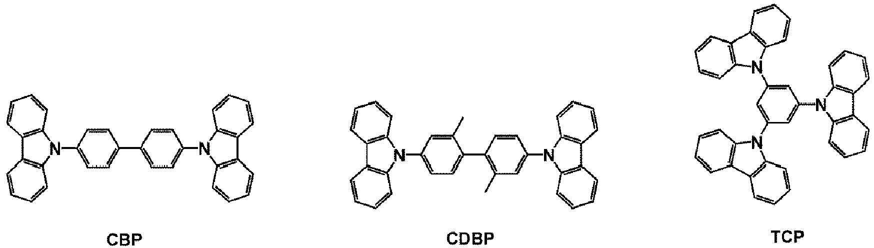

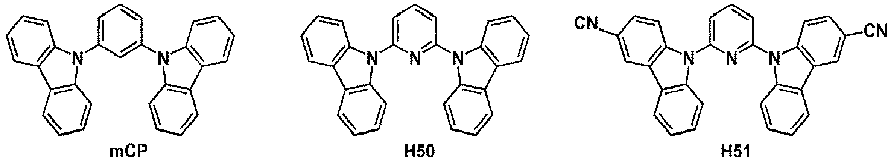

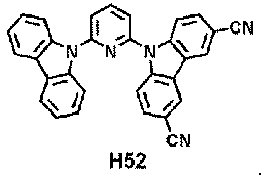

In an embodiment, when the organic light-emitting device is a full-color organic light-emitting device, the emission layer may be patterned into a red emission layer, a green emission layer, and/or a blue emission layer. In an embodiment, due to a stacked structure including a red emission layer, a green emission layer, and/or a blue emission layer, the emission layer may emit white light.

In an embodiment, when the emission layer includes a host and a dopant, an amount of the dopant may be in a range of about 0.01 parts by weight to about 15 parts by weight based on 100 parts by weight of the host, for example, about 0.01 parts by weight to about 5 parts by weight, or about 0.01 parts by weight to about 10 parts by weight based on 100 parts by weight of the host.

A thickness of the emission layer may be in a range of about 100 Å to about 1,000 Å, for example, about 200 Å to about 600 Å, about 300 Å to about 700 Å, example, or about 400 Å to about 900 Å. While not wishing to be bound by theory, it is understood that when the thickness of the emission layer is within these ranges, improved light-emission characteristics may be obtained without a substantial increase in driving voltage.

In an embodiment, an electron transport region may be arranged on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAIq, or a combination thereof.

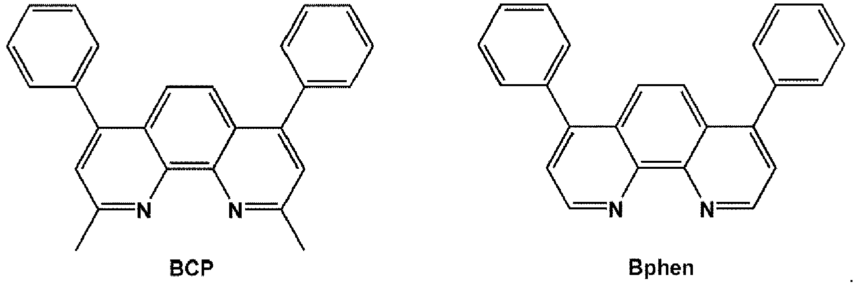

A thickness of the hole blocking layer may be in a range of about 20 Å to about 1,000 Å, for example, about 20 Å to about 400 Å about 30 Å to about 600 Å, about 40 Å to about 800 Å, or about 50 Å to about 1000 Å. While not wishing to be bound by theory, it is understood that when the thickness of the hole blocking layer is within these ranges, improved hole blocking characteristics may be obtained without a substantial increase in driving voltage.

In an embodiment, the electron transport layer may include BCP, Bphen, TPBi, AIq₃, BAIq, TAZ, NTAZ, or a combination thereof:

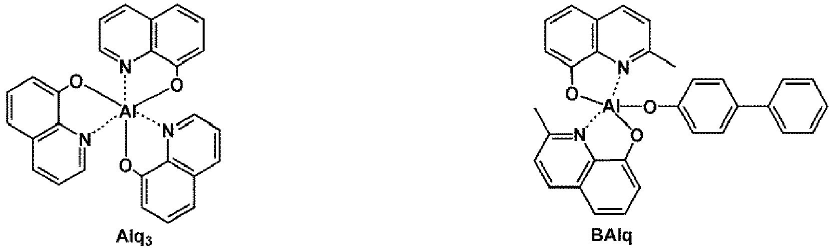

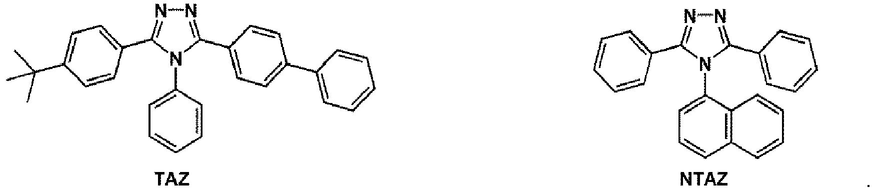

In an embodiment, the electron transport layer may include one of Compounds ET1 to ET25 or a combination thereof:

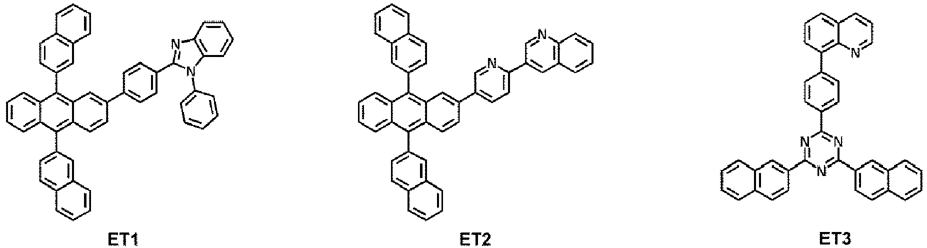

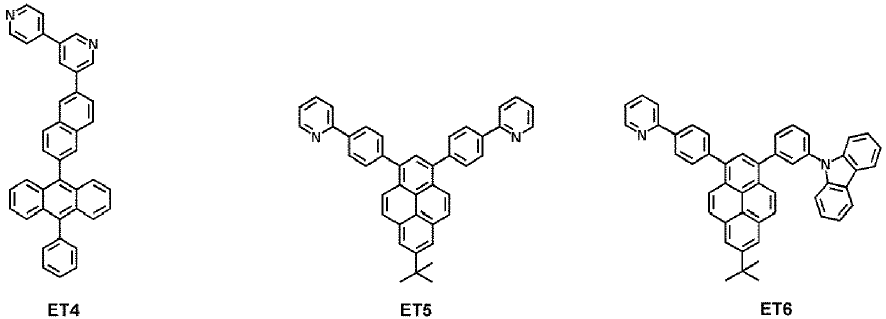

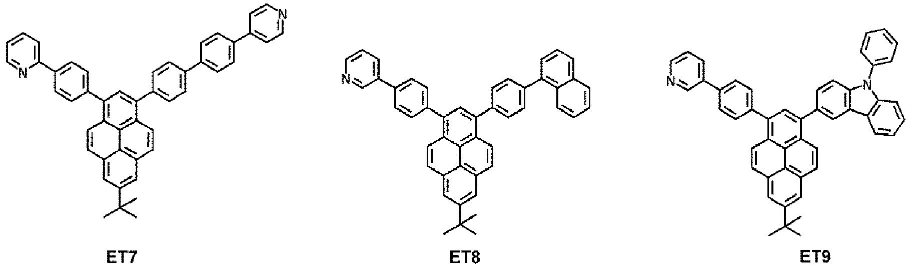

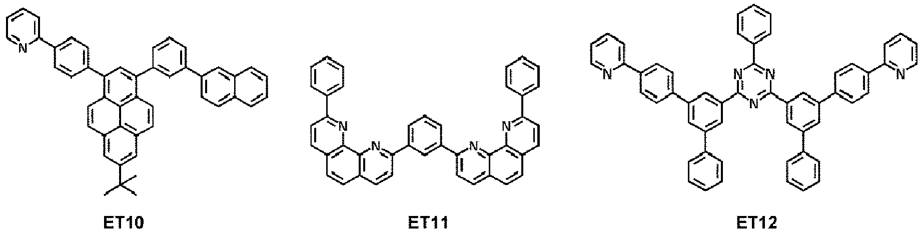

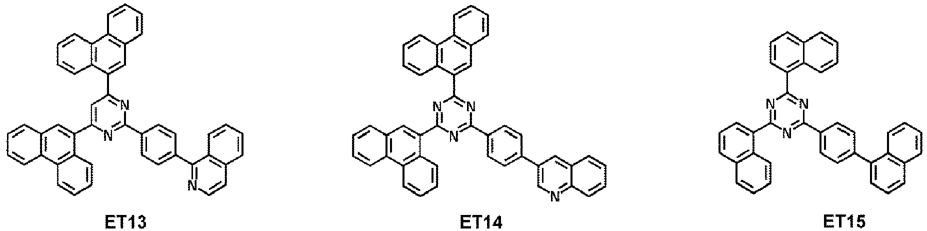

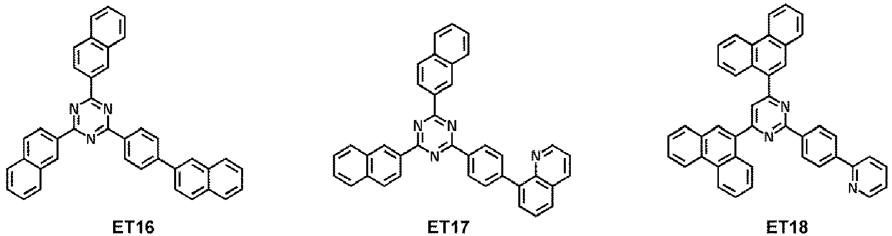

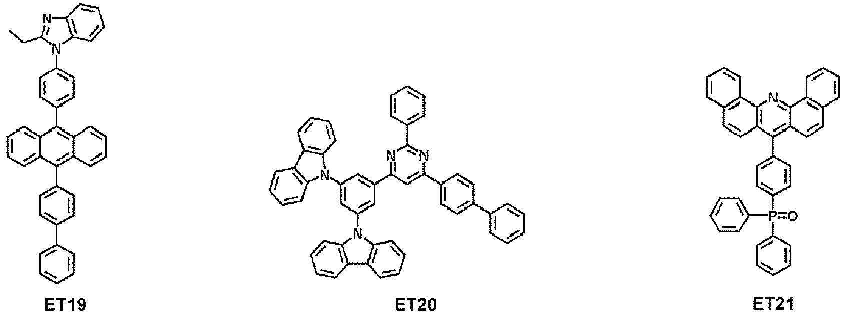

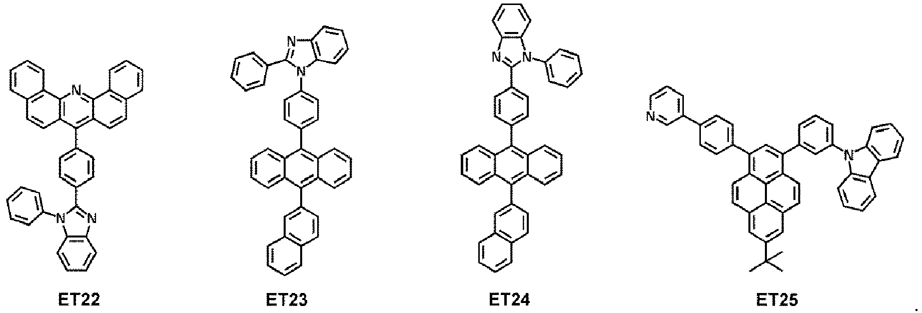

A thickness of the electron transport layer may be in a range of about 100 Å to about 1,000 Å, for example, about 150 Å to about 400 Å, about 150 Å to about 500 Å, about 200 Å to about 600 Å, about 300 Å to about 700 Å, about 400 Å to about 800 Å, or about 500 Å to about 900 Å. While not wishing to be bound by theory, it is understood that when the thickness of the electron transport layer is within these ranges, satisfactory electron transport characteristics may be obtained without a substantial increase in driving voltage.

The electron transport layer may further include, in addition to the materials described above, a metal-containing material.

The metal-containing material may include a Li complex. The Li complex may include, for example, Compound ET-D1 or ET-D2:

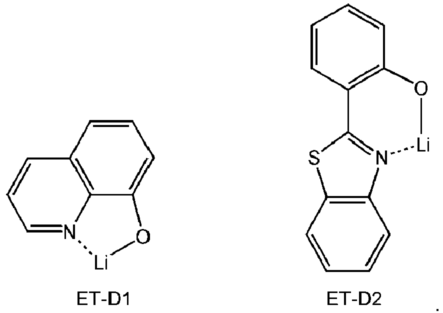

The electron transport region may include an electron injection layer that promotes the flow of electrons from the second electrode 19 thereinto.

The electron injection layer may include LiF, NaCl, CsF, Li₂O, BaO, or a combination thereof.

A thickness of the electron injection layer may be in a range of about 1 Å to about 100 Å, and, for example, about 2 Å to about 80 Å, about 3 Å to about 90 Å, about 10 Å to about 90 Å, or about 50 Å to about 90 Å. While not wishing to be bound by theory, it is understood that when the thickness of the electron injection layer is within these ranges, satisfactory electron injection characteristics may be obtained without a substantial increase in driving voltage.

The second electrode 19 is arranged on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. To manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

In an embodiment, the organic light-emitting device may be included in an electronic apparatus. Thus, an aspect of the present disclosure provides an electronic apparatus including the organic light-emitting device. The electronic apparatus may include, for example, a display, an illuminator, a sensor, and the like.

An aspect of the present disclosure provides a diagnostic composition including at least one organometallic compound represented by Formula 1.

The organometallic compound represented by Formula 1 provides high luminescence efficiency. In an embodiment, the diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each independently unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, and a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof are an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group are a cyclopropyl group, a cyclobutyl group, a cyclopentyl group, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monocyclic group that includes at least one hetero atom selected from N, O, P, Si, S, Se, Ge, and B as a ring-forming atom other than carbon, and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that has 3 to 10 carbon atoms and at least one carbon-carbon double bond in the ring thereof and no aromaticity, and examples thereof are a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom other than carbon, 1 to 10 carbon atoms, and at least one carbon-carbon double bond in its ring. Examples of the C₁-C₁₀ heterocycloalkenyl group are a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The term "C₇-C₆₀ alkylaryl group" as used herein refers to a C₆-C₆₀ aryl group substituted with at least one C₁-C₆₀ alkyl group, and the term "C₇-C₆₀ arylalkyl group" as used herein indicates -A₁₀₄A₁₀₅ (wherein A₁₀₅ is the C₆-C₅₉ aryl group and A₁₀₄ is the C₁-C₅₃ alkylene group).

The term "C₁-C₆₀ heteroaryl group" as used herein refers to a monovalent group having at least one hetero atom selected from N, O, P, Si, S, Se, Ge, and B as a ring-forming atom instead of a carbon atom and a cyclic aromatic system having 1 to 60 carbon atoms, and the term "C₁-C₆₀ heteroarylene group" as used herein refers to a divalent group having at least one hetero atom selected from N, O, P, Si, S, Se, Ge, and B as a ring-forming atom instead of carbon and a cyclic aromatic system having 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the two or more rings may be fused to each other.

The term "C₂-C₆₀ alkylheteroaryl group" as used herein refers to a C₁-C₆₀ heteroaryl group substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the term "C₆-C₆₀ arylthio group" as used herein indicates -SA₁₀₃ (wherein A₁₀₃ indicates the C₆-C₆₀ aryl group), and the term "C₁-C₆₀ alkylthio group" as used herein indicates -SA₁₀₄ (wherein A₁₀₄ indicates the C₁-C₆₀ alkyl group).

The term "C₁-C₆₀ heteroaryloxy group" as used herein refers to -OA₁₀₆ (wherein A₁₀₆ is the C₂-C₆₀ heteroaryl group), the term "C₁-C₆₀ heteroarylthio group" as used herein indicates -SA₁₀₇ (wherein A₁₀₇ is the C₁-C₆₀ heteroaryl group), and the term "C₂-C₆₀ heteroarylalkyl group" as used herein refers to -A₁₀₈A₁₀₉ (A₁₀₉ is a C₁-C₅₉ heteroaryl group, and A₁₀₈ is a C₁-C₅₉ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. An example of the monovalent non-aromatic condensed polycyclic group is a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, a heteroatom selected from N, O, P, Si, S, Se, Ge, and B, other than carbon atoms, as a ring-forming atom, and no aromaticity in its entire molecular structure. An example of the monovalent non-aromatic condensed heteropolycyclic group is a carbazolyl group. The term "divalent non-aromatic heterocondensed polycyclic group" as used herein refers to a divalent group having the same structure as a monovalent non-aromatic heterocondensed polycyclic group.

The term "C₃-C₃₀ carbocyclic group" as used herein refers to a saturated or unsaturated cyclic group having, as a ring-forming atom, 3 to 30 carbon atoms only. The C₃-C₃₀ carbocyclic group may be a monocyclic group or a polycyclic group. Examples of the "C₃-C₃₀ carbocyclic group (unsubstituted or substituted with at least one R₁₀ₐ)" are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group (,each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. Examples of the "C₁-C₃₀ heterocyclic group (unsubstituted or substituted with at least one R₁₀ₐ)" are a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group (, each unsubstituted or substituted with at least one R₁₀ₐ).

Examples of the "C₃-C₃₀ carbocyclic group" and the "C₁-C₃₀ heterocyclic group" are i) first ring, ii) a second ring, iii) a condensed cyclic group in which two or more first rings are condensed with each other, iv) a condensed cyclic group in which two or more second rings are condensed with each other, or v) a condensed cyclic group in which at least one first ring and at least one second ring are condensed with each other,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group. Examples the "fluorinated C₁ alkyl group (that is, the fluorinated methyl group)" are -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein are not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. Examples of the "deuterated C₁ alkyl group (that is, a deuterated methyl group)" are -CD₃, -CD₂H, and -CDH₂, and an example of the "deuterated C₃-C₁₀ cycloalkyl group" is Formula 10-501. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, each hydrogen included therein is not substituted with deuterium.

The term "(C₁-C₂₀ alkyl)'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of the (C₁ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group," in which, in each group, at least one of ring-forming carbon atoms is substituted with nitrogen.

Substituents of the substituted C₃-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₇-C₆₀ arylalkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroarylalkyl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each independently substituted with deuterium, -F, -Cl, -Br, -I, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a C₂-C₆₀ alkyl heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a C₂-C₆₀ alkyl heteroaryl group, a monovalent non-aromatic condensed polycyclic group, or a monovalent non-aromatic condensed heteropolycyclic group, each independently unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a C₂-C₆₀ alkyl heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or - P(Q₃₈)(Q₃₉); or
a combination thereof,
wherein Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₇-C₆₀ arylalkyl group, a C₁-C₆₀ heteroaryl group; a C₁-C₆₀ heteroaryloxy group, a C₁-C₆₀ heteroarylthio group, a C₂-C₆₀ heteroarylalkyl group, a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each independently unsubstituted or substituted with deuterium, a C₁-C₁₀ alkyl group, a phenyl group, or a combination thereof.

The term "room temperature" as used herein refers to about 25 °C.

The term "biphenyl group" refers to a monovalent group in which two benzene groups are linked via a single bond.

The term "terphenyl group" refers to a monovalent group in which three benzene groups are linked via a single bond.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Examples

### Synthesis Example 1 (Compound 182)

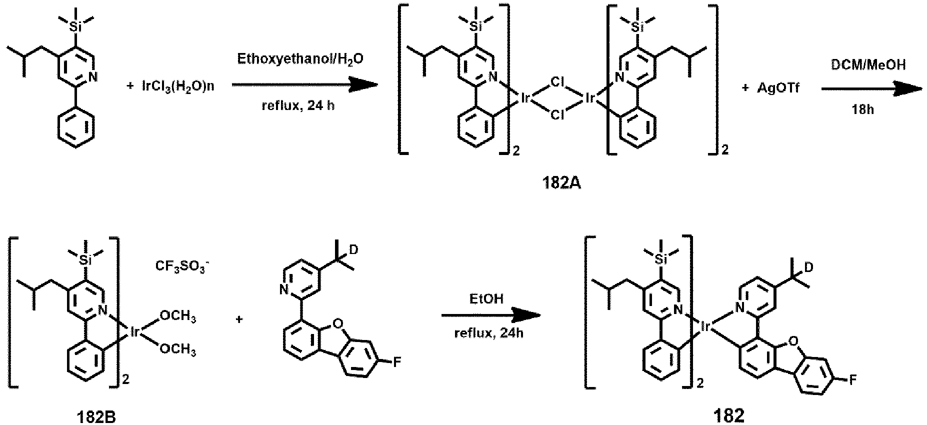

### Synthesis of Compound 182A

4-isobutyl-2-phenyl-5-(trimethylsilyl)pyridine) (3.0 gram (g), 10.6 millimole (mmol)) and iridium chloride (IrCl₃(H₂O)ₙ) (1.7 g, 4.8 mmol) are mixed with 120 milliliters (mL) of ethoxyethanol and 40 mL of distilled water. The mixed solution was stirred under reflux for 24 hours. Then, the reaction temperature was lowered to room temperature. The produced solid was separated by filtration, washed thoroughly with water/methanol/hexane in this stated order, and dried in a vacuum oven, so as to obtain 3.1 g (yield of 81 %) of Compound 182A.

### Synthesis of Compound 182B

Compound 182A (1.4 g, 0.9 mmol) was mixed with 120 mL of dichloromethane, and a mixture of silver trifluoromethanesulfonate (AgOTf) (0.45 g, 1.8 mmol) and 40 mL of methanol was added thereto. Afterwards, the resultant mixed solution was stirred for 18 hours while blocking light with aluminum foil, and then, filtered through Celite to remove the resultant solid. The filtrate was decompressed to obtain a solid (Compound 182B), which was used in the next reaction without performing any additional purification process thereon.

### Synthesis of Compound 182

Compound 182B (1.5 g, 1.6 mmol) and 2-(7-fluorodibenzo[b,d]furan-4-yl)-4-(propan-2-yl-2-d)pyridine (0.55 g, 1.8 mmol) were mixed with 50 mL of ethanol. The mixed solution was stirred under reflux for 24 hours, and the reaction temperature was lowered to room temperature. The obtained mixture was decompressed, and the solid produced therefrom was subjected to column chromatography (eluent: hexane and ethyl acetate), so as to obtain 0.64 g (yield of 39 %) of Compound 182. The obtained compound was identified by Mass spectrum and HPLC analysis.

HRMS(MALDI) calcd for C₅₆H₆₂DFIrN₃OSi₂: m/z 1062.4186 Found: 1062.4184

### Synthesis Example 2 (Compound 486)

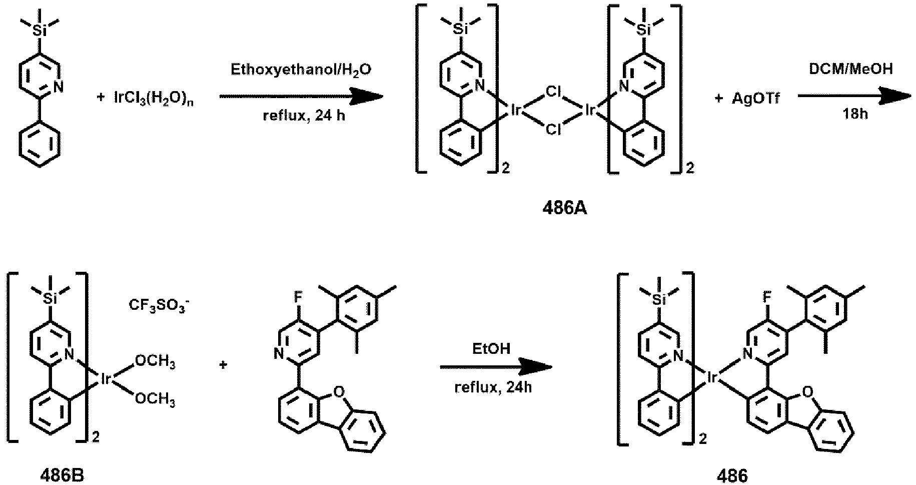

### Synthesis of Compound 486A

2.8 g (yield of 83 %) of Compound 486A was obtained in the same manner as in the synthesis of Compound 182A of Synthesis Example 1, except that 2-phenyl-5-(trimethylsilyl)pyridine was used instead of 4-isobutyl-2-phenyl-5-(trimethylsilyl)pyridine.

### Synthesis of Compound 486B

Compound 486B was obtained in the same manner as in the synthesis of Compound 182B of Synthesis Example 1, except that Compound 486A was used instead of Compound 182A. Compound 486B thus obtained was used in the next reaction without performing any additional purification process thereon.

### Synthesis of Compound 486

0.46 g (yield of 26 %) of Compound 486 was obtained in the same manner as in the synthesis of Compound 182 of Synthesis Example 1, except that Compound 486B was used instead of Compound 182B and 2-(dibenzo[b,d]furan-4-yl)-5-fluoro-4-mesitylpyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₅₄H₅₁FIrN₃OSi₂: m/z 1025.3184 Found: 1025.3181

### Synthesis Example 3 (Compound 672)

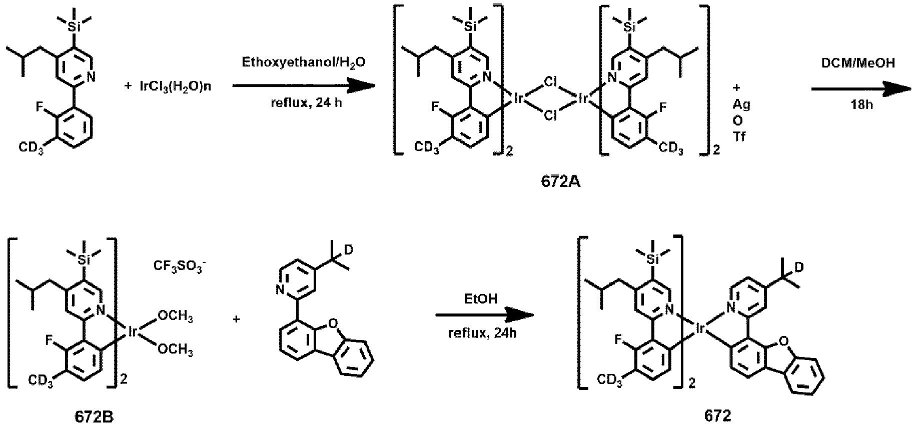

### Synthesis of Compound 672A

2.2 g (yield of 79 %) of Compound 672A was obtained in the same manner as in the synthesis of Compound 182A of Synthesis Example 1, except that 2-(2-fluoro-3-(methyl-d₃)phenyl)-4-isobutyl-5-(trimethylsilyl)pyridine was used instead of 4-isobutyl-2-phenyl-5-(trimethylsilyl)pyridine.

### Synthesis of Compound 672B

Compound 672B was obtained in the same manner as in the synthesis of Compound 182B of Synthesis Example 1, except that Compound 672A was used instead of Compound 182A. Compound 672B thus obtained was used in the next reaction without performing any additional purification process thereon.

### Synthesis of Compound 672

0.49 g (yield of 32 %) of Compound 672 was obtained in the same manner as in the synthesis of Compound 182 of Synthesis Example 1, except that Compound 672B was used instead of Compound 182B and 2-(dibenzo[b,d]furan-4-yl)-4-(propan-2-yl-2-d)pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₆₈H₈₉D₇F₂IrN₃OSi₂: m/z 1114.4781 Found: 1114.4785

### Synthesis Example 4 (Compound 943)

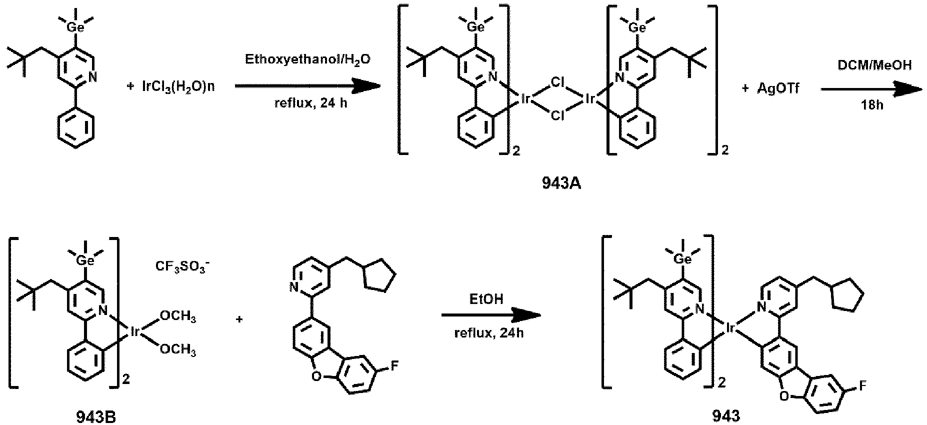

### Synthesis of Compound 943A

3.6 g (yield of 84 %) of Compound 943A was obtained in the same manner as in the synthesis of Compound 182A of Synthesis Example 1, except that 4-neopentyl-2-phenyl-5-(trimethylgermyl)pyridine was used instead of 4-isobutyl-2-phenyl-5-(trimethylsilyl)pyridine.

### Synthesis of Compound 943B

Compound 943B was obtained in the same manner as in the synthesis of Compound 182B of Synthesis Example 1, except that Compound 943A was used instead of Compound 182A. Compound 943B thus obtained was used in the next reaction without performing any additional purification process thereon.

### Synthesis of Compound 943

0.52 g (yield of 29 %) of Compound 943 was obtained in the same manner as in the synthesis of Compound 182 of Synthesis Example 1, except that Compound 943B was used instead of Compound 182B and 4-(cyclopentylmethyl)-2-(8-fluorodibenzo[b,d]furan-2-yl)pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₆₁H₇₁FGe₂IrN₃O: m/z 1221.3634 Found: 1221.3636

### Synthesis Example 5 (Compound 1034)

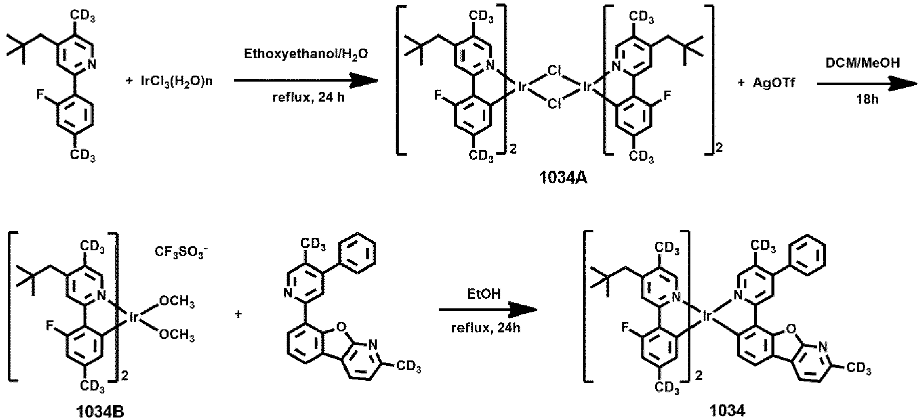

### Synthesis of Compound 1034A

2.9 g (yield of 86 %) of Compound 1034A was obtained in the same manner as in the synthesis of Compound 182A of Synthesis Example 1, except that 2-(2-fluoro-4-(methyl-d₃)phenyl)-5-(methyl-d₃)-4-neopentylpyridine was used instead of 4-isobutyl-2-phenyl-5-(trimethylsilyl)pyridine.

### Synthesis of Compound 1034B

Compound 1034B was obtained in the same manner as in the synthesis of Compound 182B of Synthesis Example 1, except that Compound 1034A was used instead of Compound 182A. Compound 1034B thus obtained was used in the next reaction without performing any additional purification process thereon.

### Synthesis of Compound 1034

0.42 g (yield of 28 %) of Compound 1034 was obtained in the same manner as in the synthesis of Compound 182 of Synthesis Example 1, except that Compound 1034B was used instead of Compound 182B and 2-(methyl-d₃)-8-(5-(methyl-d₃)-4-phenylpyridin-2-yl)benzofuro[2,3-b]pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₆₀H₄₁D₁₈F₂IrN₄O: m/z 1100.5416 Found: 1100.5413

### Synthesis Example 6 (Compound 1153)

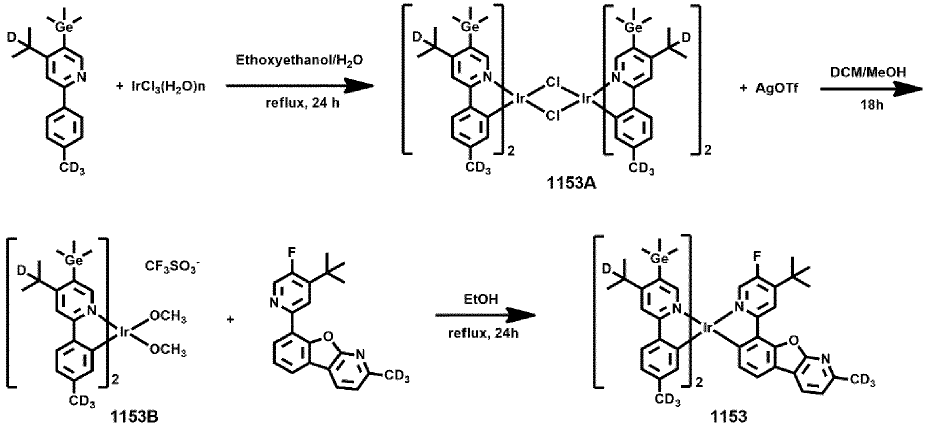

### Synthesis of Compound 1153A

3.2 g (yield of 85 %) of Compound 1153A was obtained in the same manner as in the synthesis of Compound 182A of Synthesis Example 1, except that 2-(4-(methyl-d₃)phenyl)-4-(propan-2-yl-2-d)-5-(trimethylgermyl)pyridine was used instead of 4-isobutyl-2-phenyl-5-(trimethylsilyl)pyridine.

### Synthesis of Compound 1153B

Compound 1153B was obtained in the same manner as in the synthesis of Compound 182B of Synthesis Example 1, except that Compound 1153A was used instead of Compound 182A. Compound 1153B thus obtained was used in the next reaction without performing any additional purification process thereon.

### Synthesis of Compound 1153

0.46 g (yield of 31 %) of Compound 1153 was obtained in the same manner as in the synthesis of Compound 182 of Synthesis Example 1, except that Compound 1153B was used instead of Compound 182B and 8-(4-(tert-butyl)-5-fluoropyridin-2-yl)-2-(methyl-d₃)benzofuro[2,3-b]pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₅₇H₅₅D₁₁FGe₂IrN₄O: m/z 1193.3964 Found: 1193.3961

### Synthesis Example 7 (Compound 1177)

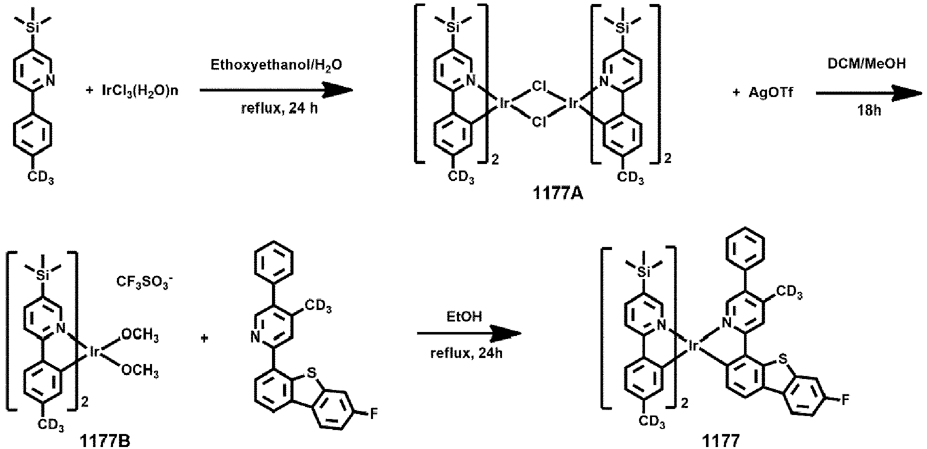

### Synthesis of Compound 1177A

4.5 g (yield of 87 %) of Compound 1177A was obtained in the same manner as in the synthesis of Compound 182A of Synthesis Example 1, except that 2-(4-(methyl-d₃)phenyl)-5-(trimethylsilyl)pyridine was used instead of 4-isobutyl-2-phenyl-5-(trimethylsilyl)pyridine.

### Synthesis of Compound 1177B

Compound 1177B was obtained in the same manner as in the synthesis of Compound 182B of Synthesis Example 1, except that Compound 1177A was used instead of Compound 182A. Compound 1177B thus obtained was used in the next reaction without performing any additional purification process thereon.

### Synthesis of Compound 1177

0.43 g (yield of 27 %) of Compound 1177 was obtained in the same manner as in the synthesis of Compound 182 of Synthesis Example 1, except that Compound 1177B was used instead of Compound 182B and 2-(7-fluorodibenzo[b,d]thiophen-4-yl)-4-(methyl-d₃)-5-phenylpyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₅₄H₄₂D₉FIrN₃SSi₂. m/z 1050.3520 Found: 1050.3518

### Synthesis Example 8 (Compound 1295)

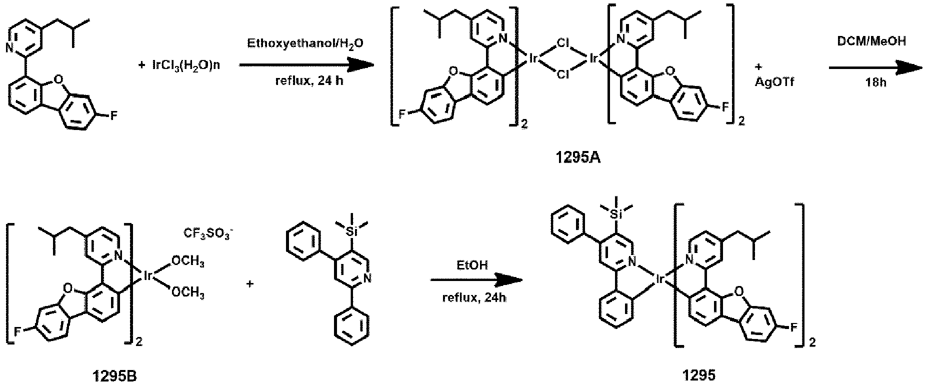

### Synthesis of Compound 1295A

4.5 g (yield of 86 %) of Compound 1295A was obtained in the same manner as in the synthesis of Compound 182A of Synthesis Example 1, except that 2-(7-fluorodibenzo[b,d]furan-4-yl)-4-isobutylpyridine was used instead of 4-isobutyl-2-phenyl-5-(trimethylsilyl)pyridine.

### Synthesis of Compound 1295B

Compound 1295B was obtained in the same manner as in the synthesis of Compound 182B of Synthesis Example 1, except that Compound 1295A was used instead of Compound 182A. Compound 1295B thus obtained was used in the next reaction without performing any additional purification process thereon.

### Synthesis of Compound 1295

0.45 g (yield of 35 %) of Compound 1295 was obtained in the same manner as in the synthesis of Compound 182 of Synthesis Example 1, except that Compound 1295B was used instead of Compound 182B and 2,4-diphenyl-5-(trimethylsilyl)pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₆₂H₅₄F₂IrN₃O₂Si: m/z 1131.3583 Found: 1131.3586

### Synthesis Example 9 (Compound 1382)

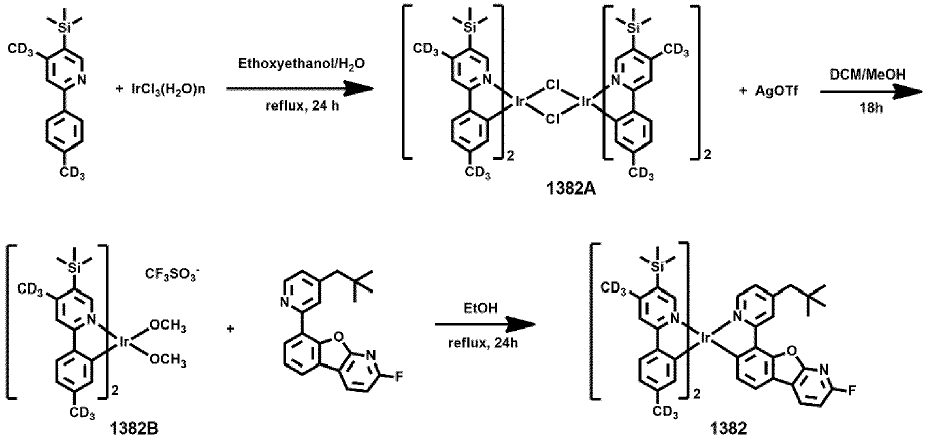

### Synthesis of Compound 1382A

3.8 g (yield of 85 %) of Compound 1382A was obtained in the same manner as in the synthesis of Compound 182A of Synthesis Example 1, except that 4-(methyl-d₃)-2-(4-(methyl-d₃)phenyl)-5-(trimethylsilyl)pyridine was used instead of 4-isobutyl-2-phenyl-5-(trimethylsilyl)pyridine.

### Synthesis of Compound 1382B

Compound 1382B was obtained in the same manner as in the synthesis of Compound 182B of Synthesis Example 1, except that Compound 1382A was used instead of Compound 182A. Compound 1382B thus obtained was used in the next reaction without performing any additional purification process thereon.

### Synthesis of Compound 1382

0.42 g (yield of 34 %) of Compound 1382 was obtained in the same manner as in the synthesis of Compound 182 of Synthesis Example 1, except that Compound 1382B was used instead of Compound 182B and 2-fluoro-8-(4-neopentylpyridin-2-yl)benzofuro[2,3-b]pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₆₃H₄₆D₁₂FIrN₄OSi₂: m/z 1046.4516 Found: 1046.4513

### Comparative Synthesis Example A (Compound A)

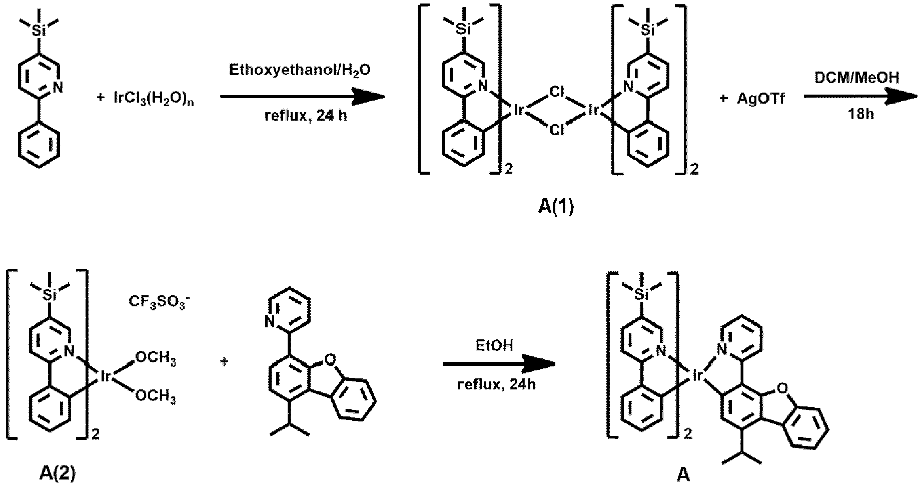

### Synthesis of Compound A(1)

2.1 g (yield of 82 %) of Compound A(1) was obtained in the same manner as in the synthesis of Compound 182A of Synthesis Example 1, except that 2-phenyl-5-(trimethylsilyl)pyridine was used instead of 4-isobutyl-2-phenyl-5-(trimethylsilyl)pyridine.

### Synthesis of Compound A(2)

Compound A(2) was obtained in the same manner as in the synthesis of Compound 182B of Synthesis Example 1, except that Compound A(1) was used instead of Compound 182A. Compound A(2) thus obtained was used in the next reaction without performing any additional purification process thereon.

### Synthesis of Compound A

0.27 g (yield of 34 %) of Compound A was obtained in the same manner as in the synthesis of Compound 182 of Synthesis Example 1, except that Compound A(2) was used instead of Compound 182B and 2-(1-isopropyldibenzo[b,d]furan-4-yl)pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₄₈H₄₈IrN₃OSi₂: m/z 931.2965 Found: 931.2968

### Comparative Synthesis Example B (Compound B)

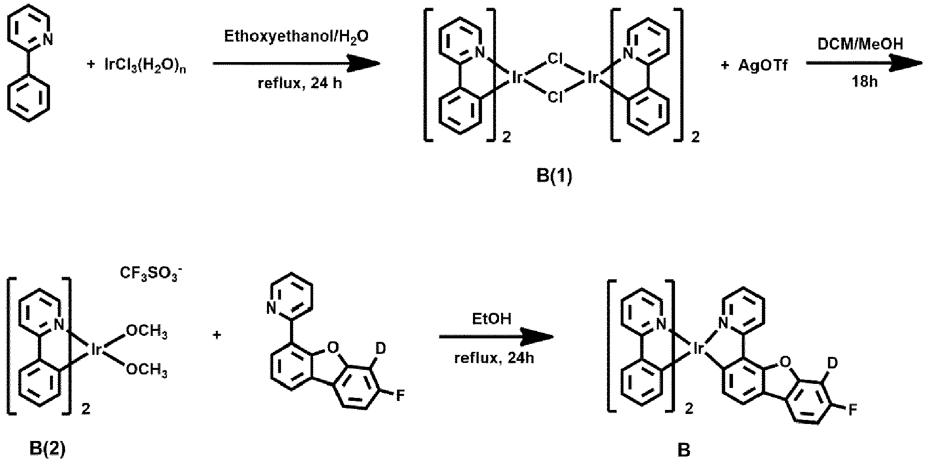

### Synthesis of Compound B(1)

2.9 g (yield of 84 %) of Compound was obtained in the same manner as in the synthesis of Compound 182A of Synthesis Example 1, except that 2-phenylpyridine was used instead of 4-isobutyl-2-phenyl-5-(trimethylsilyl)pyridine.

### Synthesis of Compound B(2)

Compound B(2) was obtained in the same manner as in the synthesis of Compound 182B of Synthesis Example 1, except that Compound B(1) was used instead of Compound 182A. Compound B(2) thus obtained was used in the next reaction without performing any additional purification process thereon.

### Synthesis of Compound B

0.35 g (yield of 41 %) of Compound B was obtained in the same manner as in the synthesis of Compound 182 of Synthesis Example 1, except that Compound B(2) was used instead of Compound 182B and 2-(7-fluorodibenzo[b,d]furan-4-yl-6-d)pyridine was used instead of 2-(7-fluorodibenzo[b,d]furan-4-yl)-4-(propan-2-yl-2-d)pyridine. The obtained compound was identified by Mass spectrum and HPLC analysis.

HRMS(MALDI) calcd for C₃₉H₂₄DFIrN₃O: m/z 764.1674 Found: 764.1671

### Example 1

As an anode, a glass substrate with ITO/Ag/ITO deposited thereon to a thickness of 70 Å/1,000 Å/70 Å was cut to a size of 50 millimeters (mm) x 50 mm x 0.5 mm, sonicated with isopropyl alcohol and pure water each for 5 minutes, and then cleaned by exposure to ultraviolet rays and ozone for 30 minutes. Then the resultant glass substrate was loaded onto a vacuum deposition apparatus.

2-TNATA was vacuum-deposited on the anode to form a hole injection layer having a thickness of 600 Å, and 4,4'-bis[N-(1-naphthyl)-N-phenylamino] biphenyl (hereinafter referred to as NPB) was vacuum-deposited on the hole injection layer to form a hole transport layer having a thickness of 1,350 Å.

Subsequently, CBP (host) and Compound 182 (dopant) were co-deposited at a weight ratio of 98:2 on the hole transport layer to form an emission layer having a thickness of 400 Å.

Thereafter, BCP was vacuum-deposited on the emission layer to form a hole blocking layer having a thickness of 50 Å, Alq₃ was vacuum-deposited on the hole blocking layer to form an electron transport layer having a thickness of 350 Å, LiF was vacuum-deposited on the electron transport layer to form an electron injection layer having a thickness of 10 Å, and Mg and Ag were co-deposited at a weight ratio of 90:10 on the electron injection layer to form a cathode having a thickness of 120 Å, thereby completing an organic light-emitting device.

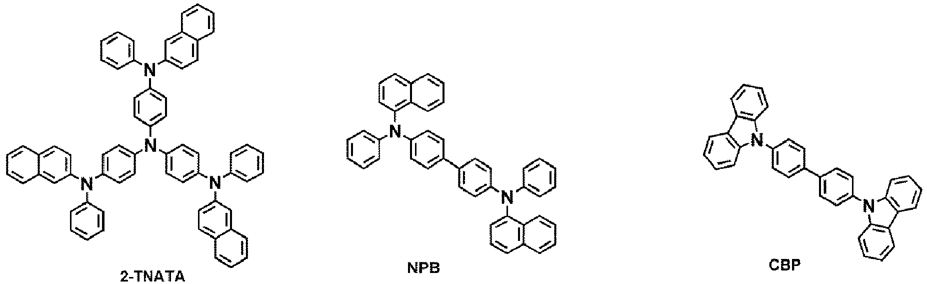

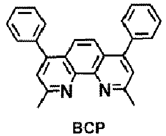

### Examples 2 to 9 and Comparative Examples A and B

Organic light-emitting devices were manufactured in the same manner as in Example 1, except that Compounds shown in Table 2 were each used instead of Compound 182 as a dopant in forming an emission layer.

### Evaluation Example 1: Characterization of organic light-emitting device

Regarding the organic light-emitting devices of Examples 1 to 9 and Comparative Examples A and B, the driving voltage, maximum value of external quantum efficiency (Max EQE, %), and lifespan (LT₉₇, hr.) were evaluated, and results are shown in Table 2. A current-voltage meter (Keithley 2400) and a luminescence meter (Minolta Cs-1,000A) were used as an apparatus for evaluation, and the lifespan (T₉₇) (at 3500 candela per square meter (cd/m²) or nit) was evaluated by measuring the amount of time that elapsed until luminance was reduced to 97% of the initial luminance of 100%, and the results were expressed as a relative value (%).

**Table 2**

| | Compound No. as a dopant in emission layer | Max EQE (relative value) | LT₉₇ (relative value) (at 3500 cd/m²) |
|---|---|---|---|
| Example 1 | 182 | 93% | 51% |
| Example 2 | 486 | 100% | 57% |
| Example 3 | 672 | 93% | 34% |
| Example 4 | 943 | 88% | 95% |
| Example 5 | 1034 | 90% | 30% |
| Example 6 | 1153 | 95% | 42% |
| Example 7 | 1177 | 96% | 100% |
| Example 8 | 1295 | 100% | 58% |
| Example 9 | 1382 | 93% | 63% |
| Comparative Example A | A | 75% | 16% |
| Comparative Example B | B | 79% | 8% |

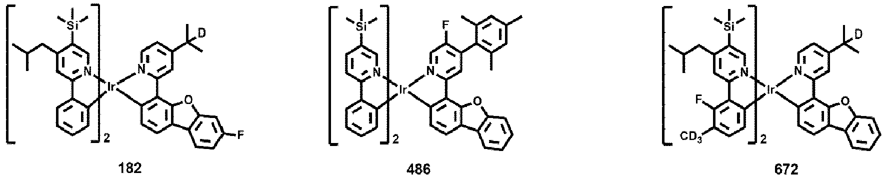

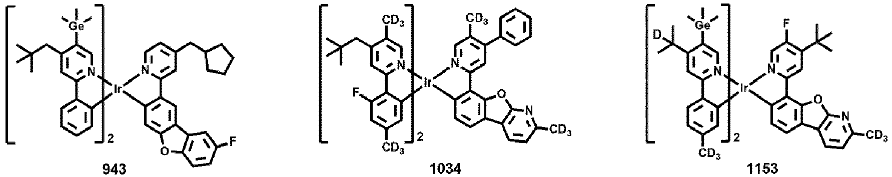

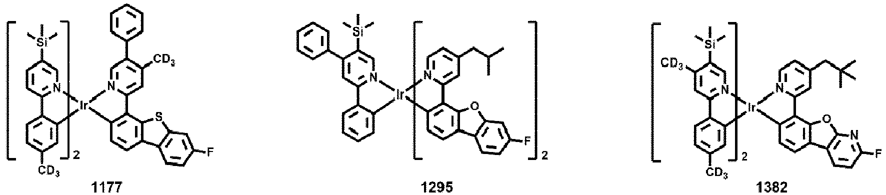

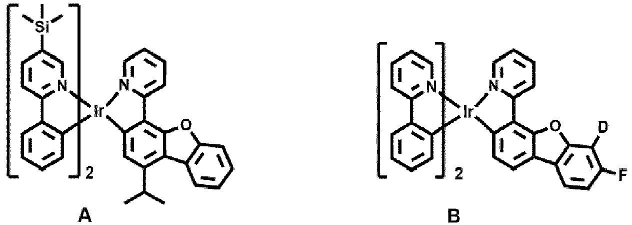

From Table 2, it was confirmed that the organic light-emitting devices of Examples 1 to 9 had improved EQE and improved lifespan characteristics compared to the organic light-emitting devices of Comparative Examples A and B.

According to the one or more embodiments, an organometallic compound may have improved electrical characteristics and improved durability, so that an electronic device, for example, an organic light-emitting device, including such an organometallic compound may have improved external quantum efficiency (EQE) and improved lifespan characteristics. Therefore, the use of the organometallic compound may enable the embodiments of a high-quality organic light-emitting device and an electronic device including the same.

It should be understood that exemplary embodiments described in detail herein should be considered in a descriptive sense and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope of the present detailed description as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2A,
L₂ is a ligand represented by Formula 2B,
n1 and n2 are each independently 1 or 2, wherein, when n1 is 2, two L₁(s) are identical to or different from each other, and when n2 is 2, two L₂(s) are identical to or different from each other,
the sum of n1 and n2 is 2 or 3, and
L₁ and L₂ are different from each other: 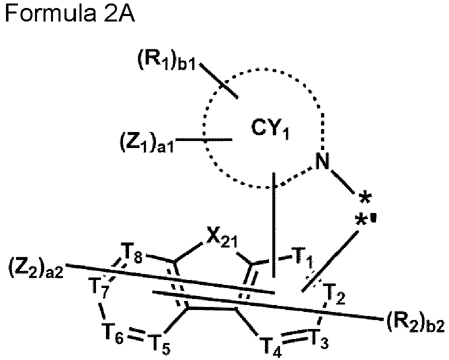 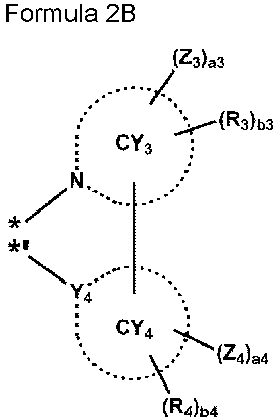 wherein, in Formulae 2A and 2B,
Y₄ is C or N,
X₂₁ is O, S, Se, S(=O), N(R₂₉), C(R₂₉)(R₃₀), or Si(R₂₉)(R₃₀),
T₁ to T₄ are each independently C, N, carbon bonded to ring CY₁, or carbon bonded to M in Formula 1, wherein one of T₁ to T₄ is the carbon bonded to M in Formula 1, and one of the remaining groups T₁ to T₄ that is not bonded to M in Formula 1 is the carbon bonded to ring CY₁,
T₅ to T₈ are each independently C or N,
ring CY₁ and ring CY₃ are each independently a C₁-C₃₀ heterocyclic group,
ring CY₄ is a C₃-C₃₀ carbocyclic group or a C₁-C₃₀ heterocyclic group, Z₁, Z₃, and Z₄ are each independently a fluoro group or a fluorinated group,
Z₂ is a fluoro group, a fluorinated non-cyclic group, or a fluorinated saturated cyclic group,
a1, a3, and a4 are each independently an integer from 0 to 20, wherein a2 is an integer from 0 to 6, and the sum of a1, a2, a3, and a4 is 1 or more,
R₁ to R₄, R₂₉, and R₃₀ are each independently hydrogen, deuterium, -F, -Cl, - Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉),
b1, b3, and b4 are each independently an integer from 0 to 20, and b2 is an integer from 0 to 6,
when i) none of T₁ to T₈ in Formula 2A is N, ii) a2 in Formula 2A is not 0, and iii) Z₂ in Formula 2A is a fluoro group, then a) b3 in Formula 2B is not 0, and b) at least one of R₃(s) in the number of b3 in Formula 2B is -Si(Q₃)(Q₄)(Q₅) or -Ge(Q₃)(Q₄)(Q₅),
two or more of a plurality of R₁(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of R₂(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of R₃(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
two or more of a plurality of R₄(s) are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is the same as described in connection with R₁,
* and *' in Formulae 2A and 2B each indicate a binding site to M in Formula 1, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₇-C₆₀ arylalkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroarylalkyl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each independently substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, or a monovalent non-aromatic condensed heteropolycyclic group, each independently unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently: hydrogen; deuterium; -F; -CI; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₇-C₆₀ arylalkyl group; a C₁-C₆₀ heteroaryl group; a C₁-C₆₀ heteroaryloxy group; a C₁-C₆₀ heteroarylthio group; a C₂-C₆₀ heteroarylalkyl group; a monovalent non-aromatic condensed polycyclic group; or a monovalent non-aromatic condensed heteropolycyclic group.

2. The organometallic compound of claim 1, wherein
in Formula 1, M is Ir, and the sum of n1 and n2 is 3; or
in Formula 1, M is Pt, and the sum of n1 and n2 is 2.

3. The organometallic compound of claims 1 or 2, wherein
ring CY₁ and ring CY₃ are each independently a pyridine group, a pyrimidine group, a pyrazine group, a pyridazine group, a triazine group, a quinoline group, an isoquinoline group, a benzoquinoline group, a benzoisoquinoline group, a 5,6,7,8-tetrahydroisoquinoline group, a 5,6,7,8-tetrahydroquinoline group, or a pyridine group condensed with a norbornane group,
Y₄ is C, and
ring CY₄ is a benzene group, a naphthalene group, a 1,2,3,4-tetrahydronaphthalene group, a fluorene group, a carbazole group, a dibenzofuran group, a dibenzothiophene group, a dibenzosilole group, an azafluorene group, an azacarbazole group, an azadibenzofuran group, an azadibenzothiophene group, an azadibenzosilole group, or a benzene group condensed with a norbornane group.

4. The organometallic compound of any of claims 1-3, wherein
Z₁, Z₃, and Z₄ are each independently:
a fluoro group; or
a fluorinated C₁-C₂₀ alkyl group, a fluorinated C₃-C₁₀ cycloalkyl group, a fluorinated C₁-C₁₀ heterocycloalkyl group, a fluorinated phenyl group, or a fluorinated biphenyl group, each independently unsubstituted or substituted with deuterium, a cyano group, a C₁-C₂₀ alkyl group, a deuterated C₁-C₂₀ alkyl group, a C₃-C₁₀ cycloalkyl group, a deuterated C₃-C₁₀ cycloalkyl group, a C₁-C₁₀ heterocycloalkyl group, a deuterated C₁-C₁₀ heterocycloalkyl group, a phenyl group, a deuterated phenyl group, a biphenyl group, a deuterated biphenyl group, or a combination thereof, and
Z₂ is:
a fluoro group; or
a fluorinated C₁-C₂₀ alkyl group, a fluorinated C₃-C₁₀ cycloalkyl group, or a fluorinated C₁-C₁₀ heterocycloalkyl group, each independently unsubstituted or substituted with deuterium, a cyano group, a C₁-C₂₀ alkyl group, a deuterated C₁-C₂₀ alkyl group, a C₃-C₁₀ cycloalkyl group, a deuterated C₃-C₁₀ cycloalkyl group, a C₁-C₁₀ heterocycloalkyl group, a deuterated C₁-C₁₀ heterocycloalkyl group, or a combination thereof.

5. The organometallic compound of any of claims 1-4, wherein
a1 is 1, and a2, a3, and a4 are each independently 0,
a2 is 1 or 2, and a1, a3, and a4 are each independently 0,
a3 is 1, and a1, a2, and a4 are each independently 0,
a4 is 1, and a1, a2, and a3 are each independently 0,
a2 and a4 are each independently 1, and a1 and a3 are each independently 0, or
a1 and a2 are each independently 1, and a3 and a4 are each independently 0.

6. The organometallic compound of any of claims 1-5, wherein
R₁ to R₄, R₂₉, and R₃₀ are each independently:
hydrogen, deuterium, or a cyano group;
a C₁-C₂₀ alkyl group unsubstituted or substituted with deuterium, a cyano group, a C₃-C₁₀ cycloalkyl group, a deuterated C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, a phenyl group, a deuterated phenyl group, a (C₁-C₂₀ alkyl)phenyl group, a deuterated (C₁-C₂₀ alkyl)phenyl group, a biphenyl group, a deuterated biphenyl group, a (C₁-C₂₀ alkyl)biphenyl group, a deuterated (C₁-C₂₀ alkyl)biphenyl group, or a combination thereof;
a C₃-C₁₀ cycloalkyl group, a C₁-C₁₀ heterocycloalkyl group, a phenyl group, or a biphenyl group, each independently unsubstituted or substituted with deuterium, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated a C₃-C₁₀ cycloalkyl group, a (C₁-C₂₀ alkyl)C₃-C₁₀ cycloalkyl group, a deuterated (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a deuterated (C₁-C₂₀ alkyl)C₁-C₁₀ heterocycloalkyl group, a phenyl group, a deuterated phenyl group, a (C₁-C₂₀ alkyl)phenyl group, a deuterated (C₁-C₂₀ alkyl)phenyl group, a biphenyl group, a deuterated biphenyl group, a (C₁-C₂₀ alkyl)biphenyl group, a deuterated (C₁-C₂₀ alkyl)biphenyl group, or a combination thereof; or
-Si(Q₃)(Q₄)(Q₅) or -Ge(Q₃)(Q₄)(Q₅).

7. The organometallic compound of any of claims 1-6, wherein in Formula 2B, b3 is not 0, and at least one of R₃(s) in the number of b3 is -Si(Q₃)(Q₄)(Q₅) or - Ge(Q₃)(Q₄)(Q₅); and/or
wherein the organometallic compound comprises at least one deuterium.

8. The organometallic compound of any of claims 1-7, wherein a group represented by 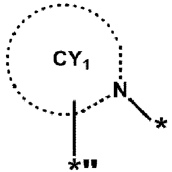 in Formula 2A is a group represented by one of Formulae CY1 (1) to CY1 (22): 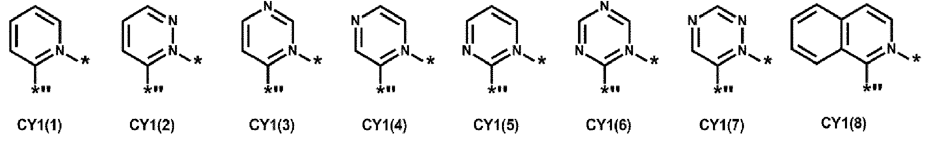 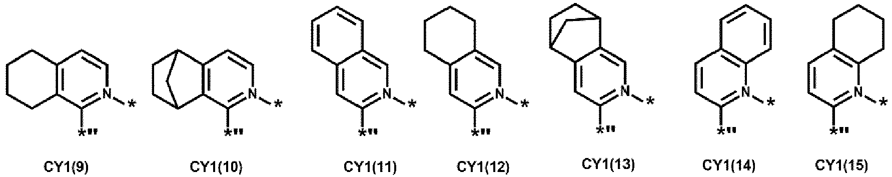 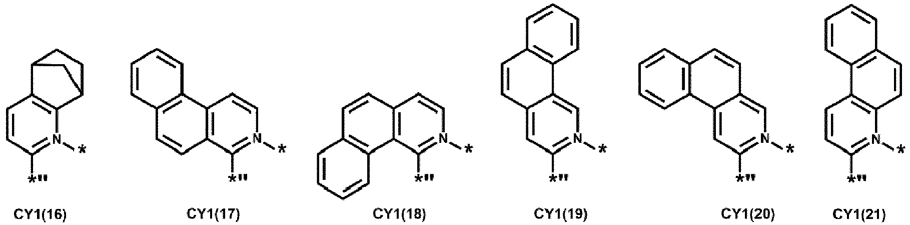 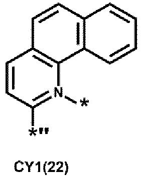 wherein, in Formulae CY1(1) to CY1(22), * indicates a binding site to M in Formula 1, and *" indicates a binding site to a neighboring carbon atom in Formula 2A; and/or wherein
a group represented by 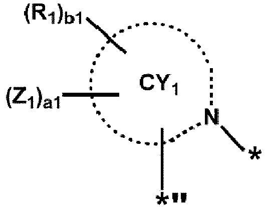 in Formula 2A is a group represented by one of Formulae CY1-1 to CY1-16 and CY1-1F to CY1-32F: 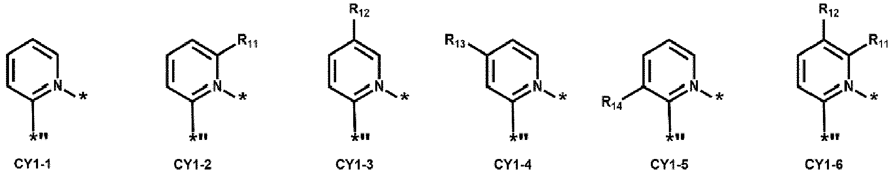 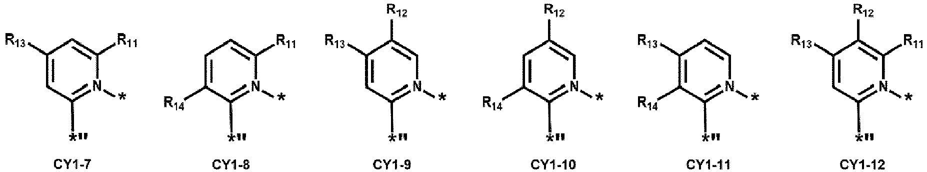 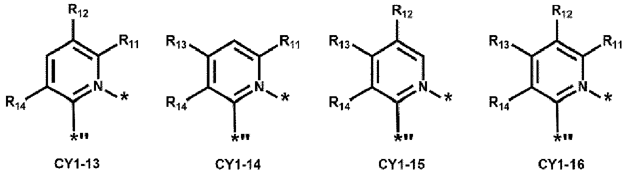 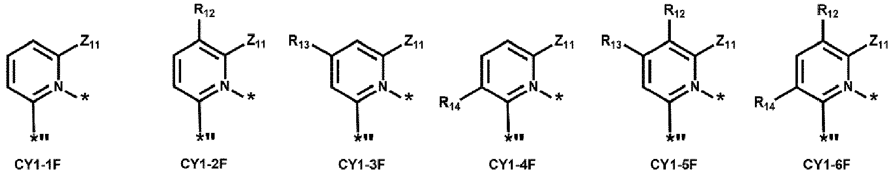 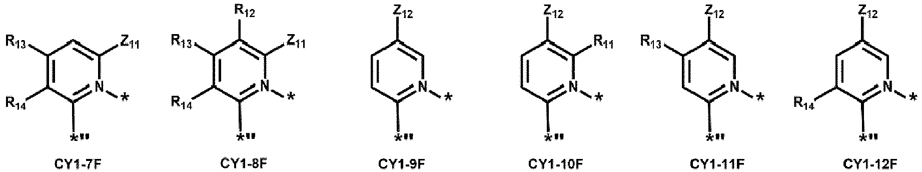 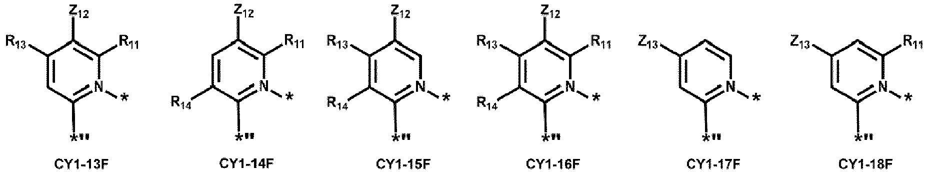 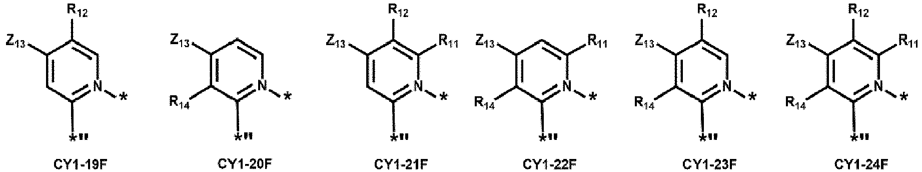 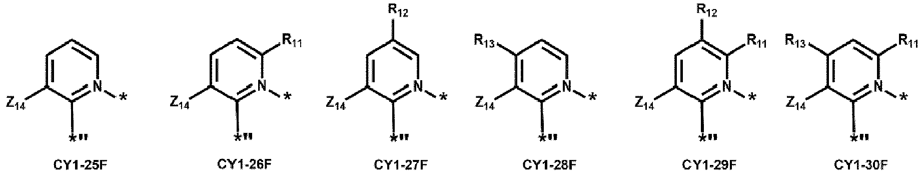 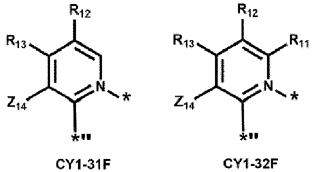
wherein, in Formulae CY1-1 to CY1-16 and CY1-1F to CY1-32F,
Z₁₁ to Z₁₄ are each the same as described in connection with Z₁ in claim 1,
R₁₁ to R₁₄ are each the same as described in connection with R₁ in claim 1, wherein each of R₁₁ to R₁₄ is not hydrogen,
* indicates a binding site to M in Formula 1, and
*" indicates a binding site to a neighboring carbon atom in Formula 2A.

9. The organometallic compound of any of claims 1-8, wherein a group represented by 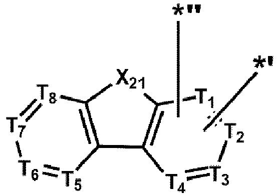 in Formula 2A is a group represented by one of Formulae CY2-1 to CY2-6: 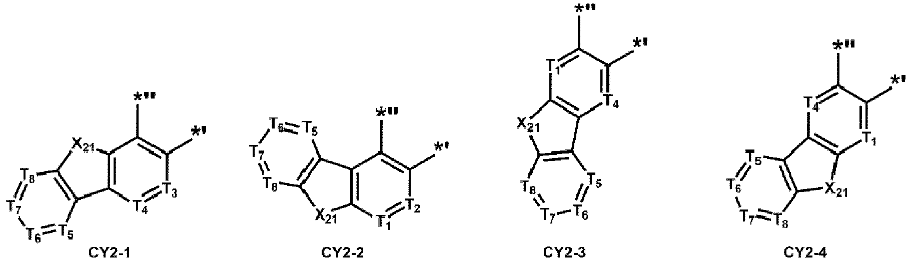 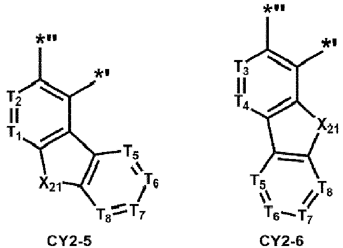
wherein, in Formulae CY2-1 to CY2-6, *' indicates a binding site to M in Formula 1, and *" indicates a binding site to ring CY₁ in Formula 2A; and/or
wherein
a group represented by 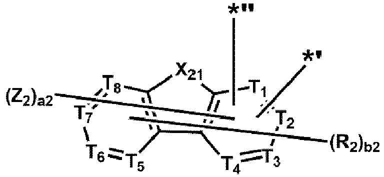 in Formula 2A is a group represented by one of Formulae CY2-1-1 to CY2-1-22, CY2-1-1N to CY2-1-16N, CY2-4-1 to CY2-4-22, CY2-4-1N to CY2-4-16N, CY2-1-1F to CY2-1-21F, CY2-1-1NF to CY2-1-15NF, CY2-4-1F to CY2-4-21F, and CY2-4-1NF to CY2-4-15NF: 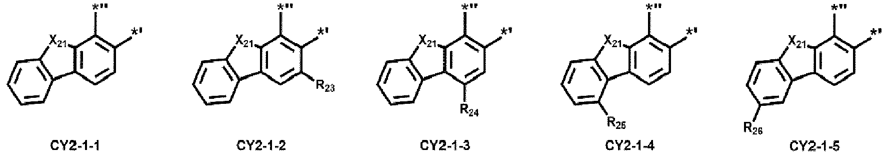 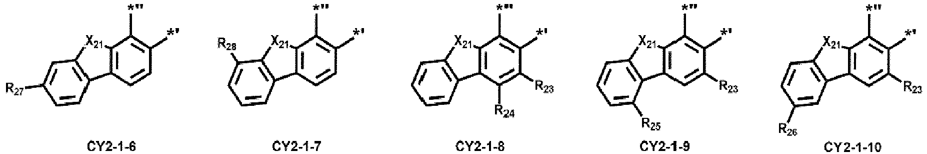 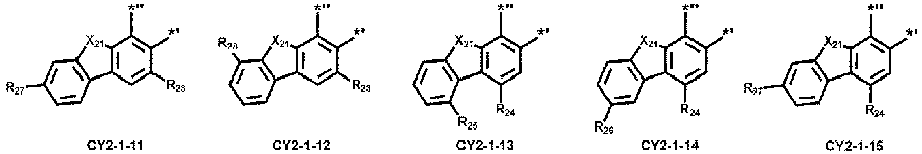 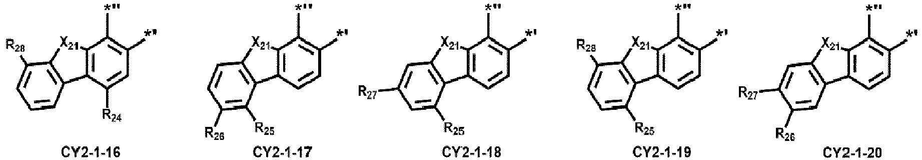 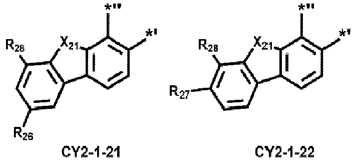 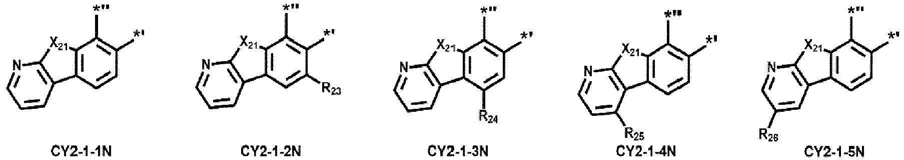 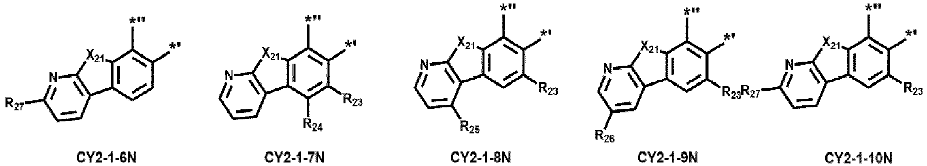 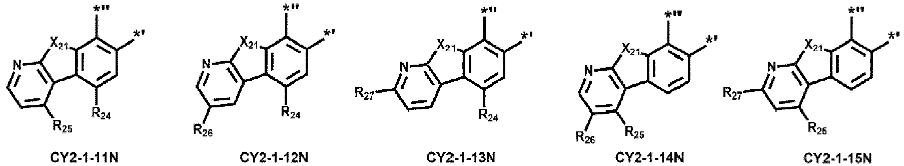 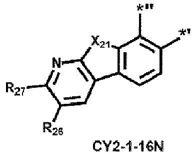 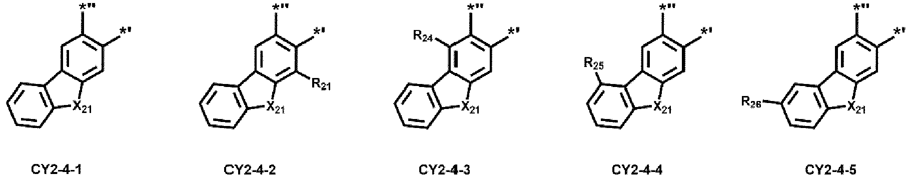 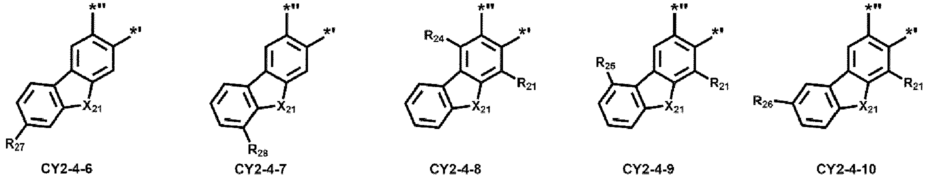 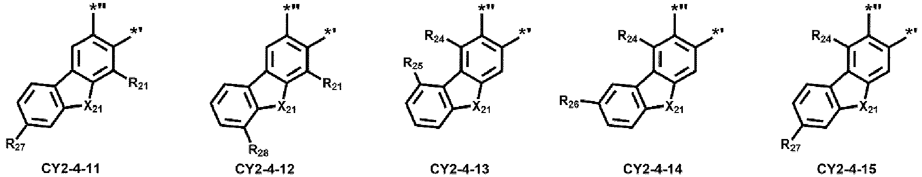 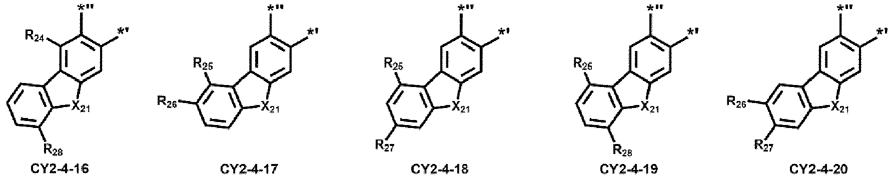 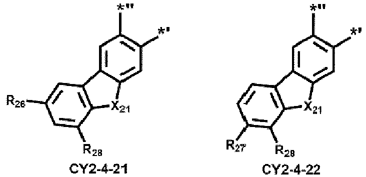 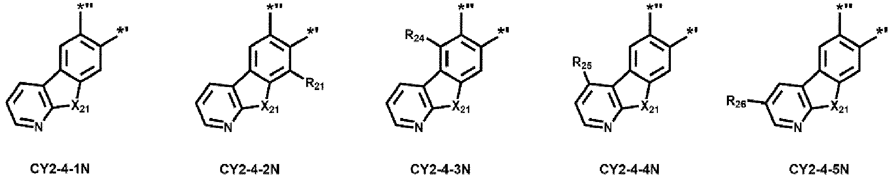 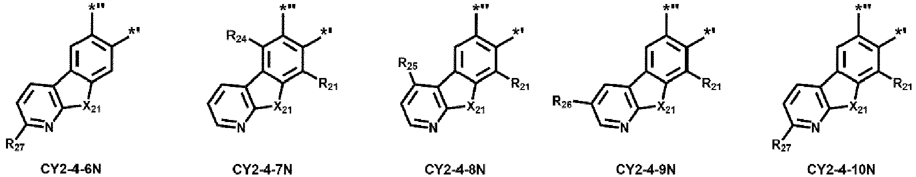 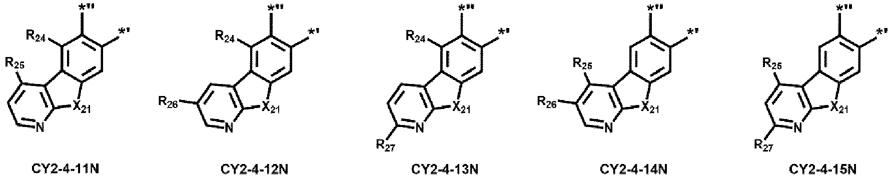 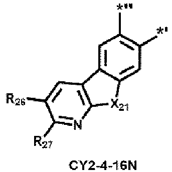 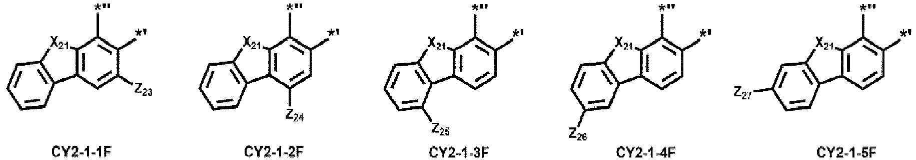 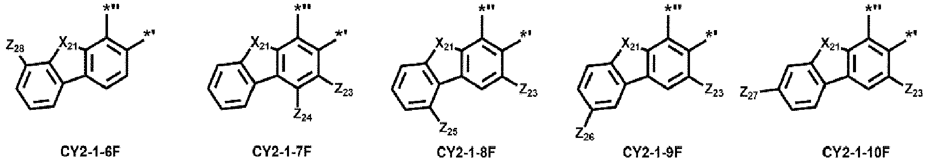 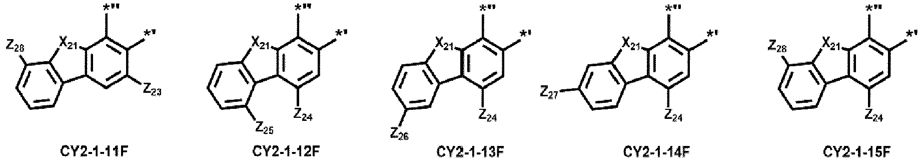 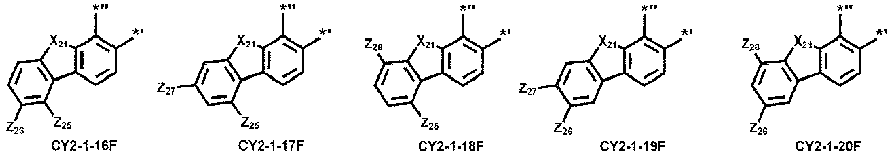 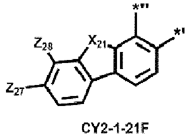 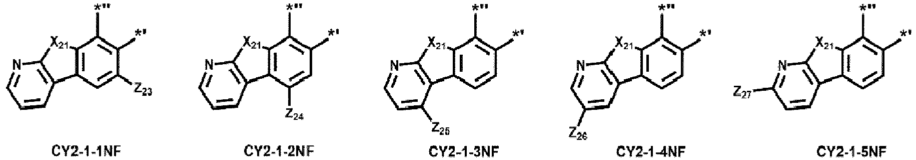 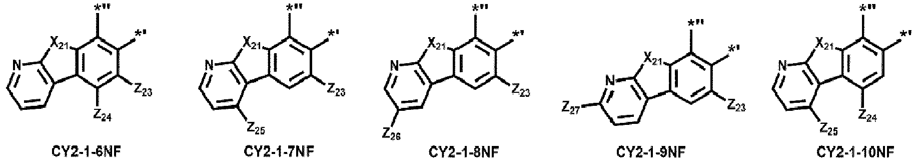 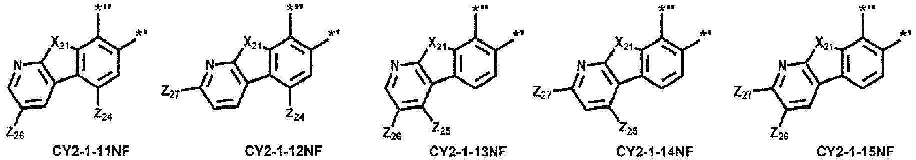 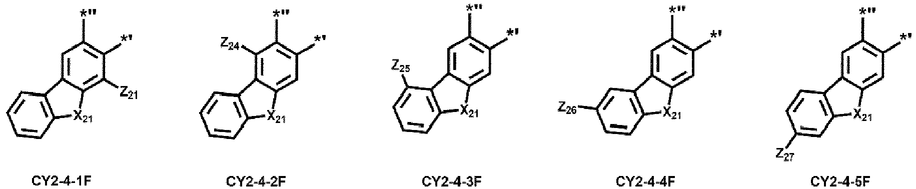 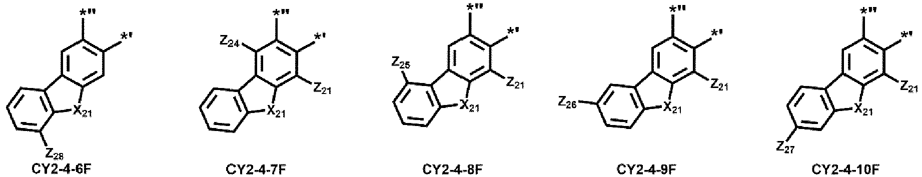 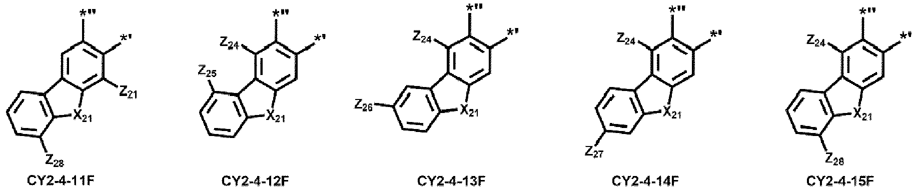 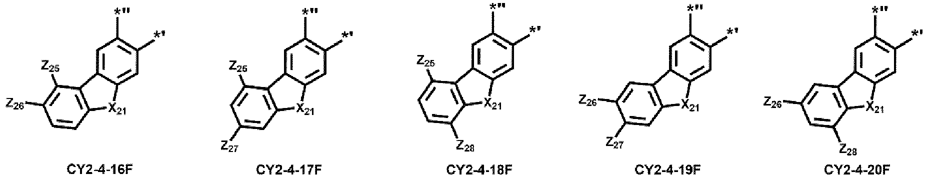 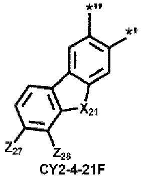 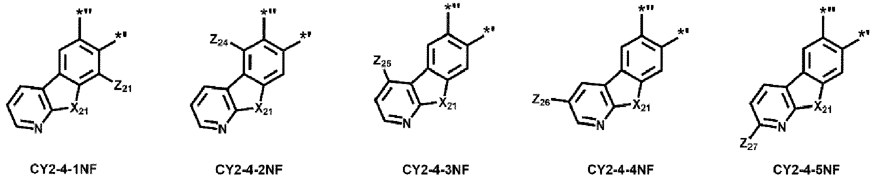 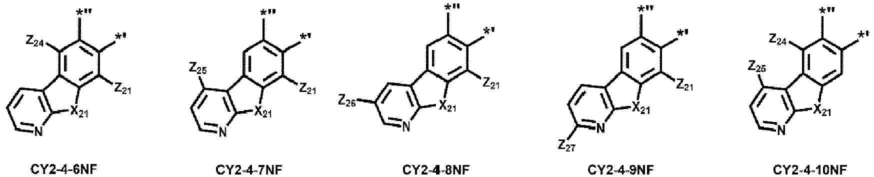 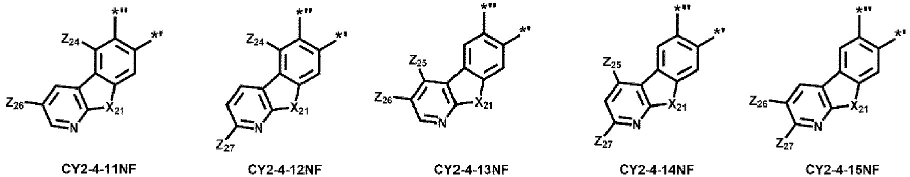
wherein, in Formulae CY2-1-1 to CY2-1-22, CY2-1-1N to CY2-1-16N, CY2-4-1 to CY2-4-22, CY2-4-1N to CY2-4-16N, CY2-1-1F to CY2-1-21F, CY2-1-1NF to CY2-1-15NF, CY2-4-1F to CY2-4-21F, and CY2-4-1 NF to CY2-4-15NF,
Z₂₁ to Z₂₈ are each the same as described in connection with Z₂ in claim 1,
R₂₁ to R₂₈ are each the same as described in connection with R₂ in claim 1, wherein each of R₂₁ to R₂₈ is not hydrogen,
*' indicates a binding site to M in Formula 1, and
*" indicates a binding site to ring CY₁ in Formula 2A.

10. The organometallic compound of any of claims 1-9, wherein a group represented by 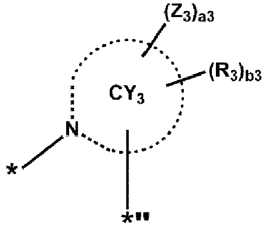 in Formula 2B is a group represented by Formula CY3(1): 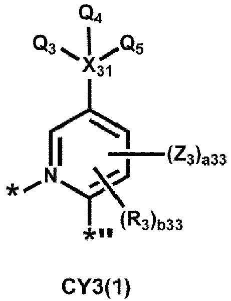 wherein, in Formula CY3(1),
X₃₁ is Si or Ge,
Z₃, R₃, and Q₃ to Q₅ are each the same as described in claim 1,
a33 and b33 are each independently an integer from 0 to 3,
two or more of R₃(s) in the number of a33 are optionally linked together to form a C₃-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is the same as described in connection with R₁ in claim 1,
* indicates a binding site to M in Formula 1, and
*" indicates a binding site to ring CY₄ in Formula 2B.

11. The organometallic compound of any of claims 1-10, wherein a group represented by 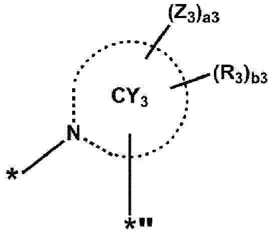 in Formula 2B is a group represented by one of Formulae CY3-1 to CY3-16 and CY3-1F to CY3-32F: 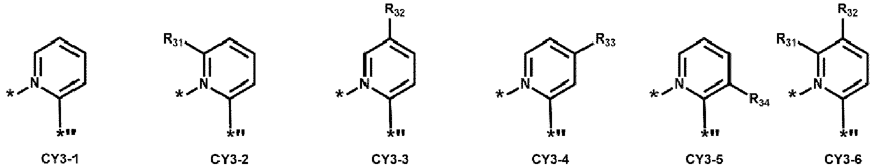 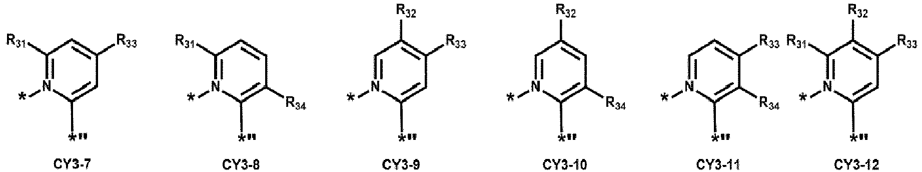 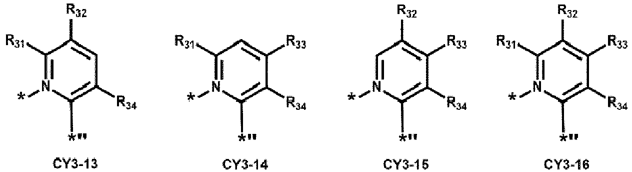 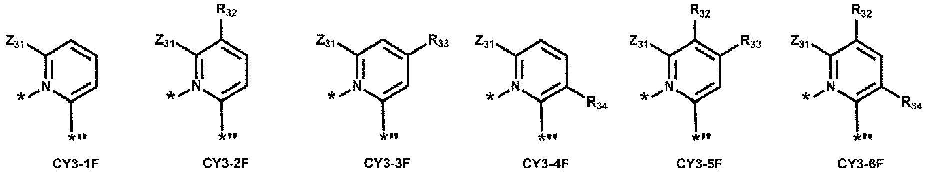 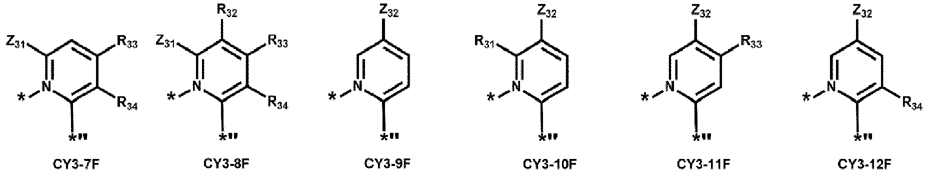 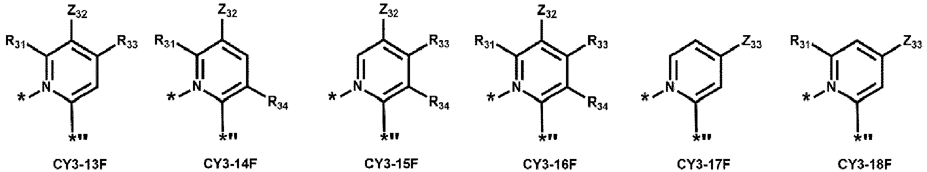 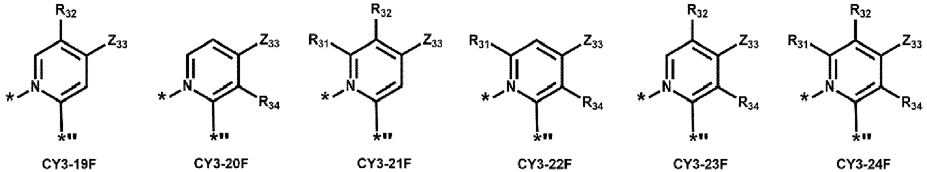 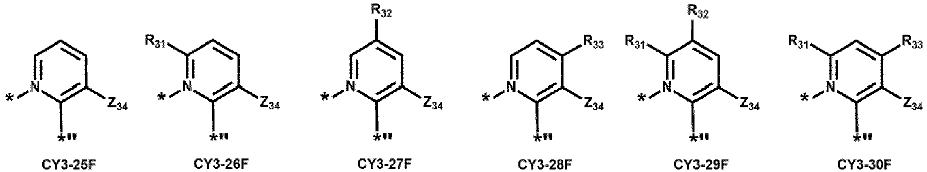 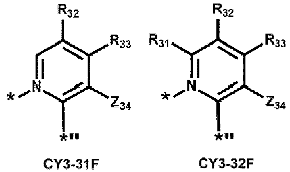
wherein, in Formulae CY3-1 to CY3-16 and CY3-1F to CY3-32F,
Z₃₁ to Z₃₄ are each the same as described in connection with Z₃ in claim 1,
R₃₁ to R₃₄ are each the same as described in connection with R₃ in claim 1, wherein each of R₃₁ to R₃₄ is not hydrogen,
* indicates a binding site to M in Formula 1, and
*" indicates a binding site to ring CY₄ in Formula 2B.

12. The organometallic compound of any of claims 1-11, wherein a group represented by 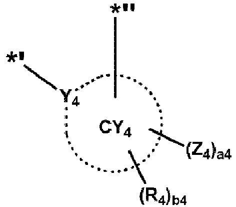 in Formula 2B is a group represented by one of Formulae CY4-1 to CY4-16 and CY4-1F to CY4-32F: 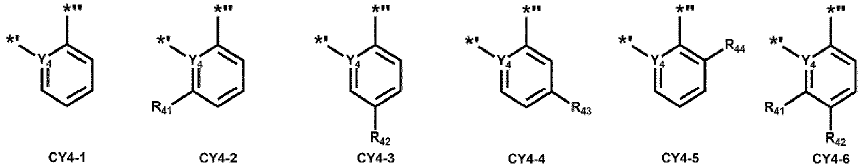 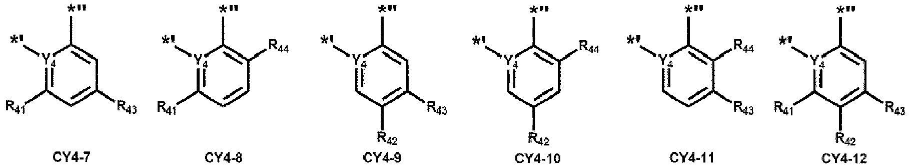 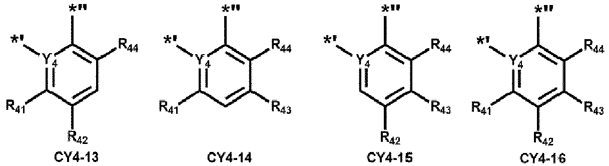 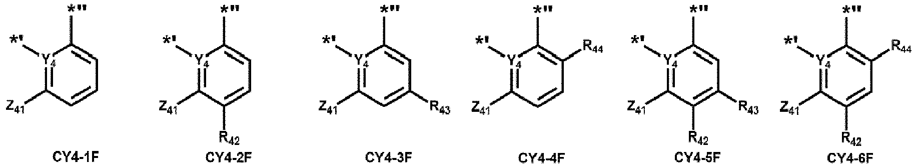 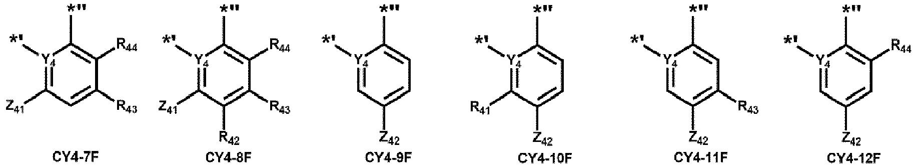 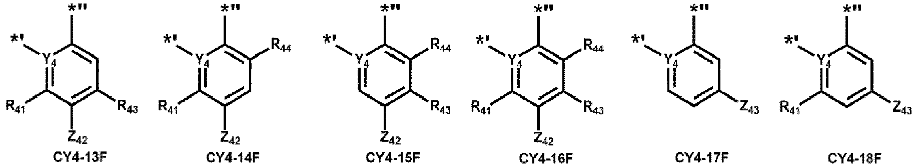 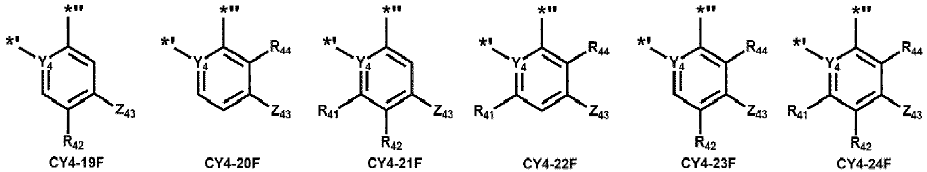 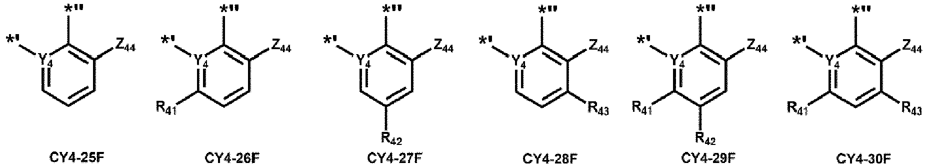 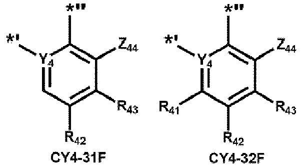
wherein, in Formulae CY4-1 to CY4-16 and CY4-1F to CY4-32F,
Z₄₁ to Z₄₄ are each the same as described in connection with Z₄ in claim 1, R₄₁ to R₄₄ are each the same as described in connection with R₄ in claim 1, wherein each of R₄₁ to R₄₄ is not hydrogen,
*' indicates a binding site to M in Formula 1, and
*" indicates a binding site to ring CY₃ in Formula 2B.

13. An organic light-emitting device comprising:
a first electrode;
a second electrode; and
an organic layer arranged between the first electrode and the second electrode, wherein the organic layer comprises an emission layer,
wherein the organic layer further comprises at least one organometallic compound of any of claims 1-12;
preferably wherein
the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

14. The organic light-emitting device of claim 13, wherein
the emission layer comprises the at least one organometallic compound; preferably wherein
the emission layer further comprises a host, and an amount of the host in the emission layer is greater than an amount of the at least one organometallic compound in the emission, each based on total weight of the emission layer.

15. An electronic apparatus comprising the organic light-emitting device of claims 13 or 14.
